# EUROPEAN PATENT APPLICATION

(11) **EP 4 821 936 A1**
(43) Date of publication of application: **14.10.2026**
(21) Application number: 25738901.5
(22) Date of filing: 07.01.2025
(51) Int. Cl.: C07F 5/02, C07F 7/08, C07F 7/30, H10K 85/60, H10K 85/40

(54) **POLYCYCLIC COMPOUND, AND ORGANIC LIGHT-EMITTING DEVICE USING SAME**

(30) Priority: 08.01.2024 KR 20240002764
(71) Applicant: SFC Co., Ltd., Cheongju-si, Chungcheongbuk-do 28122 (KR)
(72) Inventor: CHO, Jin-hwi, Cheongju-si Chungcheongbuk-do 28122 (KR); SHIM, So-young, Cheongju-si Chungcheongbuk-do 28122 (KR)
(74) Representative: Grosse, Felix Christopher
(86) International application number: PCT/KR2025/000275
(87) International publication number: WO 2025/150827

(57) **Abstract**

The present invention relates to a polycyclic compound having a characteristic fused ring structure, and an organic light-emitting device using the same. The polycyclic compound according to the present invention may be used in a light-emitting layer in the organic light-emitting device to achieve a highly efficient and long-lasting organic light-emitting device having a remarkably improved lifespan and excellent luminous efficiency, and accordingly, the organic light-emitting device is industrially useful not only in lighting devices, but also in various display devices such as flat panel, flexible and wearable displays, and displays for virtual or augmented reality.

## Description

### [Technical Field]

The present invention relates to a polycyclic compound employed in an organic layer such as a light-emitting layer in an organic light-emitting device, and an organic light-emitting device including the same.

### [Background Art]

Organic light-emitting devices are self-luminous devices in which electrons injected from an electron injecting electrode (cathode) combine with holes injected from a hole injecting electrode (anode) in a light-emitting layer to form excitons, which emit light while releasing energy. Such organic light-emitting devices have advantages of low driving voltage, high luminance, wide viewing angle and short response time, and being applicable to full-color light-emitting flat-panel displays. Due to these advantages, organic light-emitting devices have received attention as nextgeneration light sources.

The above characteristics of organic light-emitting devices are achieved by structural optimization of organic layers of the devices and are supported by stable and efficient materials for the organic layers, such as hole injecting materials, hole transport materials, hole blocking materials, light-emitting materials, electron transport materials, electron injecting materials, and electron blocking materials. However, more research still needs to be done to develop structurally optimized structures of organic layers for organic light-emitting devices and stable and efficient materials for organic layers of organic light-emitting devices.

Particularly, to obtain maximum efficiency in a light-emitting layer, an appropriate combination of energy band gaps of a host and a dopant is required so that holes and electrons each migrate to the dopant through stable electrochemical paths to form excitons.

### [Detailed Description of the Invention]

### [Problems to be Solved by the Invention]

Accordingly, the present invention is directed to providing a polycyclic compound having a characteristic fused ring structure, and a highly efficient and long-lasting organic light-emitting device having remarkably improved lifespan and luminous efficiency by employing the same as a dopant material in a light-emitting layer.

### [Means for Solving the Problems]

In order to solve the above-described problems, one aspect of the present invention provides a polycyclic compound represented by [Chemical Formula 1], having a characteristic fused ring structure as follows, and an organic light-emitting device including the same as a dopant in a light-emitting layer.

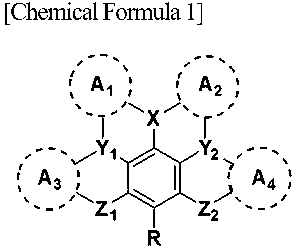

The specific structure of [Chemical Formula 1], specific compounds according to the present invention obtained therefrom, and a definition of each substituent will be described below.

### [Effects of the Invention]

The present invention relates to a polycyclic compound having a characteristic fused ring structure, and an organic light-emitting device employing the same as a dopant of a light-emitting layer, and since a high efficiency and long lifespan organic light-emitting device can be achieved, the organic light-emitting device can be effectively utilized not only in lighting devices, but also in various display devices such as flat-panel, flexible and wearable displays, and displays for virtual or augmented reality.

### [Best Mode for Carrying out the Invention]

Hereinafter, the present invention will be described in more detail.

One aspect of the present invention relates to a polycyclic compound represented by the following [Chemical Formula 1].

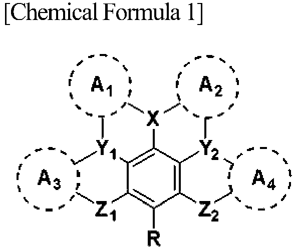

In [Chemical Formula 1],
X, Y₁ and Y₂ are each independently B or N.
Z₁ and Z₂ are the same as or different from each other, and each independently selected from O, S, NR₁, CR₂R₃, SiR₄R₅ and GeR₆R₇.

Rings A₁ to A₄ are the same as or different from each other, and each independently selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring, and a substituted or unsubstituted ring in which a C₃-C₃₀ aliphatic ring and a C₃-C₃₀ aromatic ring are fused.

Herein, at least one of the rings A₁ to A₄ is a substituted or unsubstituted ring in which a C₃-C₃₀ aliphatic ring and a C₃-C₃₀ aromatic ring are fused.

R is selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₃-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.

R₁ to R₇ are the same as or different from each other, and each independently selected from a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₃-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.

The ring A₁ is linked to X and Y₁ to form a ring, the ring A₂ is linked to X and Y₂ to form a ring, the ring A₃ is linked to Y₁ and Z₁ to form a ring, and the ring A₄ is linked to Y₂ and Z₂ to form a ring.

R may be linked to adjacent substituents to further form an alicyclic or aromatic monocyclic or polycyclic ring.

R₂ and R₃, R₄ and R₅, and R₆ and R₇ may each be linked to each other to further form an alicyclic or aromatic monocyclic or polycyclic ring.

R₁ to R₇ may be linked to the adjacent ring A₃ or A₄ to further form an alicyclic or aromatic monocyclic or polycyclic ring.

The adjacent rings A₁ to A₄ may be linked to each other to further form an alicyclic or aromatic monocyclic or polycyclic ring.

The 'substituted' in the 'substituted or unsubstituted' in [Chemical Formula 1] means being substituted with one, or two or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₃-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, one or more hydrogen atoms in the substituents may be substituted with deuterium atoms, and two or more adjacent substituents may be linked to each other to further form an alicyclic or aromatic monocyclic or polycyclic ring.

According to one embodiment of the present invention, Y₁ and Y₂ are N when X is B, or Y₁ and Y₂ are B when X is N in the compound of [Chemical Formula 1] according to the present invention.

According to one embodiment of the present invention, Z₁ and Z₂ in [Chemical Formula 1] are the same as or different from each other, and may be each independently any one selected from O, S and NR₁.

In addition, according to one embodiment of the present invention, at least one of Z₁ and Z₂ in [Chemical Formula 1] may be O or S.

In addition, in the compound according to the present invention, at least one hydrogen atom in [Chemical Formula 1] may be substituted with deuterium.

According to one embodiment of the present invention, the ring A₁ in [Chemical Formula 1] is a substituted or unsubstituted ring in which a C₃-C₂₄ aliphatic ring and a C₃-C₂₄ aromatic ring are fused, and accordingly, [Chemical Formula 1] may be represented by the following [Chemical Formula 1-1] to [Chemical Formula 1-3].

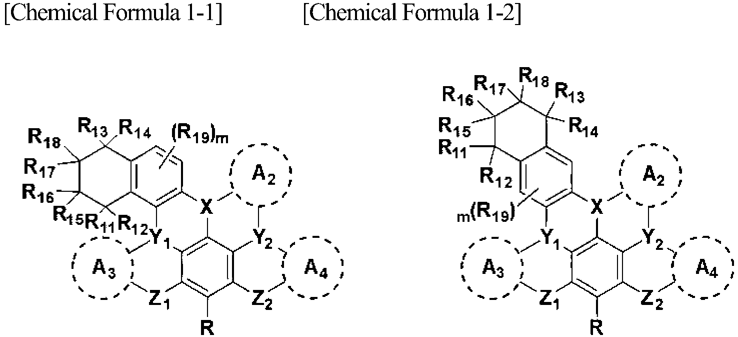

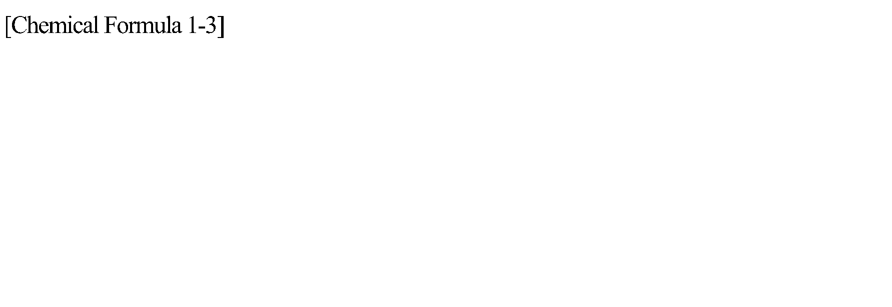

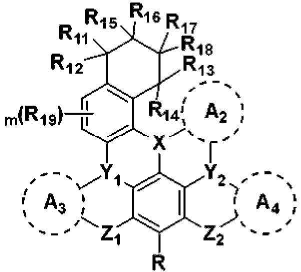

In [Chemical Formula 1-1] to [Chemical Formula 1-3],
X, Y₁ and Y₂ are each independently B or N.
Z₁ and Z₂ are the same as or different from each other, and each independently selected from O, S and NR₁.

Rings A₂ to A₄ are the same as or different from each other, and each independently selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring, and a substituted or unsubstituted ring in which a C₃-C₃₀ aliphatic ring and a C₃-C₃₀ aromatic ring are fused.

R and R₁₉ are the same as or different from each other, and each independently selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₃-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.

R₁ and R₁₁ to R₁₄ are the same as or different from each other, and each independently selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, and a substituted or unsubstituted cyclic group in which a C₃-C₃₀ aliphatic ring and a C₃-C₃₀ aromatic ring are fused.

R₁₅ to R₁₈ are the same as or different from each other, and each independently hydrogen or deuterium.

m is an integer of 2.

The ring A₂ is linked to X and Y₂ to form a ring, the ring A₃ is linked to Y₁ and Z₁ to form a ring, and the ring A₄ is linked to Y₂ and Z₂ to form a ring.

R may be linked to adjacent substituents to further form an alicyclic or aromatic monocyclic or polycyclic ring.

The adjacent R₁₁ to R₁₄ may be linked to each other to further form an alicyclic or aromatic monocyclic or polycyclic ring.

R₁ may be linked to the adjacent ring A₃ or A₄ to further form an alicyclic or aromatic monocyclic or polycyclic ring.

The adjacent rings A₂ and A₄ may be linked to each other to further form an alicyclic or aromatic monocyclic or polycyclic ring.

The 'substituted' in the 'substituted or unsubstituted' in [Chemical Formula 1-1] to [Chemical Formula 1-3] means being substituted with one, or two or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₃-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, one or more hydrogen atoms in the substituents may be substituted with deuterium atoms, and two or more adjacent substituents may be linked to each other to further form an alicyclic or aromatic monocyclic or polycyclic ring.

According to one embodiment of the present invention, Y₁ and Y₂ are N when X is B, or Y₁ and Y₂ are B when X is N in the compounds of [Chemical Formula 1-1] to [Chemical Formula 1-3] according to the present invention.

Meanwhile, in the present invention, the term 'substituted or unsubstituted' means that each of the substituents defined above is substituted with one, or two or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₃-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, one or more hydrogen atoms in the substituents may be substituted with deuterium atoms, and two or more adjacent substituents may be linked to each other to further form an alicyclic or aromatic monocyclic or polycyclic ring. For example, it means that the ring A is substituted with a C₁-C₃₀ amine group, a C₁-C₃₀ amine group substituted with a C₁-C₂₄ alkyl group, or both a C₆-C₃₀ aryl group and a C₆-C₃₀ aryl group substituted with a C₁-C₂₄ alkyl group.

In addition, in the present invention, the range of the number of carbon atoms in the alkyl group or aryl group in the 'substituted or unsubstituted C₁-C₃₀ alkyl group', 'substituted or unsubstituted C₆-C₃₀ aryl group' and the like refers to the total number of carbon atoms forming the alkyl or aryl moiety when unsubstituted without considering the moiety substituted with the substituents. For example, it means that a phenyl group substituted with a butyl group at a para position corresponds to a C₆ aryl group substituted with a C₄ butyl group.

In addition, in the present invention, being linked to each other or to adjacent groups to further form a ring may mean that adjacent substituents among the specified substituents may bond to each other or the specified substituent and another adjacent group may bond to each other to form a substituted or unsubstituted alicyclic or aromatic ring, and the 'adjacent group' may refer to a substituent substituting on an atom directly linked to an atom substituted with the corresponding substituent, a substituent positioned sterically closest to the corresponding substituent, or another substituent substituting on an atom substituted with the corresponding substituent. For example, two substituents substituting at an ortho position of a benzene ring and two substituents substituting on the same carbon in an aliphatic ring may be interpreted as 'adjacent groups' to each other, the pair of linked substituents additionally form a ring by linking the substituents to each other after removing one hydrogen radical from each of the substituents, and carbon atoms of the formed alicyclic or aromatic monocyclic or polycyclic ring may be replaced by a heteroatom such as N, O, S, Si or Ge (R has the same definition as R₁ to R₇ in [Chemical Formula 1]).

In the present invention, the alkyl group may be linear or branched. Specific examples thereof may include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group and the like, but are not limited thereto.

In the present invention, specific examples of the arylalkyl group may include phenylmethyl (benzyl), phenylethyl, phenylpropyl, naphthylmethyl, naphthylethyl and the like, but are not limited thereto.

In the present invention, specific examples of the alkylaryl group may include tolyl, xylenyl, dimethylnaphthyl, t-butylphenyl, t-butylnaphthyl, t-butylphenanthryl and the like, but are not limited thereto.

In the present invention, the alkenyl group includes linear or branched forms, and may be further substituted with other substituents. Specific examples thereof may include a vinyl group, a I-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present invention, the alkynyl group also includes linear or branched forms, and may be further substituted with other substituents. Examples thereof may include ethynyl, 2-propynyl and the like, but are not limited thereto.

In the present invention, the cycloalkenyl group is a non-aromatic cyclic unsaturated hydrocarbon group having one or more carbon double bonds. Examples thereof may include cyclopropenyl, cyclobutenyl, cyclopentenyl, cyclohexenyl, cycloheptenyl, 1,3-cyclohexadienyl, 1,4-cyclohexadienyl, 2,4-cycloheptadienyl, 1,5-cyclooctadienyl and the like, but are not limited thereto.

In the present invention, the aromatic hydrocarbon ring or the aryl group may be monocyclic or polycyclic. The term 'polycyclic group' refers to a group directly linked to or fused with other cyclic groups, and the other cyclic group may be an aromatic hydrocarbon ring, but may also be other types of cyclic groups such as an aliphatic heteroring, an aliphatic hydrocarbon ring and an aromatic heteroring. Examples of the monocyclic aryl group may include a phenyl group, a biphenyl group, a terphenyl group and the like, and examples of the polycyclic aryl group may include a naphthyl group, an anthracenyl group, a phenanthrenyl group, a pyrenyl group, a perylenyl group, a tetracenyl group, a chrysenyl group, a fluorenyl group, an acenaphathcenyl group, a triphenylene group, a fluoranthrene group and the like, however, the scope of the present invention is not limited to these examples.

In the present invention, the aromatic heteroring or the heteroaryl group is an aromatic ring including one or more of heteroatoms. Examples thereof may include a thiophene group, a furan group, a pyrrole group, an imidazole group, a thiazole group, an oxazole group, an oxadiazole group, a triazole group, a pyridyl group, a bipyridyl group, a pyrimidyl group, a triazine group, a triazole group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, an indolocarbazole group, a benzoxazole group, a benzimidazole group, a benzothiazole group, a benzocarbazole group, a benzothiophene group, a dibenzothiophene group, a benzofuranyl group, a dibenzofuranyl group, a phenanthroline group, a thiazolyl group, an isoxazolyl group, an oxadiazolyl group, a thiadiazolyl group, a benzothiazolyl group, a phenothiazinyl and the like, but are not limited thereto.

In the present invention, the aliphatic hydrocarbon ring or the cycloalkyl group refers to a non-aromatic ring formed only with carbon and hydrogen atoms. Examples thereof may include monocyclic or polycyclic groups, and the aliphatic hydrocarbon ring or the cycloalkyl group may be further substituted with other substituents. The term 'polycyclic group' refers to a group directly linked to or fused with other cyclic groups, and the other cyclic group may be an aliphatic hydrocarbon ring, but may also be other types of cyclic groups such as an aliphatic heteroring, an aromatic hydrocarbon ring and an aromatic heteroring. Specific examples thereof may include a cycloalkyl group such as a cyclopropyl group, a cyclobutyl group, a cyclopentyl group, an adamantyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group and a cyclooctyl group, a cycloalkane group such as a cyclohexane group and a cyclopentane group, and a cycloalkene group such as a cyclohexene group and a cyclobutene group, but are not limited thereto.

In the present invention, the aliphatic heteroring or the heterocycloalkyl group refers to an aliphatic ring including one or more of heteroatoms such as O, S, Se, N or Si, includes monocyclic or polycyclic groups as well, and may be further substituted with other substituents. The term 'polycyclic group' refers to a group in which heterocycloalkyl, heterocycloalkane or the like is directly linked to or fused with other cyclic groups, and the other cyclic group may be an aliphatic heteroring, but may also be other types of cyclic groups such as an aliphatic hydrocarbon ring, an aromatic hydrocarbon ring and an aromatic heteroring.

In the present invention, the ring (cyclic group) in which an aliphatic ring and an aromatic ring are fused is an aliphatic-aromatic mixed ring (cyclic group), and refers to a ring in which two or more rings are linked to and fused with each other, and an aliphatic ring and an aromatic ring are fused to exhibit non-aromaticity as a whole. More specifically, the ring (cyclic group) in which an aliphatic ring and an aromatic ring are fused may include an aromatic hydrocarbon ring (cyclic group) fused with an aliphatic hydrocarbon ring, an aromatic hydrocarbon ring (cyclic group) fused with an aliphatic heteroring, an aromatic heteroring (cyclic group) fused with an aliphatic hydrocarbon ring, an aromatic heteroring (cyclic group) fused with an aliphatic heteroring, an aliphatic hydrocarbon ring (cyclic group) fused with an aromatic hydrocarbon ring, an aliphatic hydrocarbon ring (cyclic group) fused with an aromatic heteroring, an aliphatic heteroring (cyclic group) fused with an aromatic hydrocarbon ring, an aliphatic heteroring (cyclic group) fused with an aromatic heteroring, and the like, and specific examples thereof may include a tetrahydronaphthyl group, a tetrahydrobenzocycloheptene group, a tetrahydrophenanthrene group, a tetrahydroanthracenyl group, an octahydrotriphenylene group, a tetrahydrobenzothiophene group, a tetrahydrobenzofuranyl group, a tetrahydrocarbazole group, a tetrahydroquinoline group and the like. In addition, carbon in the ring (cyclic group) in which an aliphatic ring and an aromatic ring are fused may be replaced with a heteroatom such as N, NR, O, S, Si or Ge (R has the same definition as R₁ to R₇ in [Chemical Formula 1]).

In the present invention, specific examples of the alkoxy group may include methoxy, ethoxy, propoxy, isobutyloxy, sec-butyloxy, pentyloxy, iso-amyloxy, hexyloxy and the like, but are not limited thereto.

In the present invention, the silyl group may include -SiH₃, an alkylsilyl group, an arylsilyl group, an alkylarylsilyl group, an arylheteroarylsilyl group, a heteroarylsilyl group and the like. The arylsilyl group refers to a silyl group in which one, or two or three hydrogen atoms are substituted with an aryl group in -SiH₃, the alkylsilyl group refers to a silyl group in which one, or two or three hydrogen atoms are substituted with an alkyl group in -SiH₃, the alkylarylsilyl group refers to a silyl group including one or two alkyl groups and two or one aryl groups corresponding thereto by substituting at least one hydrogen atom with an alkyl group and an aryl group in -SiH₃, the arylheteroarylsilyl group refers to a silyl group including one or two aryl groups and two or one heteroaryl groups corresponding thereto by substituting at least one hydrogen atom with an aryl group and a heteroaryl group in -SiH₃, and the heteroarylsilyl group refers to a silyl group in which one, or two or three hydrogen atoms are substituted with a heteroaryl group in -SiH₃. Examples of the arylsilyl group may include a substituted or unsubstituted monoarylsilyl group, a substituted or unsubstituted diarylsilyl group, or a substituted or unsubstituted triarylsilyl group, and the same also applies to the alkylsilyl group and the heteroarylsilyl group.

Herein, the aryl group in each of the arylsilyl group, the heteroarylsilyl group and the arylheteroarylsilyl group may be a monocyclic aryl group or a polycyclic aryl group, and the heteroaryl group in each of the arylsilyl group, the heteroarylsilyl group and the arylheteroarylsilyl group may be a monocyclic heteroaryl group or a polycyclic heteroaryl group.

In addition, specific examples of the silyl group may include trimethylsilyl, triethylsilyl, triphenylsilyl, trimethoxysilyl, dimethoxyphenylsilyl, diphenylmethylsilyl, diphenylvinylsilyl, methylcyclobutylsilyl, dimethylfurylsilyl and the like, and one or more hydrogen atoms in the silyl group may be substituted with the same substituents as in the case of the aryl group.

In the present invention, the amine group may include -NH₂, an alkylamine group, an arylamine group, an alkylarylamine group, an arylheteroarylamine group, a heteroarylamine group and the like. The arylamine group refers to an amine group in which one or two hydrogen atoms are substituted with an aryl group in -NH₂, the alkylamine group refers to an amine group in which one or two hydrogen atoms are substituted with an alkyl group in -NH₂, and the alkylarylamine group refers to an amine group in which one hydrogen atom is substituted with an alkyl group and the other hydrogen atom is substituted with an aryl group in -NH₂. The arylheteroarylamine group refers to an amine group in which one hydrogen atom is substituted with an aryl group and the other hydrogen atom is substituted with a heteroaryl group in -NH₂, and the heteroarylamine group refers to an amine group in which one or two hydrogen atoms are substituted with a heteroaryl group in -NH₂. Examples of the arylamine group may include a substituted or unsubstituted monoarylamine group, a substituted or unsubstituted diarylamine group, or a substituted or unsubstituted triarylamine group, and the same also applies to the alkylamine group and the heteroarylamine group.

Herein, the aryl group in each of the arylamine group, the heteroarylamine group and the arylheteroarylamine group may be a monocyclic aryl group or a polycyclic aryl group, and the heteroaryl group in each of the arylamine group, the heteroarylamine group and the arylheteroarylamine group may be a monocyclic heteroaryl group or a polycyclic heteroaryl group.

In the present invention, the germanium group (or germane group) may include -GeH₃, an alkylgermanium group, an arylgermanium group, a heteroarylgermanium group, an alkylarylgermanium group, an alkylheteroarylgermanium group, an arylheteroarylgermanium group and the like. Definitions thereof follow the description provided for the silyl group, and may be applied to each substituent as a substituent obtained by being substituted with a germanium (Ge) atom instead of a silicon (Si) atom in the silyl group.

In addition, specific examples of the germanium group may include trimethylgermane, triethylgermane, triphenylgermane, trimethoxygermane, dimethoxyphenylgermane, diphenylmethylgermane, diphenylvinylgermane, methylcyclobutylgermane, dimethylfurylgermane and the like, and one or more hydrogen atoms in the germanium group may be substituted with the same substituents as in the case of the aryl group.

In the present invention, the cycloalkyl group, the aryl group and the heteroaryl group in the cycloalkyloxy group, the aryloxy group, the heteroaryloxy group, the cycloalkylthioxy group, the arylthioxy group and the heteroarylthioxy group are the same as the examples of the cycloalkyl group, the aryl group and the heteroaryl group described above. Specific examples of the aryloxy group may include a phenoxy group, a p-tolyloxy group, an m-tolyloxy group, a 3,5-dimethylphenoxy group, a 2,4,6-trimethylphenoxy group, a p-tert-butylphenoxy group, a 3-biphenyloxy group, a 4-biphenyloxy group, a 1-naphthyloxy group, a 2-naphthyloxy group, a 4-methyl-1-naphthyloxy group, a 5-methyl-2-naphthyloxy group, a 1-anthryloxy group, a 2-anthryloxy group, a 9-anthryloxy group, a 1-phenanthryloxy group, a 3-phenanthryloxy group, a 9-phenanthryloxy group and the like, and specific examples of the arylthioxy group may include a phenylthioxy group, a 2-methylphenylthioxy group, a 4-tert-butylphenylthioxy group and the like. However, the aryloxy group and the arylthioxy group are not limited thereto.

In the present invention, examples of the halogen group include fluorine, chlorine, bromine or iodine.

According to one embodiment of the present invention, the polycyclic compound represented by [Chemical Formula 1] may be any one selected from compounds represented by the following chemical formulae, however, the scope of the present invention is not limited thereby.

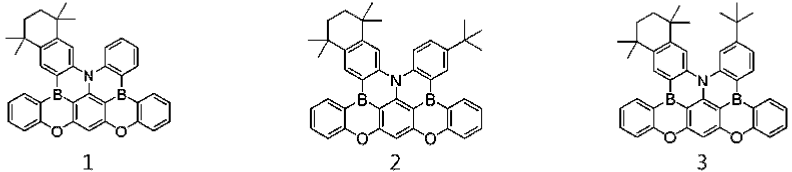

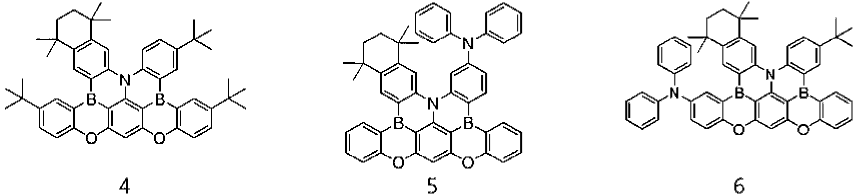

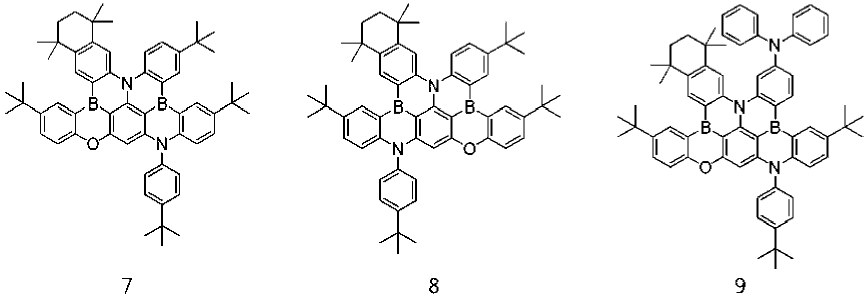

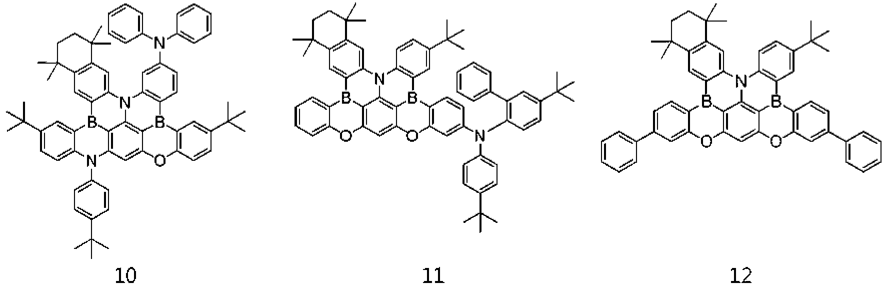

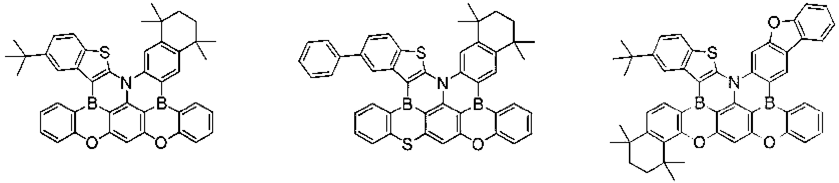

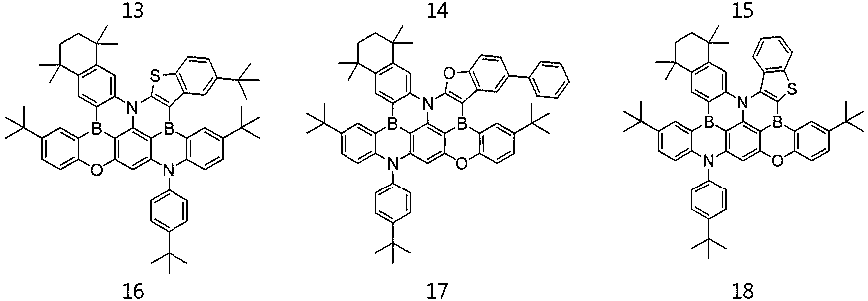

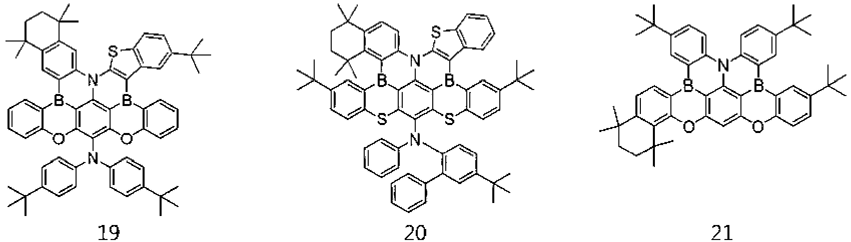

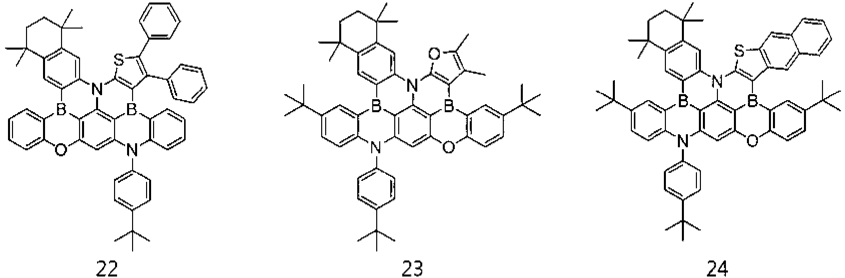

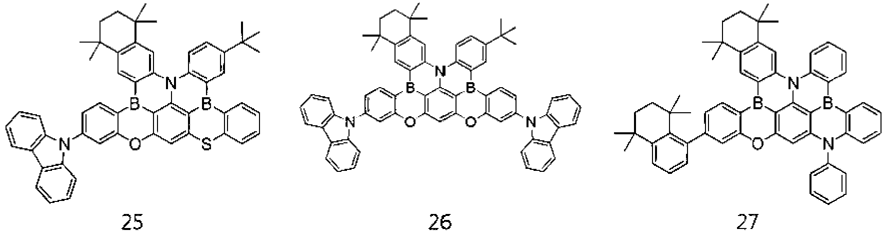

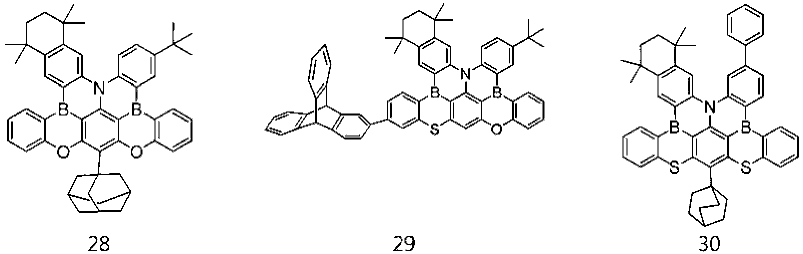

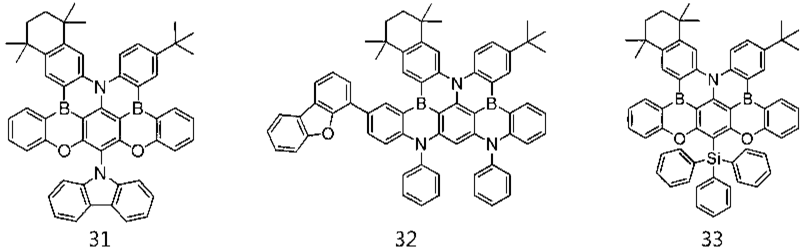

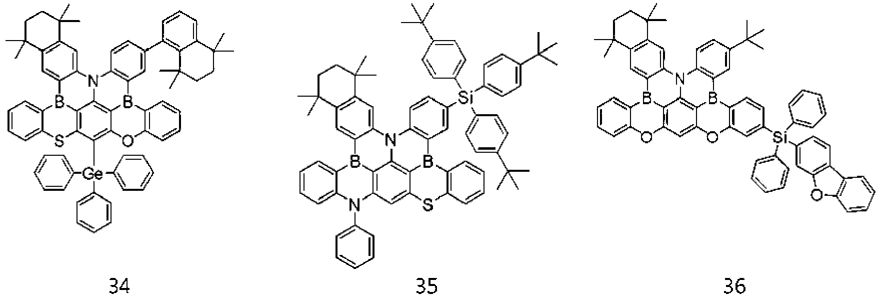

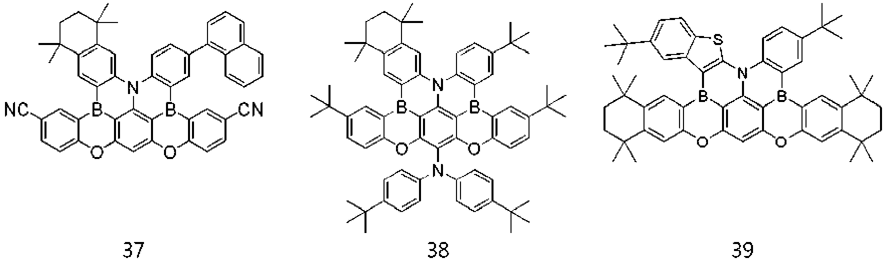

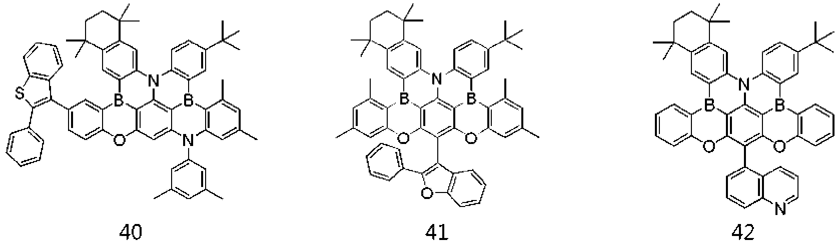

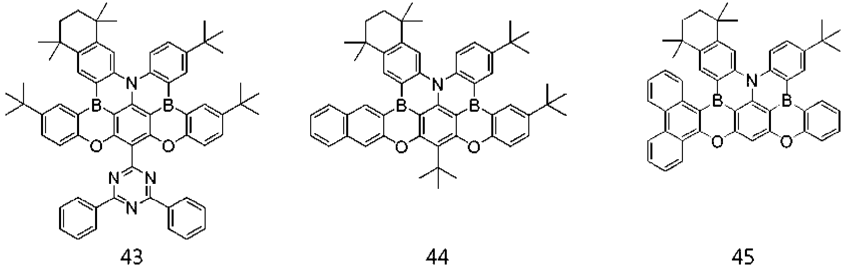

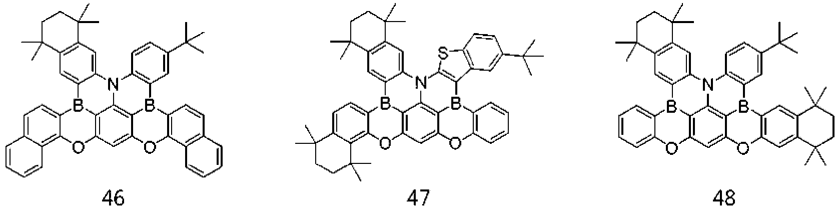

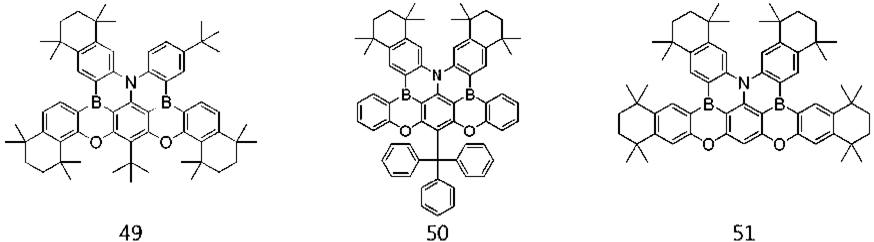

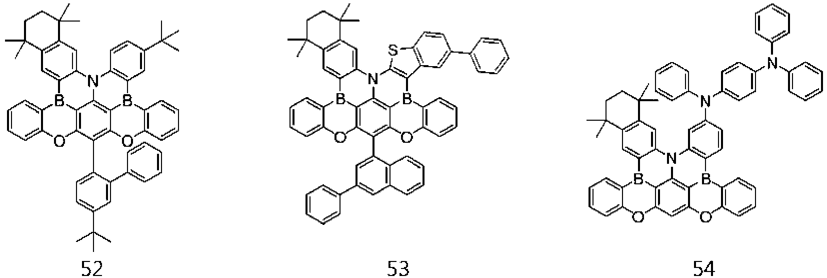

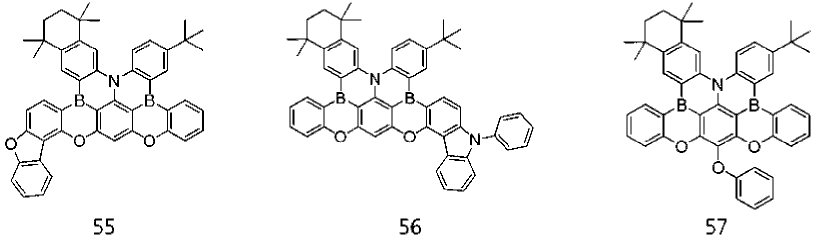

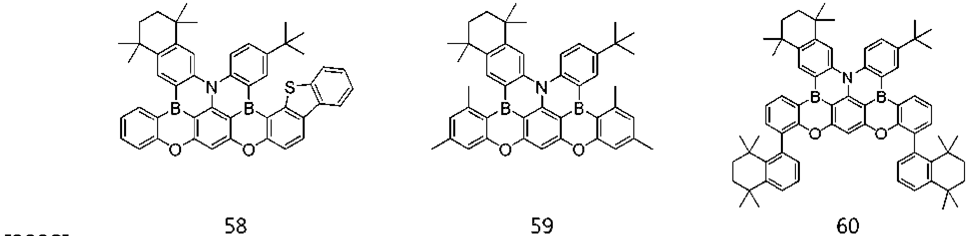

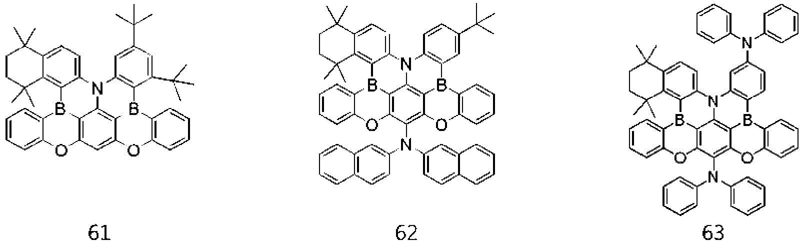

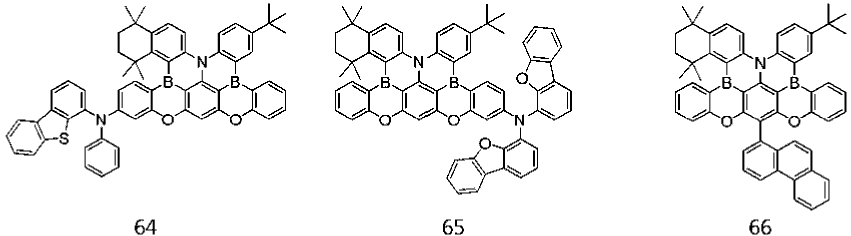

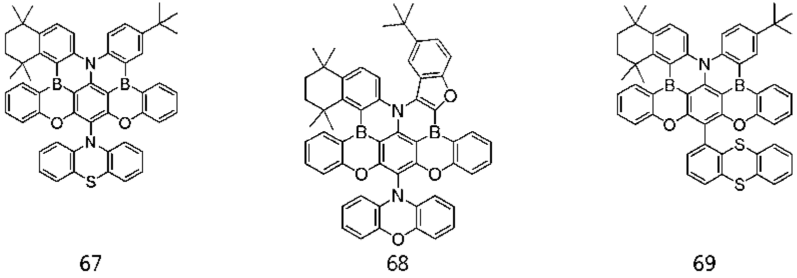

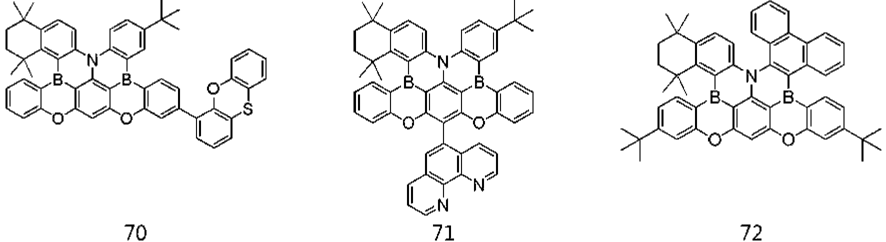

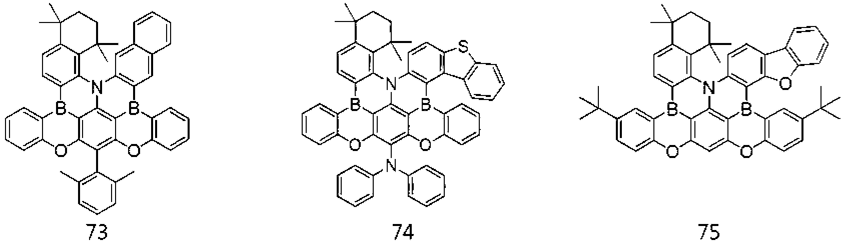

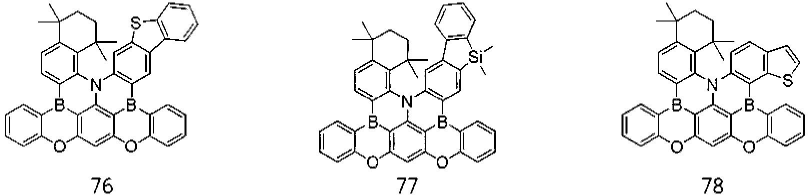

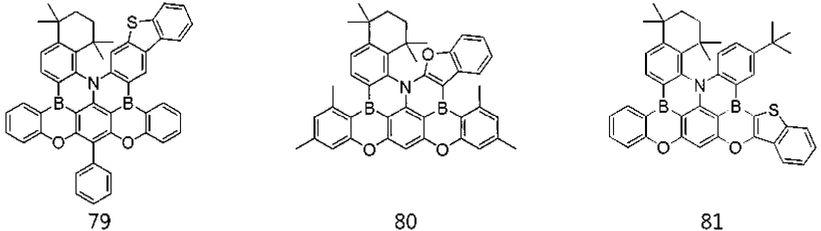

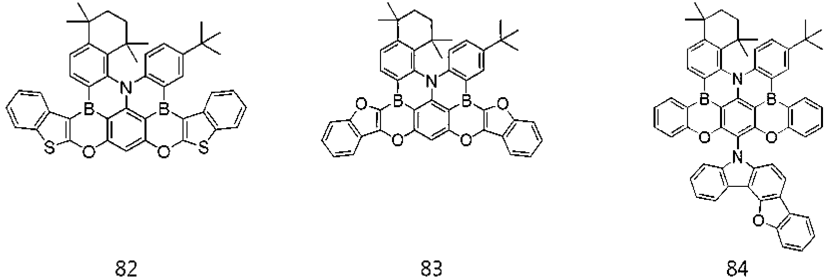

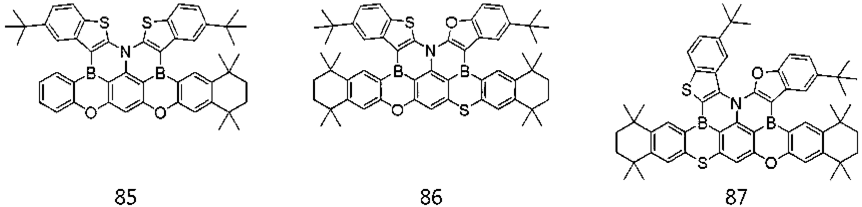

In addition, another aspect of the present invention relates to an organic light-emitting device including: a first electrode; a second electrode; and one or more organic layers interposed between the first electrode and the second electrode, wherein the organic layer, preferably a light-emitting layer, includes the compound represented by [Chemical Formula 1] as a dopant.

The light-emitting layer has a structure composed of a host and a dopant. The light-emitting layer may further include other host or dopant materials in addition to the compound according to the present invention, and herein, the content of the dopant may be typically selected in a range of about 0.01 parts by weight to about 20 parts by weight based on about 100 parts by weight of the host, however, the dopant content is not limited thereto.

In addition, the light-emitting layer may further include various dopant and host materials in addition to the compound according to the present invention, and accordingly, one or more compounds different from each other may be mixed or laminated and used as the dopant material as well as the host material in the light-emitting layer.

Accordingly, when the compound represented by [Chemical Formula 1] is used as a fluorescent or delayed fluorescent dopant in the light-emitting layer, the light-emitting layer in the organic light-emitting device according to the present invention may include an anthracene compound represented by the following [Chemical Formula 2] as a host material.

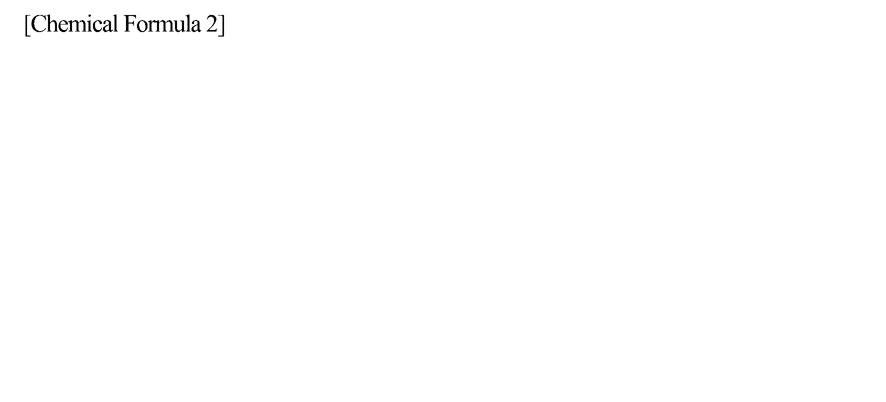

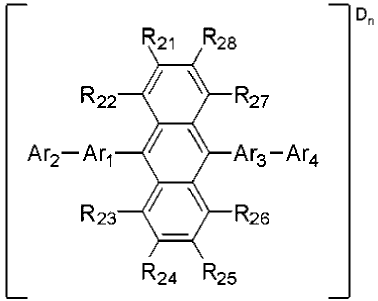

In [Chemical Formula 2],
R₂₁ to R₂₈ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₃-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group.

Ar₁ and Ar₃ are the same as or different from each other, and each independently a single bond, or any one selected from a substituted or unsubstituted C₆-C₃₀ arylene group, a substituted or unsubstituted C₂-C₃₀ heteroarylene group, and a substituted or unsubstituted divalent cyclic group in which a C₃-C₃₀ aliphatic ring and a C₃-C₃₀ aromatic ring are fused.

Ar₂ and Ar₄ are the same as or different from each other, and each independently any one selected from a substituted or unsubstituted C₆-C₅₀ aryl group, a substituted or unsubstituted C₃-C₃₀ cycloalkyl group, a substituted or unsubstituted C₃-C₃₀ heterocycloalkyl group, a substituted or unsubstituted C₂-C₅₀ heteroaryl group, and a substituted or unsubstituted cyclic group in which a C₃-C₃₀ aliphatic ring and a C₃-C₃₀ aromatic ring are fused.

Dₙ refers to the number of hydrogen atoms replaced by deuterium atoms in [Chemical Formula 2], and n is an integer of 0 to 60.

According to one embodiment of the present invention, the anthracene compound represented by [Chemical Formula 2] may be any one selected from compounds represented by the following chemical formulae, however, the scope of the present invention is not limited thereby.

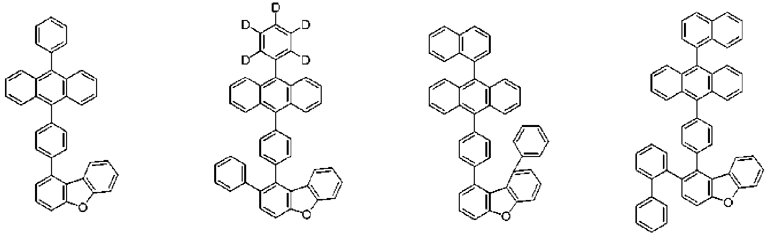

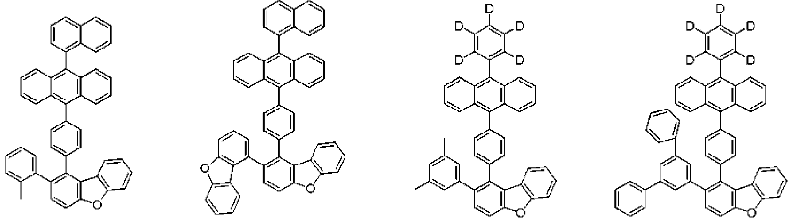

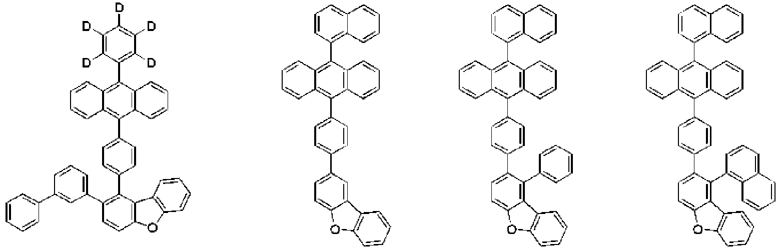

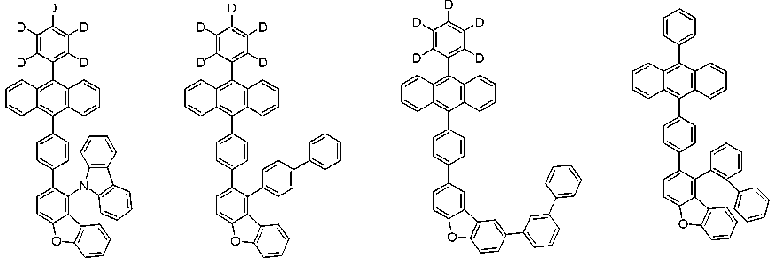

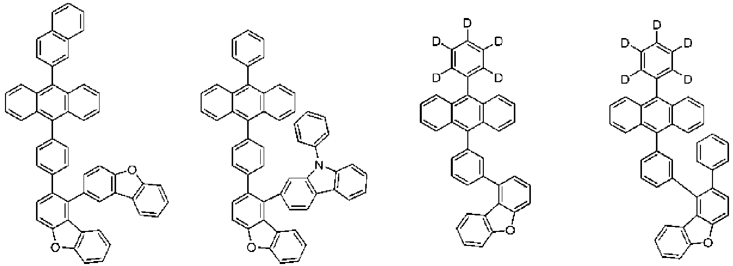

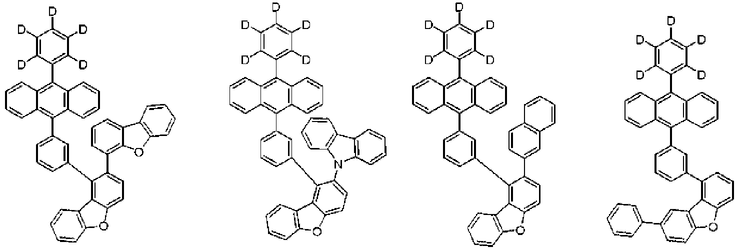

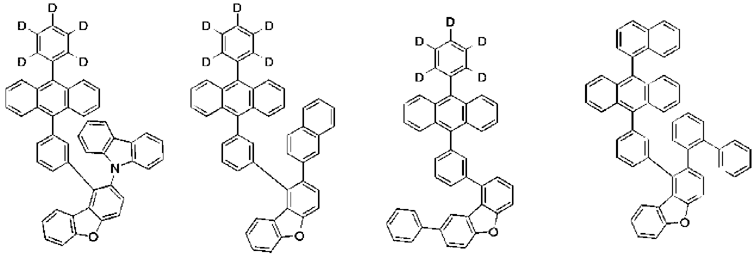

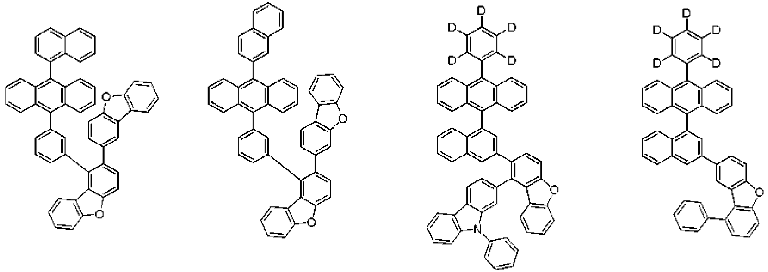

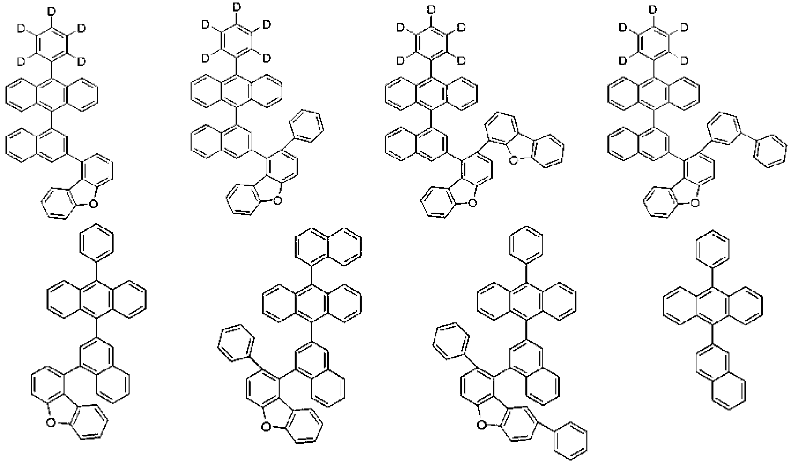

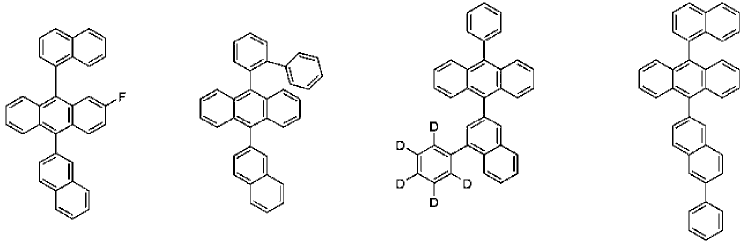

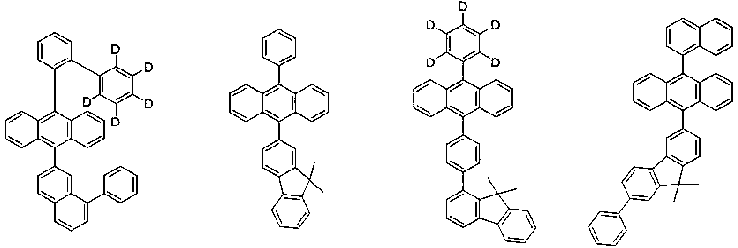

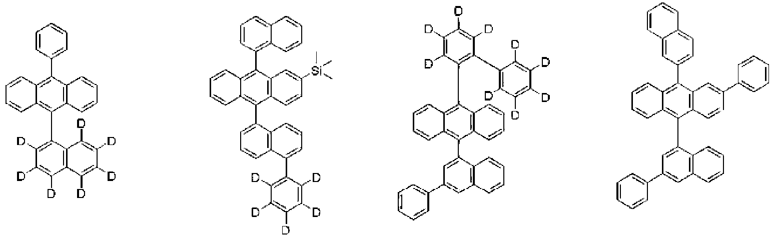

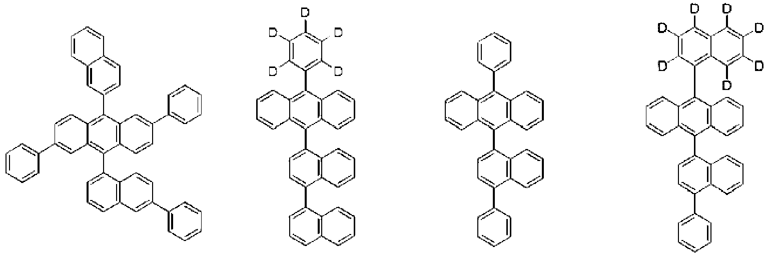

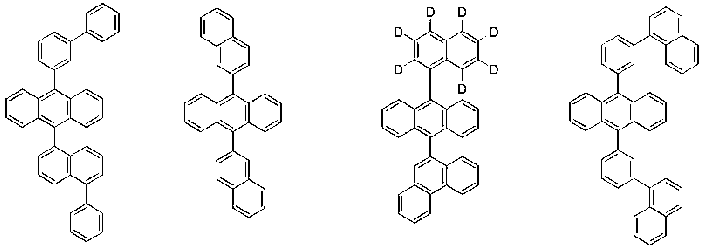

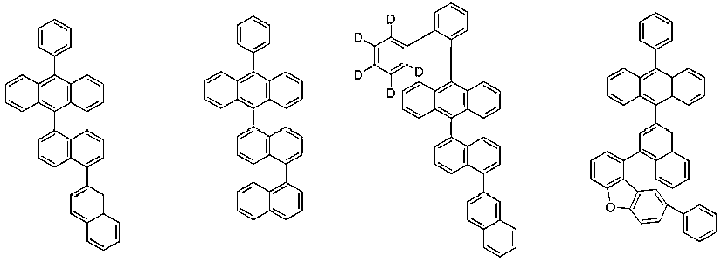

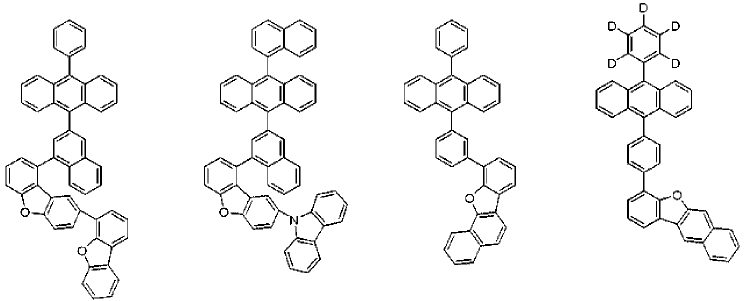

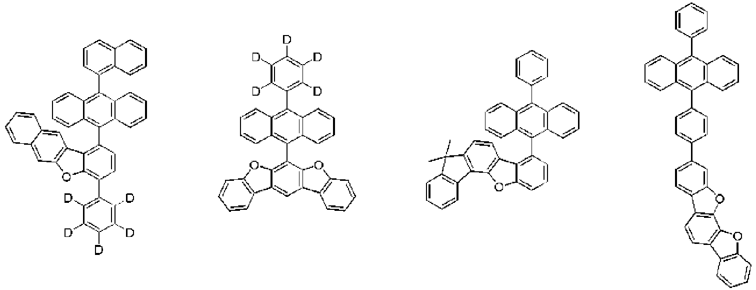

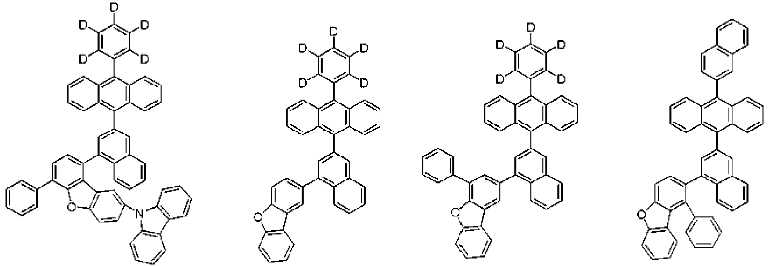

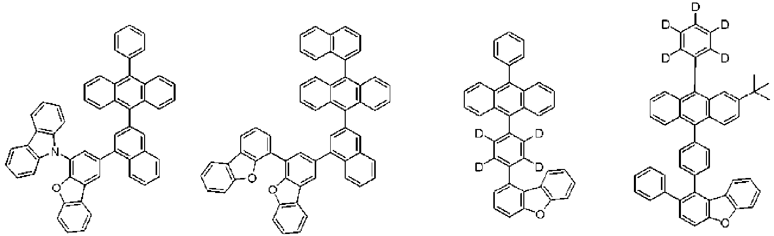

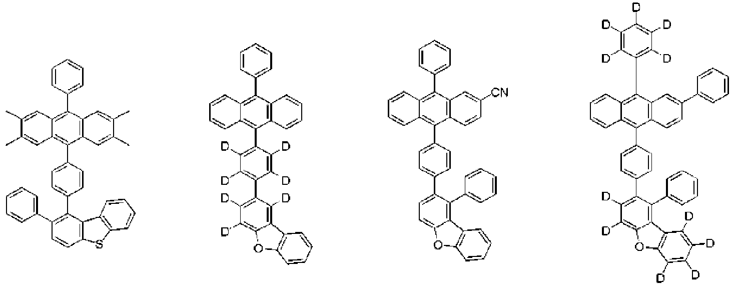

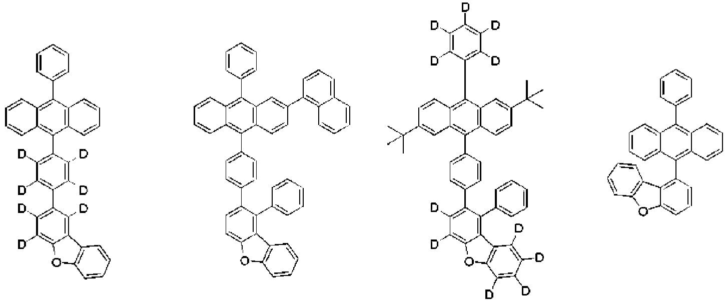

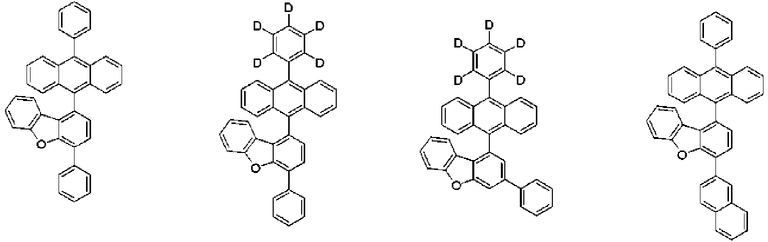

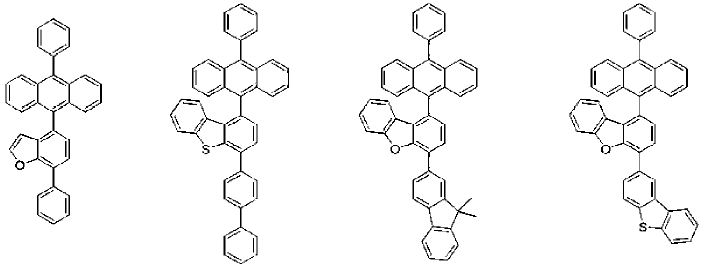

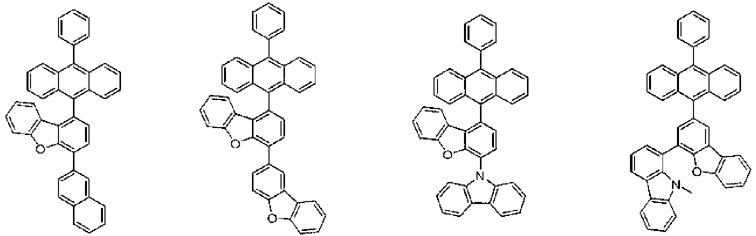

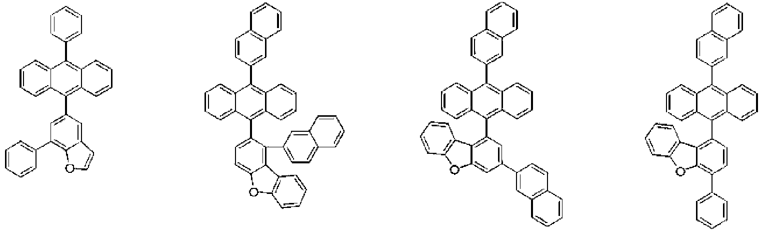

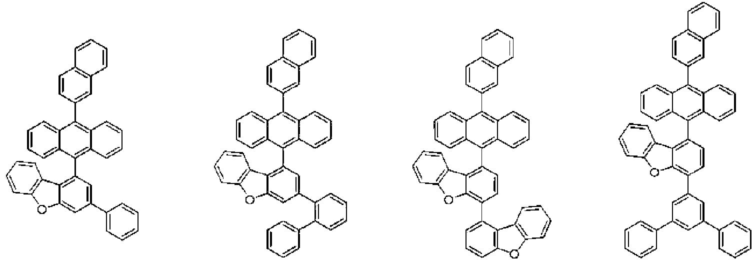

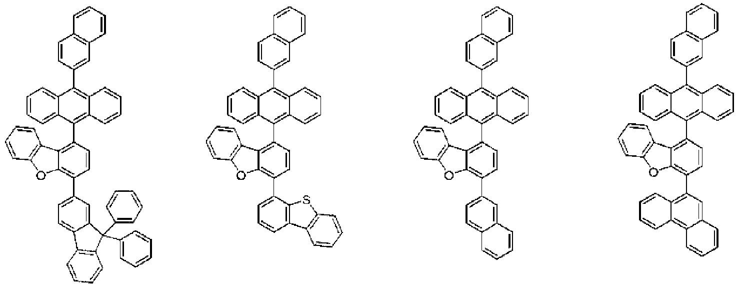

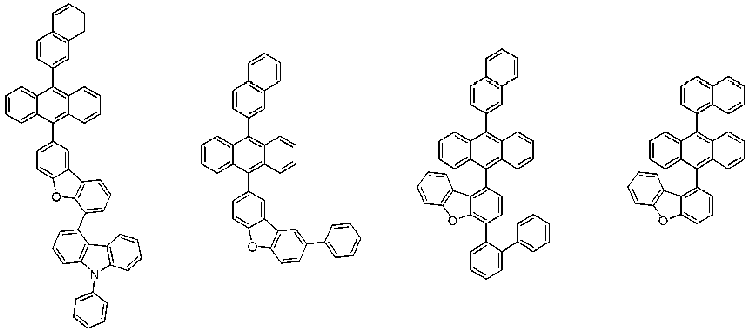

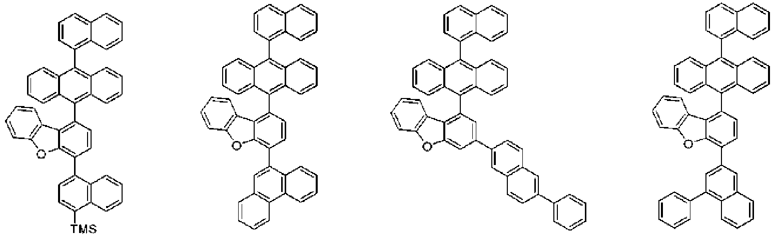

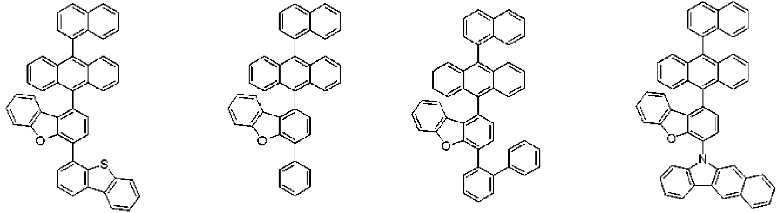

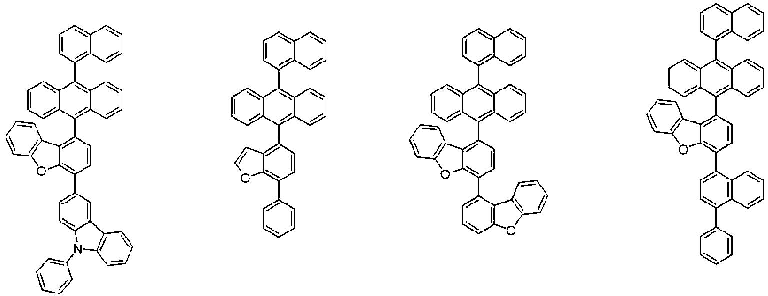

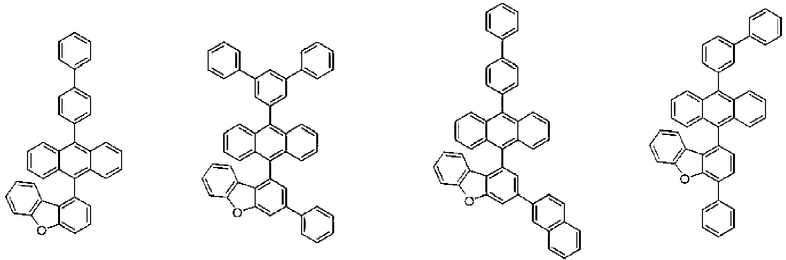

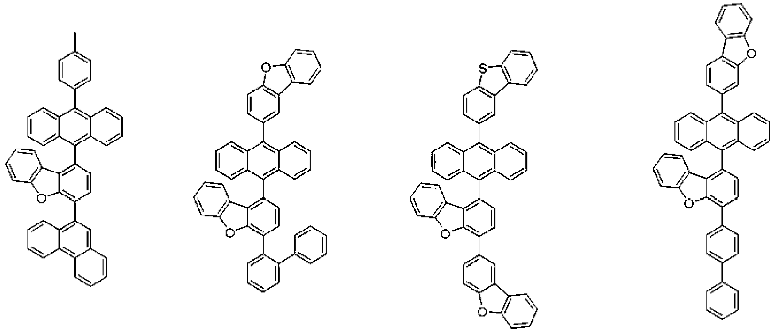

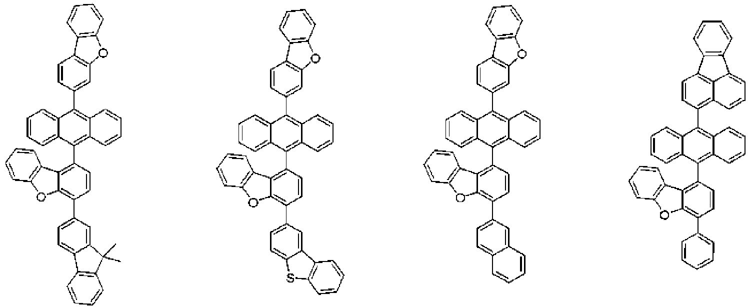

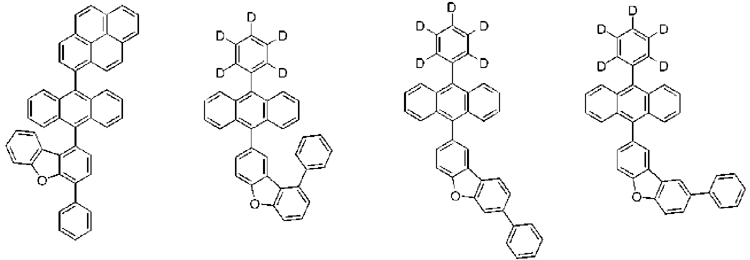

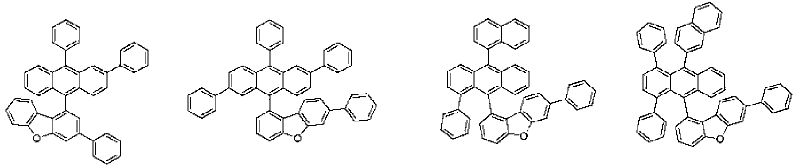

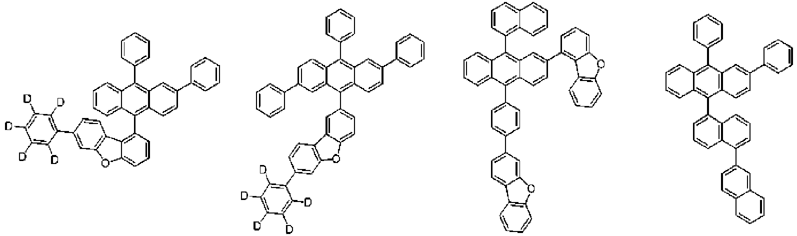

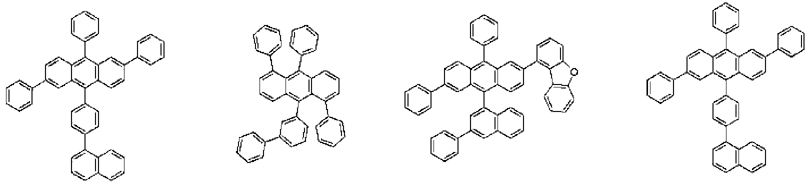

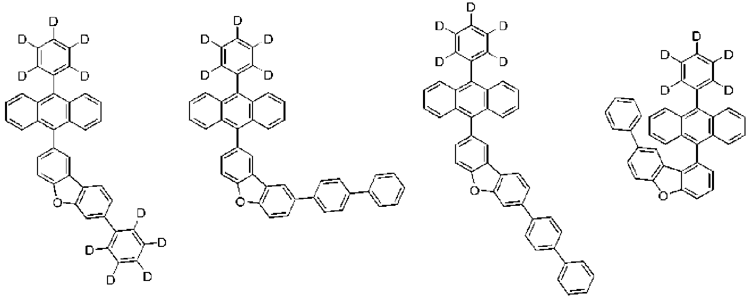

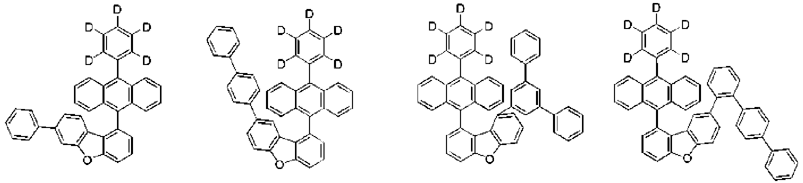

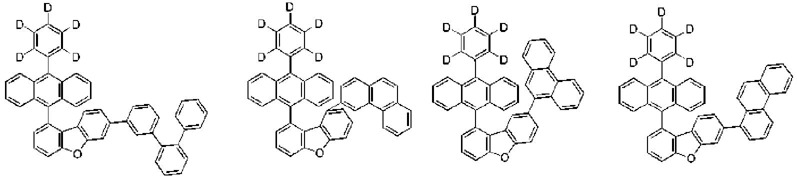

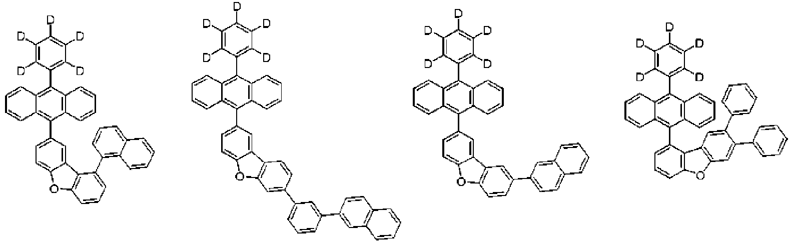

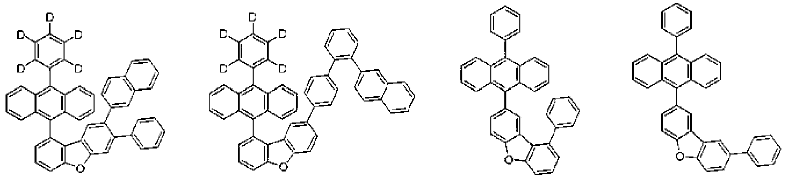

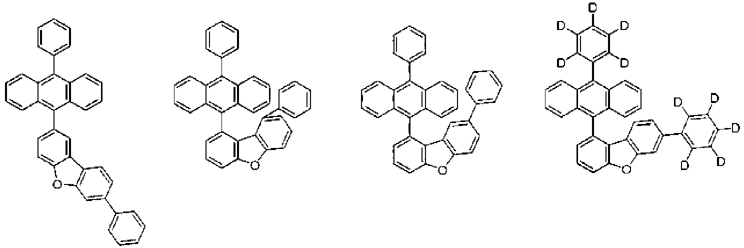

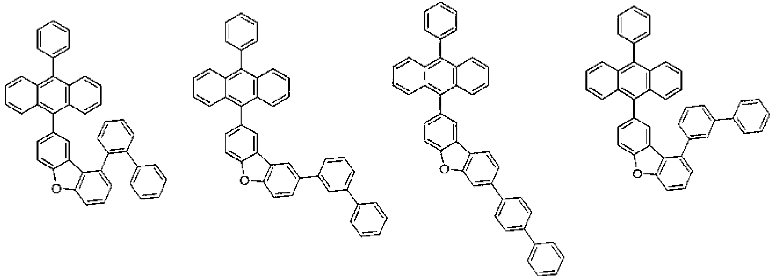

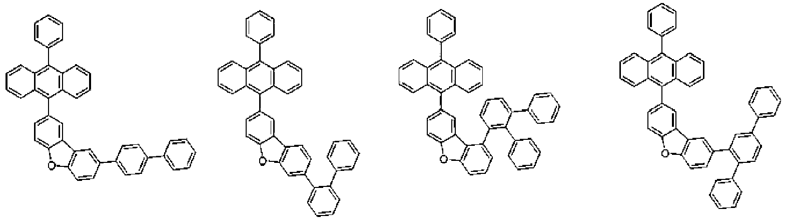

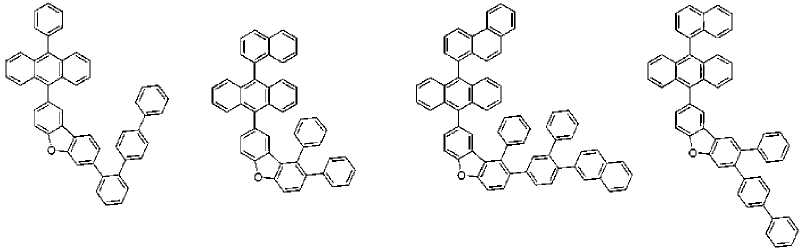

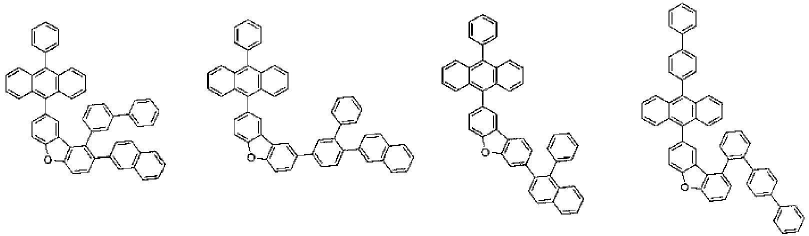

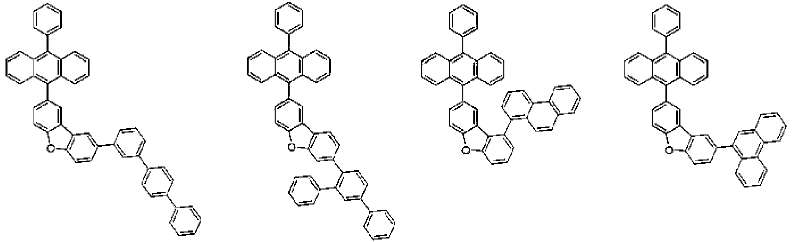

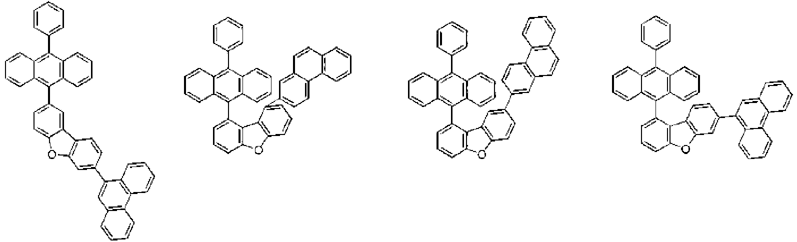

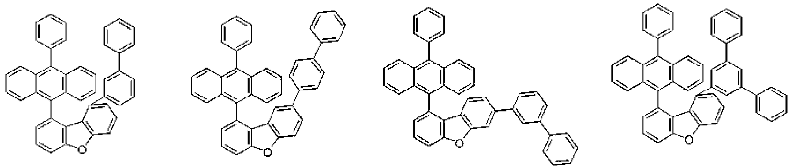

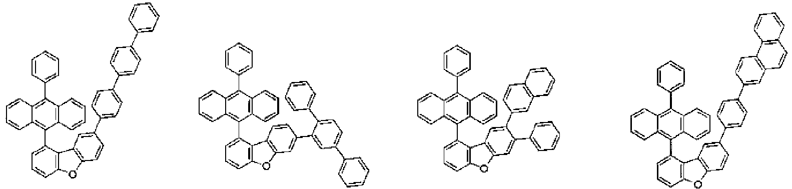

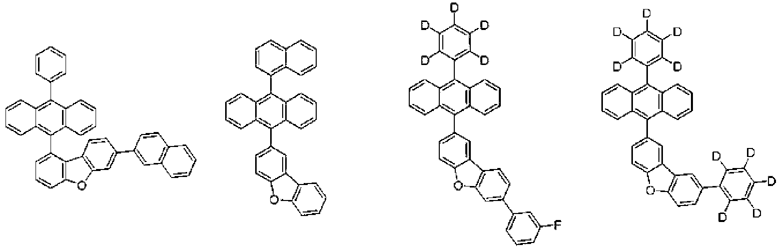

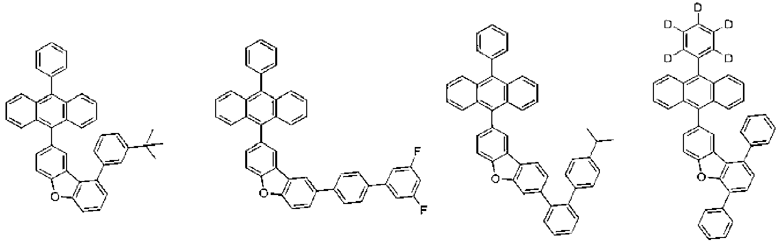

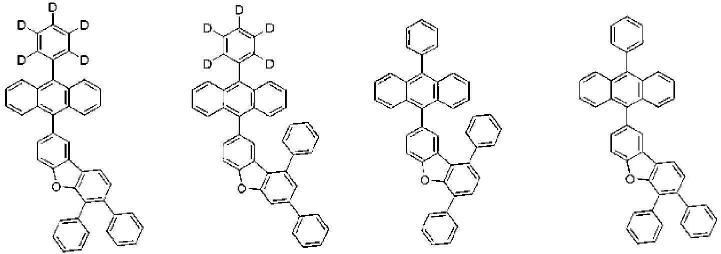

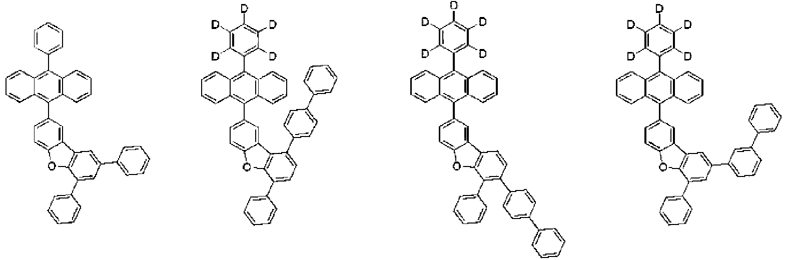

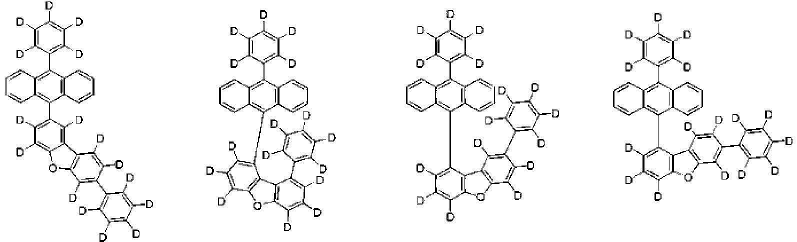

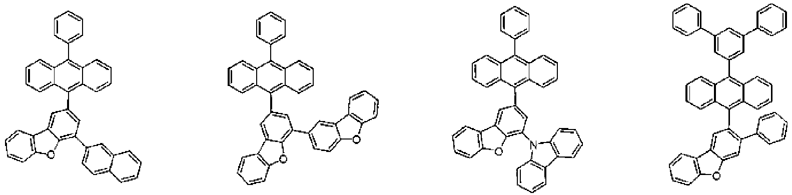

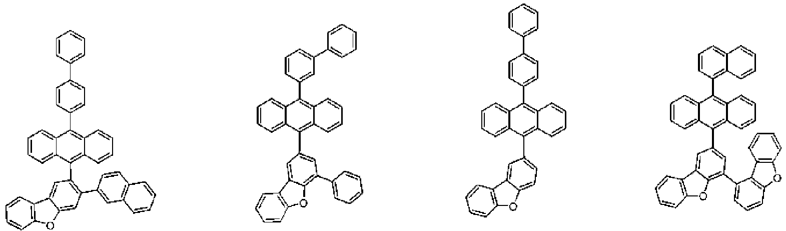

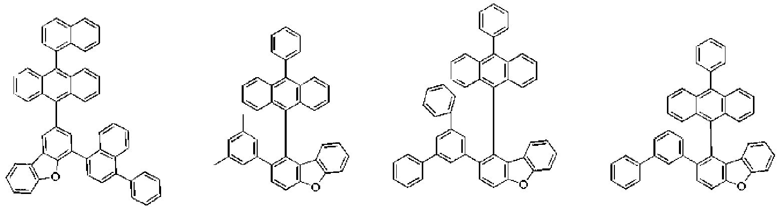

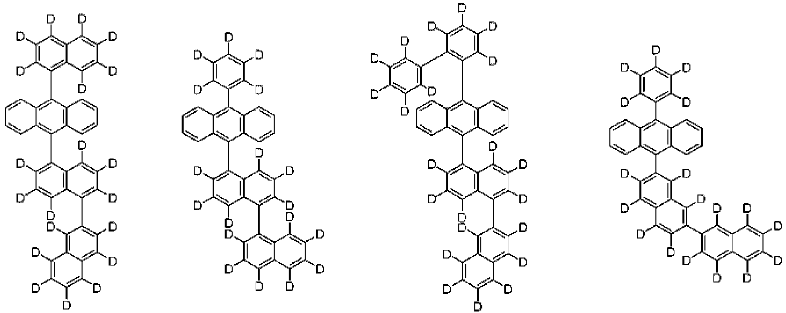

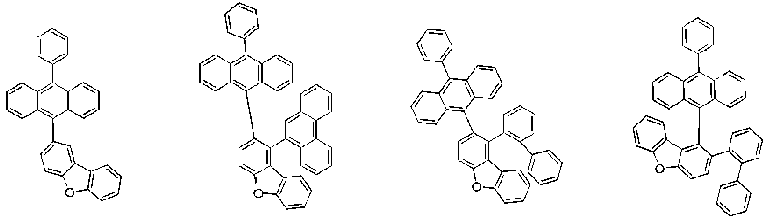

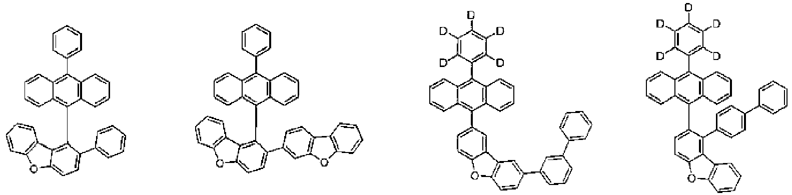

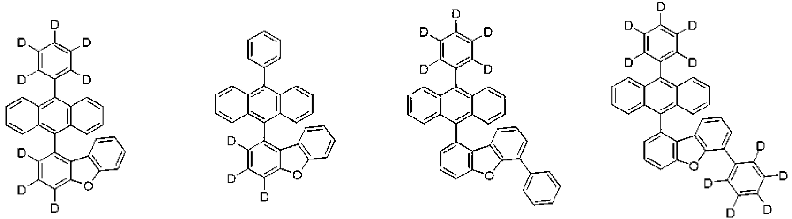

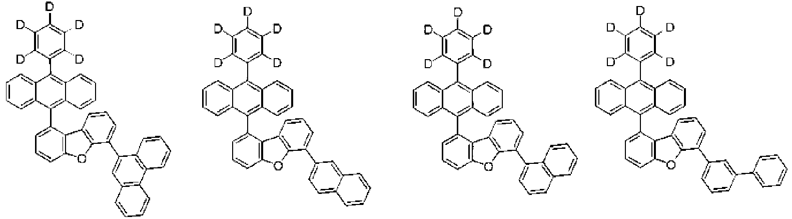

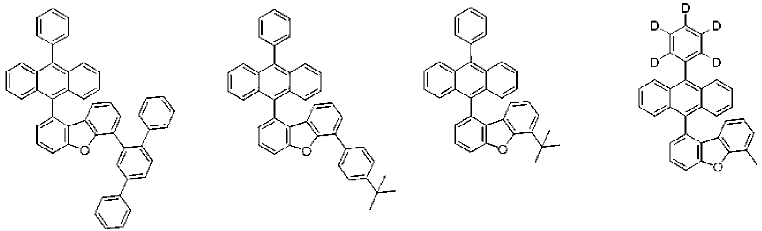

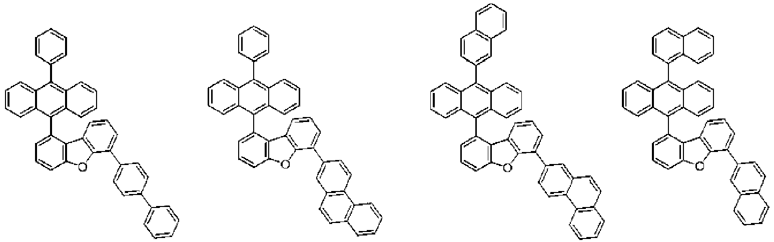

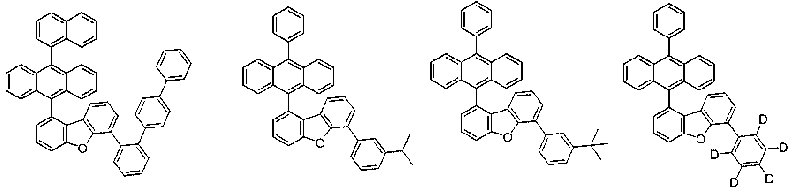

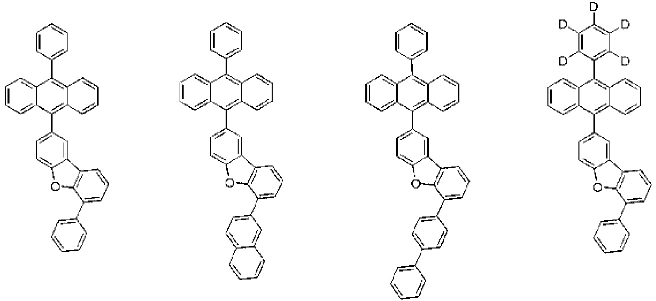

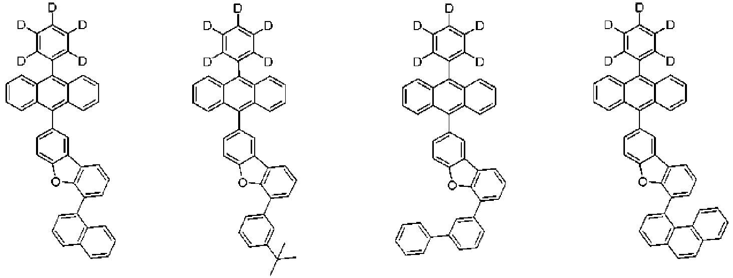

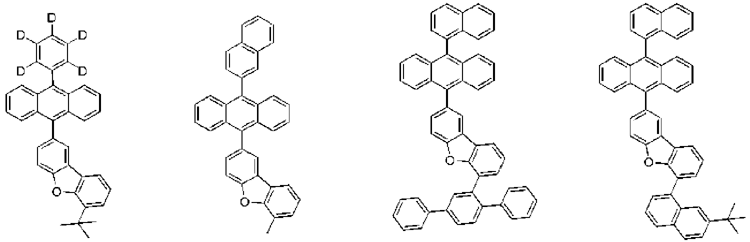

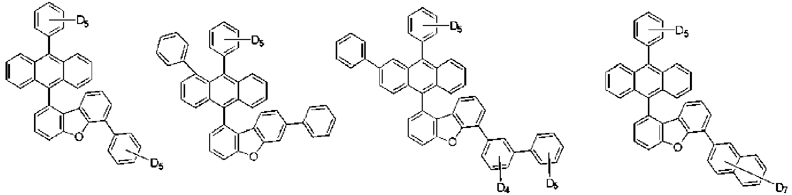

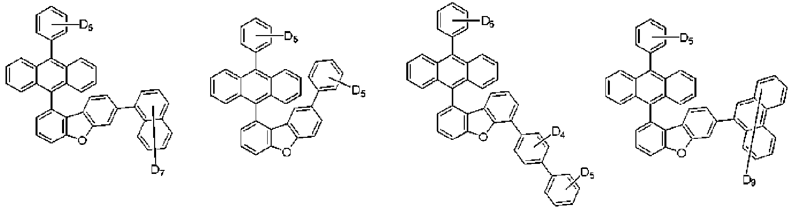

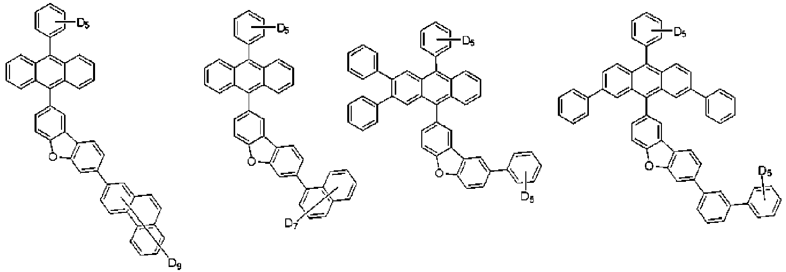

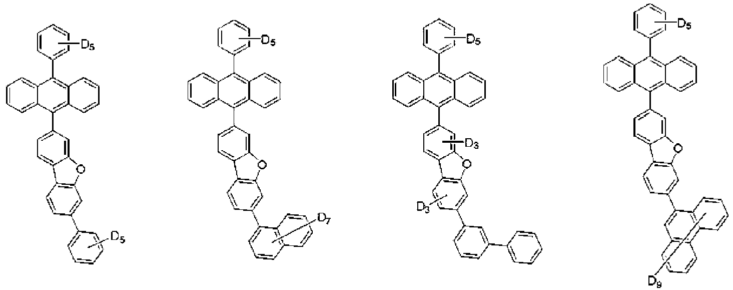

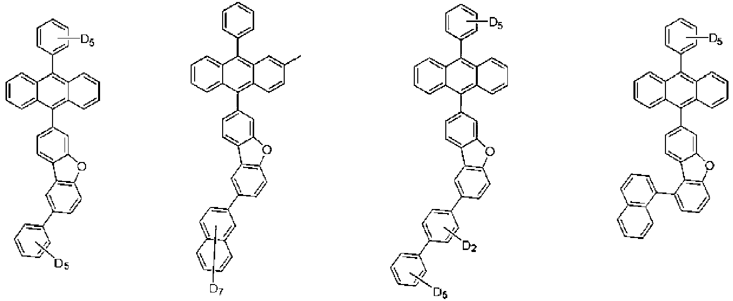

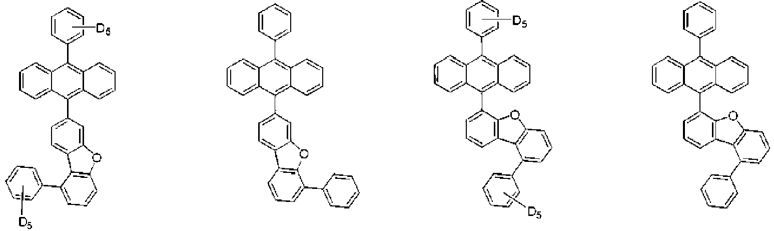

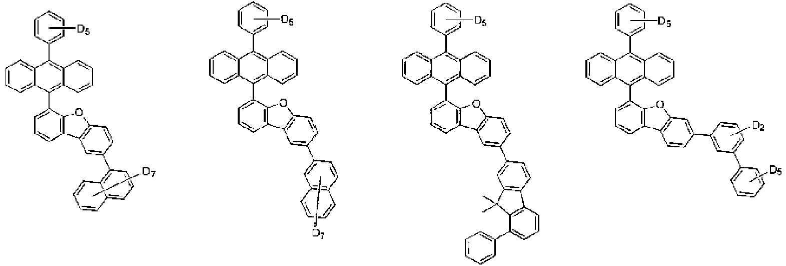

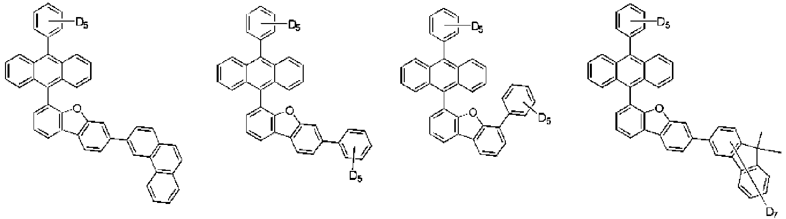

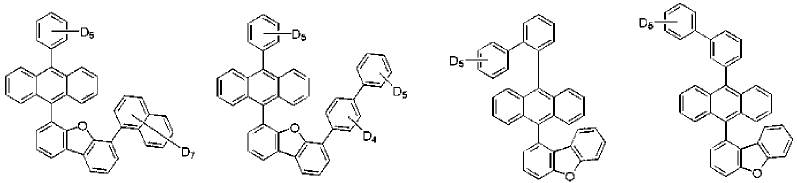

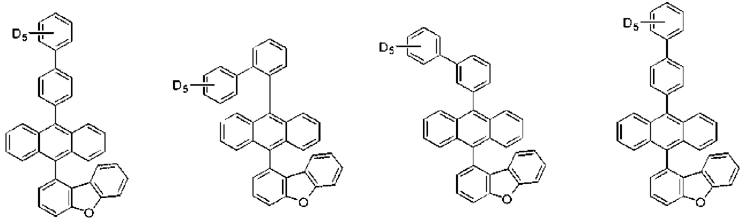

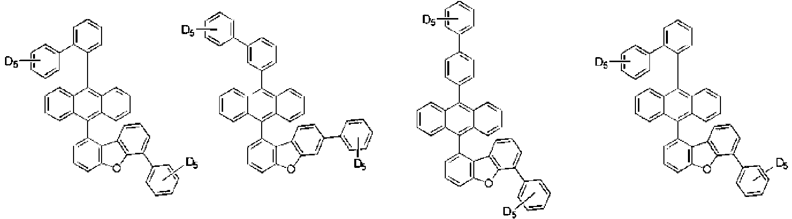

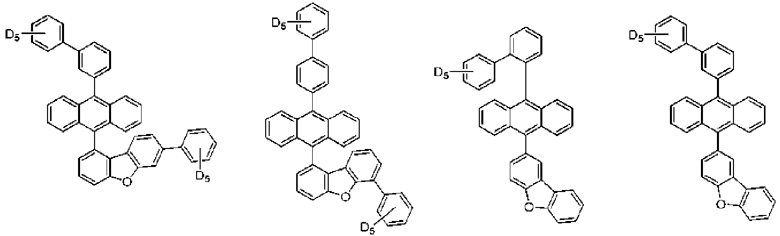

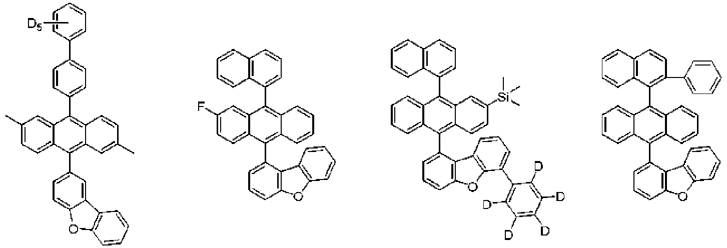

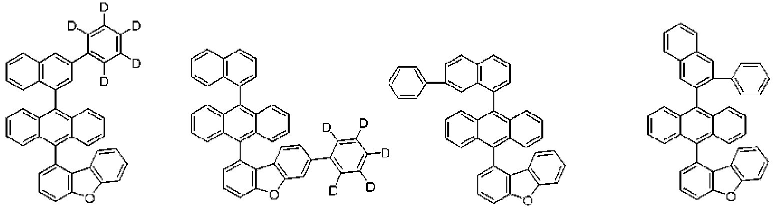

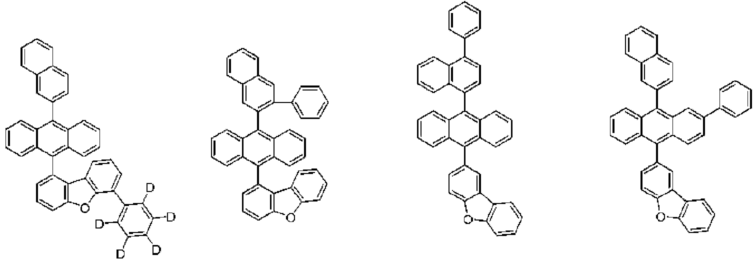

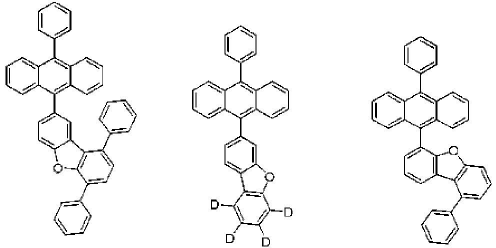

The organic layer of the organic light-emitting device according to the present invention may be formed in a single layer structure, but may be formed in a multilayer structure in which two or more organic layers are laminated. For example, the organic layer may have a structure including a hole injection layer, a hole transport layer, a hole blocking layer, a light-emitting layer, an electron blocking layer, an electron transport layer, an electron injection layer and the like. However, the structure is not limited thereto, and may also include a smaller or larger number of organic layers, and a preferred organic material layer structure of the organic light-emitting device according to the present invention will be described in more detail in examples described below.

In addition, the organic light-emitting device according to one embodiment of the present invention may further include various host and dopant materials in addition to the compound according to the present invention in the light-emitting layer, and accordingly, one or more compounds different from each other may be mixed or laminated and used as the dopant material as well as the host material in the light-emitting layer.

In addition, according to one embodiment of the present invention, the dopant may further include at least one organometallic compound in addition to the compound according to the present invention, which may be mixed or laminated and used.

Accordingly, in the organic light-emitting device according to one embodiment of the present invention, the light-emitting layer may be formed to include a first host, a second host, an organometallic compound and a boron-based thermally activated delayed fluorescence emitter material.

Herein, the organometallic compound functions as a sensitizer and the boron-based thermally activated delayed fluorescence emitter material functions as a light-emitting dopant, and the sensitizer compound receives excitons from the first host and the second host and transfers them to the light-emitting dopant.

Accordingly, excitons are transferred from the sensitizer to the light-emitting dopant compound through a Dexter energy transfer (DET) or Forster resonance transfer (FRET) mechanism, and the exciton energy transferred to the light-emitting dopant compound may be emitted as light during transition to the ground state. Herein, the excitons of the sensitizer may be formed by being transferred from the first host and the second host through a FRET mechanism, or by the transfer of excitons generated from the hosts through a DET mechanism.

Accordingly, energy is readily transferred between the sensitizer and the light-emitting dopant through the FRET and DET mechanisms, and triplet-triplet annihilation is suppressed, thereby enabling the manufacture of a high-efficiency organic light-emitting device.

Using the compound of [Chemical Formula 1] according to the present invention as a boron-based thermally activated delayed fluorescence emitter enables Forster energy transfer from the triplet of the phosphorescence sensitizer to the singlet of the boron-based thermally activated delayed fluorescence emitter, and as a result, a lifespan of the device may be improved by reducing the number of long-lived triplet excitons involved in the degradation of the device.

In addition, since the compound has a high molar extinction coefficient, the rate of fluorescence resonance energy transfer from the phosphorescence sensitizer to the emitter may increase and the emission spectrum may become narrow due to a multiple resonance effect, and as a result, efficiency and lifespan may be improved through effects such as enhanced color purity.

Hereinafter, one embodiment of the organic light-emitting device according to the present invention will be described in more detail.

The organic light-emitting device of the present invention includes an anode, a hole transport layer, a light-emitting layer, an electron transport layer and a cathode. As necessary, the organic light-emitting device of the present invention may further include a hole injection layer between the anode and the hole transport layer, and an electron injection layer between the electron transport layer and the cathode. In addition thereto, one or two intermediate layers may be further formed, a hole blocking layer or an electron blocking layer may be further formed, and as described above, organic layers having various functions such as a capping layer may be further included depending on the device properties.

Meanwhile, the specific structure of the organic light-emitting device according to one embodiment of the present invention, a method for manufacturing the same, and the materials of each organic layer may be examined as follows.

First, a material for an anode electrode is coated on a substrate to form an anode. Herein, substrates used in common organic light-emitting devices may be used as the substrate, and organic substrates or transparent plastic substrates having excellent transparency, surface smoothness, handling readiness and waterproofness are preferred. As the material for an anode electrode, indium tin oxide (ITO), indium zinc oxide (IZO), tin oxide (SnO₂), zinc oxide (ZnO) or the like, which is transparent and has excellent conductivity, is used.

A hole injection layer material is coated on the anode electrode by vacuum thermal deposition or spin coating to form a hole injection layer. Then, a hole transport layer material is coated on the hole injection layer by vacuum thermal deposition or spin coating to form a hole transport layer.

The hole injection layer material is not particularly limited as long as it is commonly used in the art. Examples thereof may include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), N,N'-diphenyl-N,N'-bis(4-(phenyl-m-tolylamino)phenyl)biphenyl-4,4'-diamine (DNTPD), and the like.

The hole transport layer material is not particularly limited as well as long as it is commonly used in the art. Examples thereof may include N,N'-bis(3-methylphenyl)-N,N'-diphenyl-(1,1-biphenyl)-4,4'-diamine (TPD), N,N'-di(naphthalen-1-yl)-N,N'-diphenylbenzidine (α-NPD) and the like.

Subsequently, a hole auxiliary layer and a light-emitting layer are sequentially laminated on the hole transport layer. A hole blocking layer may be optionally formed as a thin film on the light-emitting layer using a method of vacuum deposition or spin coating. When holes pass through an organic light-emitting layer and flow into a cathode, lifespan and efficiency of a device are reduced, and the hole blocking layer performs a role of preventing this problem by using a material having a very low highest occupied molecular orbital (HOMO) level. The hole blocking material used herein is not particularly limited, but needs to have higher ionization potential than a light-emitting compound while having an electron transport ability. Representative examples thereof may include BAlq, BCP, TPBI and the like.

As a material used for the hole blocking layer, BAlq, BCP, Bphen, TPBI, TAZ, BeBq₂, OXD-7, Liq and the like may be used, however, the material is not limited thereto.

After depositing an electron transport layer on the hole blocking layer using a method of vacuum deposition or spin coating, an electron injection layer is formed thereon, and a metal for forming a cathode is vacuum thermal deposited on the electron injection layer to form a cathode, and as a result, the organic light-emitting device according to one embodiment of the present invention is completed.

Herein, as the metal for forming a cathode, lithium (Li), magnesium (Mg), aluminum (Al), aluminum-lithium (Al-Li), calcium (Ca), magnesium-indium (Mg-In), magnesium-silver (Mg-Ag) or the like may be used, and in order to obtain a top emission-type light-emitting device, a transmissive cathode using ITO or IZO may be used.

As a material for the electron transport layer, known electron transport materials functioning to stably transport electrons injected from the cathode may be used. Examples of the known electron transport material may include materials such as quinoline derivatives, particularly tris(8-quinolinolato)aluminum (Alq₃), TAZ, BAlq, beryllium bis(benzoquinolin-10-olate) (Bebq₂) and oxadiazole derivatives (PBD, BMD, BND and the like).

In addition, each of the organic layers may be formed using a monomolecular deposition method or solution process. Herein, the monomolecular deposition method refers to a method of forming a thin film by evaporating a material used for forming each of the layers through heating and the like under vacuum or reduced pressure, and the solution process refers to a method of forming a thin film by mixing a material used for forming each of the layers with a solvent, and then applying a method such as ink-jet printing, roll-to-roll coating, screen printing, spray coating, dip coating or spin coating on the mixture.

In addition, the organic light-emitting device of the present invention may be used in devices selected from flat-panel display devices, flexible display devices, monochromatic or white flat-panel lighting devices, monochromatic or white flexible lighting devices, display devices for vehicles, display devices for virtual or augmented reality, and the like.

Hereinafter, preferred synthesis examples of compounds and device examples are provided in order to help understand the present invention. However, the following examples are for illustrative purposes only, and the scope of the present invention is not limited thereby.

### Synthesis Example 1: Synthesis of [Compound 2]

### Synthesis Example 1-1: Synthesis of A-1

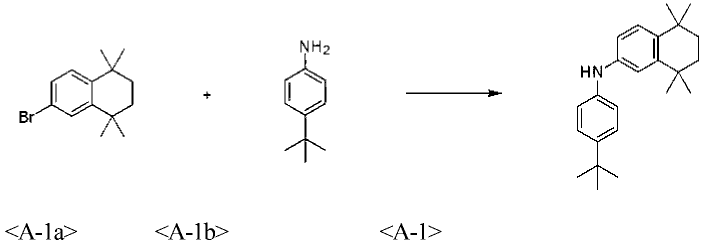

<A-1a> (20 g), <A-1b> (12.3 g), Pd(dba)₃ (1.4 g), P(t-Bu)₃HBF₄ (1.3 g), t-BuONa (10.8 g) and toluene (250 mL) were introduced to a reactor, followed by stirring under reflux for 6 hours. After the reaction was finished, the organic layer was concentrated under reduced pressure, and then purified by column chromatography to obtain <A-1> (21 g, 83.6%).

### Synthesis Example 1-2: Synthesis of A-2

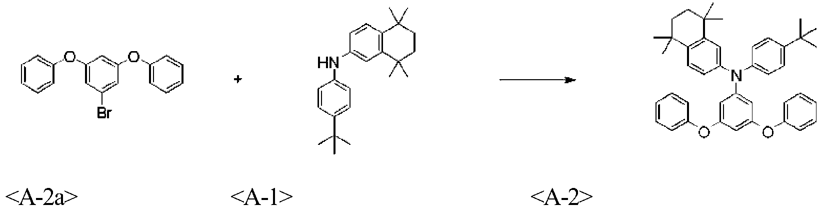

<A-2> was obtained by performing a synthesis in the same manner as in Synthesis Example 1-1, except that <A-2a> was used instead of <A-1a>, and <A-1> was used instead of <A-1b>. (Yield 79%)

### Synthesis Example 1-3: Synthesis of [Compound 2]

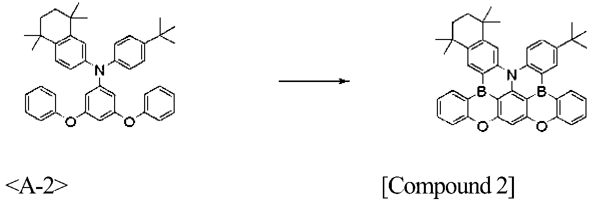

<A-2> (3 g), BI₃ (9.86 g), BPh₃ (2.44 g) and 1,2,4-trichlorobenzene (120 mL) were introduced to a reactor, followed by stirring for 6 hours at 180°C. After that, the temperature was lowered to 120°C, and then N,N-diisopropylethylamine (13.1 mL) was added thereto, followed by stirring for 1 hour. After the reaction was finished, the organic layer was concentrated under reduced pressure, and then purified by column chromatography to obtain [Compound 2] (0.6 g, 19.5%).

### MS (MALDI-TOF): m/z 611.32 [M⁺]

### Synthesis Example 2: Syntheses of [Compound 7] and [Compound 8]

### Synthesis Example 2-1: Synthesis of B-1

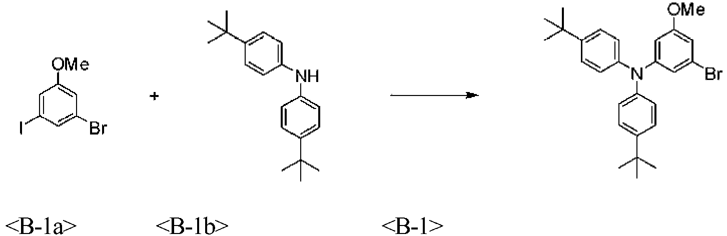

<B-1> was obtained by performing a synthesis in the same manner as in Synthesis Example 1-1, except that <B-1a> was used instead of <A-1a>, and <B-1b> was used instead of <A-1b>. (Yield 77%)

### Synthesis Example 2-2: Synthesis of B-2

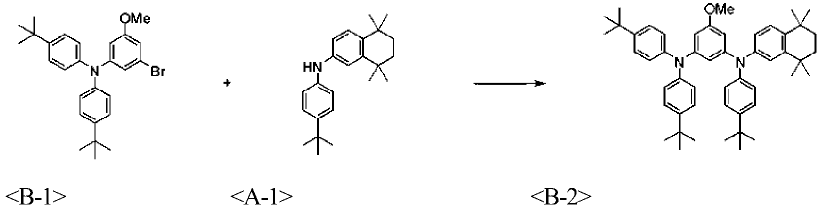

<B-2> was obtained by performing a synthesis in the same manner as in Synthesis Example 1-1, except that <B-1> was used instead of <A-1a>, and <A-1> was used instead of <A-1b>. (Yield 80%)

### Synthesis Example 2-3: Synthesis of B-3

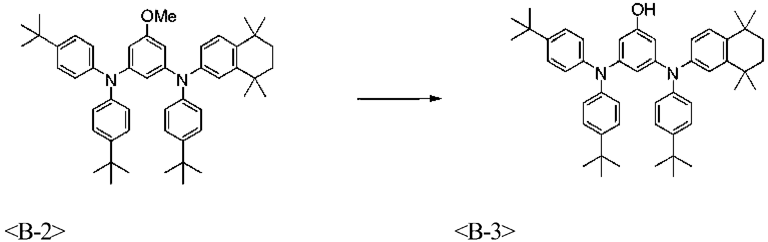

After introducing <B-2> (15 g) and dichloromethane (200 mL) to a reactor, BBr₃ (10.4 g) was added dropwise thereto in small portions while stirring the mixture at -78°C. After that, the temperature was raised to room temperature, and the mixture was stirred for 24 hours. After the reaction was finished, the organic layer was concentrated under reduced pressure, and then purified by column chromatography to obtain <B-3> (7.3 g, 49.6%).

### Synthesis Example 2-4: Synthesis of B-4

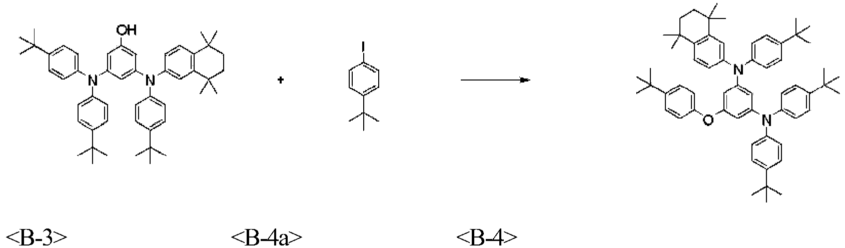

<B-3> (10 g), <B-4a> (11 g), potassium carbonate (7.8 g), CuI (0.04 g), Fe(III)(acac) (0.15 g) and NMP (400 mL) were introduced to a reactor, followed by stirring under reflux for 10 hours at 180°C. After the reaction was finished, the organic layer was concentrated under reduced pressure, and then purified by column chromatography to obtain <B-4> (2.7 g, 22.8%).

### Synthesis Example 2-5: Syntheses of [Compound 7] and [Compound 8]

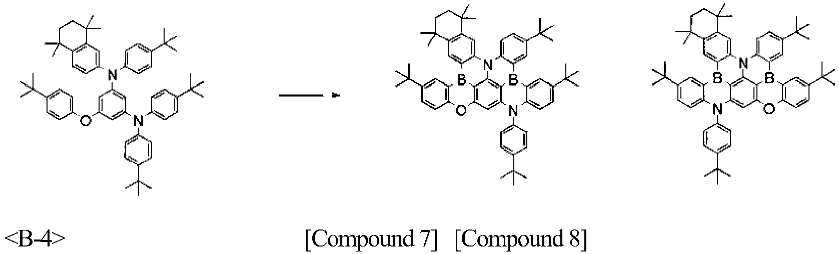

### [Compound 7] and [Compound 8] were obtained by performing a synthesis in the same manner as in Synthesis Example 1-3, except that <B-4> was used instead of <A-2>. (Yields 11% and 6%, respectively)

### MS (MALDI-TOF): m/z 854.55 [M⁺]

### Synthesis Example 3: Syntheses of [Compound 9] and [Compound 10]

### Synthesis Example 3-1: Synthesis of C-1

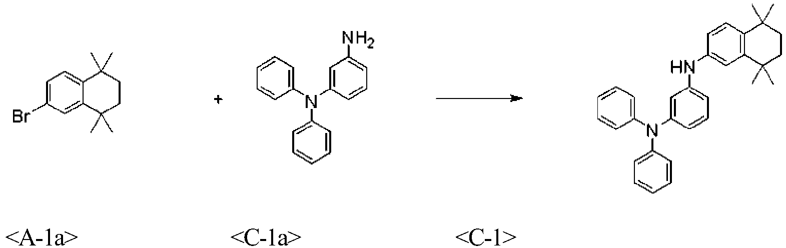

### <C-1> was obtained by performing a synthesis in the same manner as in Synthesis Example 1-1, except that <C-1a> was used instead of <A-1b>. (Yield 72%)

### Synthesis Example 3-2: Synthesis of C-2

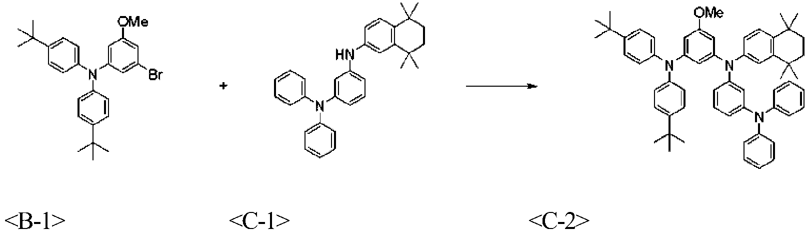

### <C-2> was obtained by performing a synthesis in the same manner as in Synthesis Example 1-1, except that <B-1> was used instead of <A-1a>, and <C-1> was used instead of <A-1b>. (Yield 64%)

### Synthesis Example 3-3: Synthesis of C-3

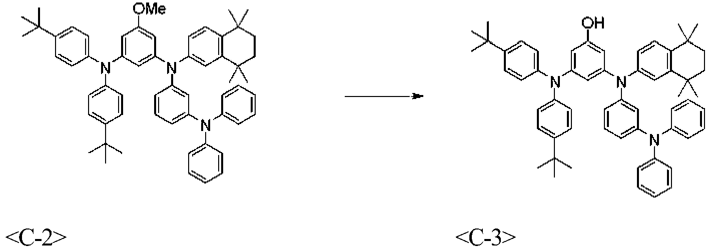

### <C-3> was obtained by performing a synthesis in the same manner as in Synthesis Example 2-3, except that <C-2> was used instead of <B-2>. (Yield 51%)

### Synthesis Example 3-4: Synthesis of C-4

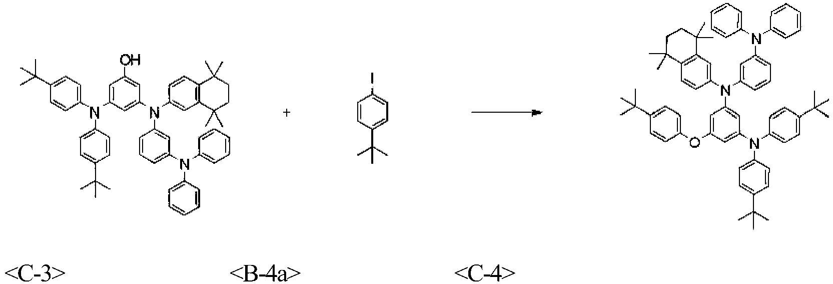

### <C-4> was obtained by performing a synthesis in the same manner as in Synthesis Example 2-4, except that <C-3> was used instead of <B-3>. (Yield 23%)

### Synthesis Example 3-5: Syntheses of [Compound 9] and [Compound 10]

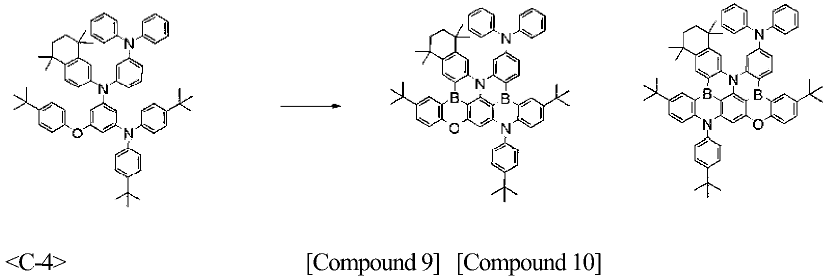

### [Compound 9] and [Compound 10] were obtained by performing a synthesis in the same manner as in Synthesis Example 1-3, except that <C-4> was used instead of <A-2>. (Yields 8% and 5%, respectively)

### MS (MALDI-TOF): m/z 965.56 [M⁺]

### Synthesis Example 4: Synthesis of [Compound 13]

### Synthesis Example 4-1: Synthesis of D-1

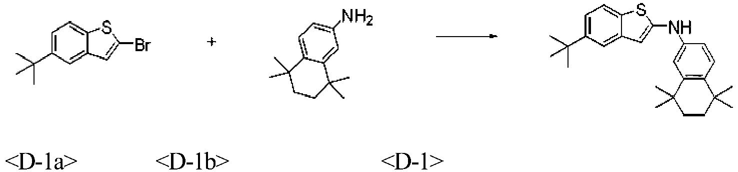

### <D-1> was obtained by performing a synthesis in the same manner as in Synthesis Example 1-1, except that <D-1a> was used instead of <A-1a>, and <D-1b> was used instead of <A-1b>. (Yield 67%)

### Synthesis Example 4-2: Synthesis of D-2

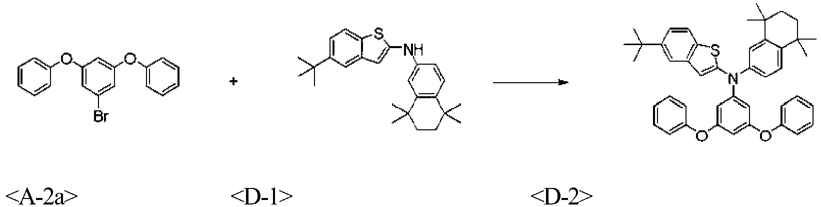

### <D-2> was obtained by performing a synthesis in the same manner as in Synthesis Example 1-1, except that <A-2a> was used instead of <A-1a>, and <D-1> was used instead of <A-1b>. (Yield 73%)

### Synthesis Example 4-3: Synthesis of [Compound 13]

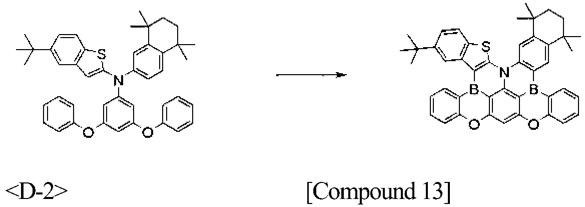

### [Compound 13] was obtained by performing a synthesis in the same manner as in Synthesis Example 1-3, except that <D-2> was used instead of <A-2>. (Yield 18%)

### MS (MALDI-TOF): m/z 667.29 [M⁺]

### Synthesis Example 5: Synthesis of [Compound 39]

### Synthesis Example 5-1: Synthesis of E-1

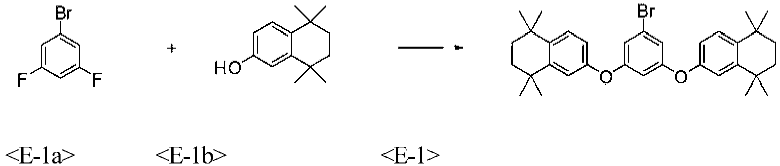

<E-1b> (26.4 g), cesium carbonate (50.6 g) and NMP (120 mL) were introduced to a reactor under a nitrogen atmosphere, followed by stirring. Then, <E-1a> (10 g) was added thereto, and the mixture was stirred for 24 hours at 120°C. After that, the temperature was lowered to 0°C, 6 N HCl (55 mL) was added thereto, and then the result was extracted with toluene. After the reaction was finished, the organic layer was washed with water, concentrated under reduced pressure, and then purified by column chromatography to obtain <E-1> (25.3 g, 87%).

### Synthesis Example 5-2: Synthesis of E-2

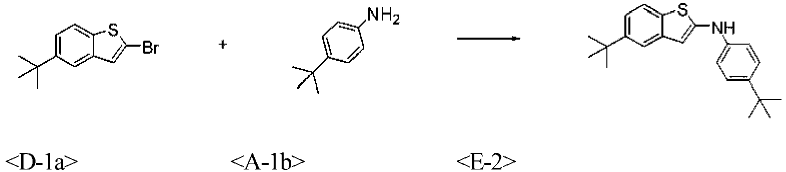

### <E-2> was obtained by performing a synthesis in the same manner as in Synthesis Example 1-1, except that <D-1a> was used instead of <A-1a>. (Yield 75%)

### Synthesis Example 5-3: Synthesis of E-3

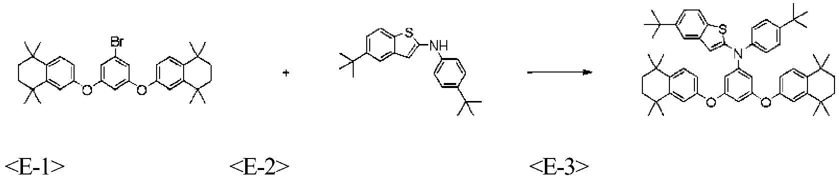

### <E-3> was obtained by performing a synthesis in the same manner as in Synthesis Example 1-1, except that <E-1> was used instead of <A-1a>, and <E-2> was used instead of <A-1b>. (Yield 75%)

### Synthesis Example 5-4: Synthesis of [Compound 39]

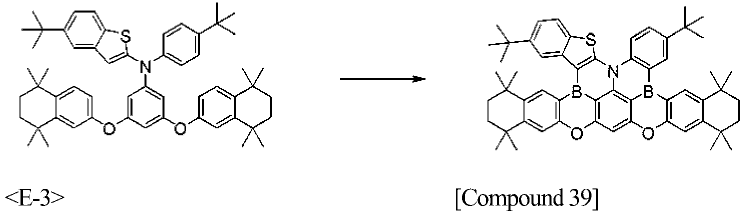

### [Compound 39] was obtained by performing a synthesis in the same manner as in Synthesis Example 1-3, except that <E-3> was used instead of <A-2>. (Yield 19.3%)

### MS (MALDI-TOF): m/z 833.46 [M⁺]

### Examples 1 to 7: Manufacture of Organic Light-Emitting Device

ITO glass was patterned to have a light-emitting area of 2 mm×2 mm, and then cleaned. The ITO glass was installed in a vacuum chamber, and the base pressure was set at 1x10⁻⁷ torr. Then, on the ITO, an electron acceptor having the following Structural Formula [Acceptor-1] and [Chemical Formula F] were deposited (100 Å) at a deposition ratio of 2:98 ([Acceptor-1]:[Chemical Formula F]) as a hole injection layer. [Chemical Formula F] was deposited (550 Å) as a hole transport layer, and subsequently, [Chemical Formula G] was deposited (50 Å) as an electron blocking layer. As a light-emitting layer, a host [BH-1] described below and the compound of the present invention (2 wt%) were mixed and deposited (200 Å). After that, [Chemical Formula H] was deposited (50 Å) as a hole blocking layer, [Chemical Formula E-1] and [Chemical Formula E-2] were deposited (250 Å) at a ratio of 1:1 as an electron transport layer, [Chemical Formula E-2] was deposited (10 Å) as an electron injection layer, and Al was deposited (1000 Å) in this order to manufacture an organic light-emitting device. Light-emitting characteristics of the organic light-emitting device were measured at 0.4 mA.

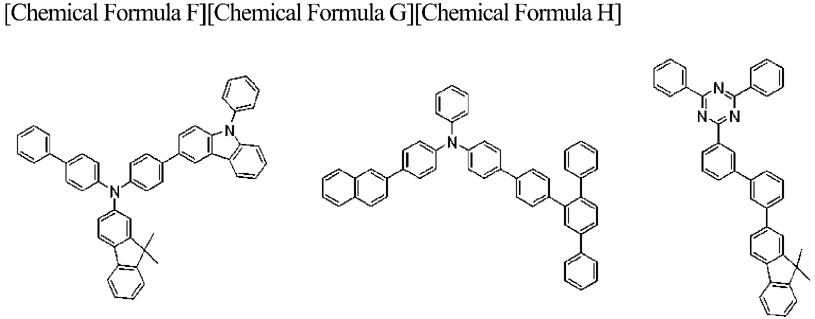

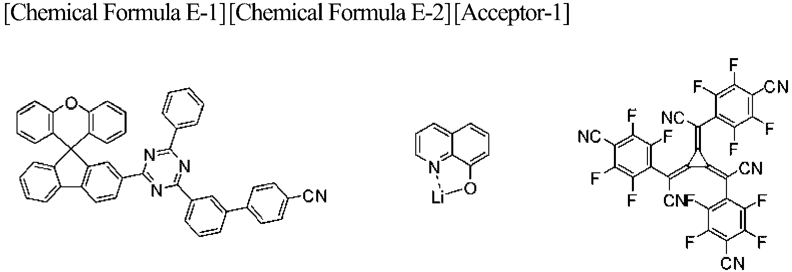

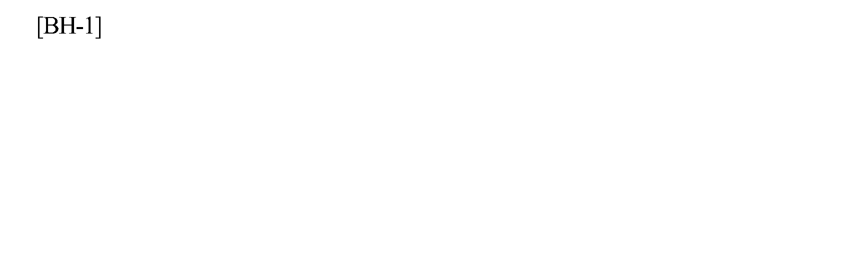

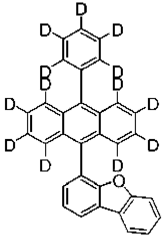

### Comparative Examples 1 to 3

Organic light-emitting devices were manufactured in the same manner as in the Examples, except that [RD-1] to [RD-3] were used instead of the compounds used in the Examples, and light-emitting characteristics of the organic light-emitting devices were measured at 0.4 mA. The structures of [RD-1] to [RD-3] are as follows.

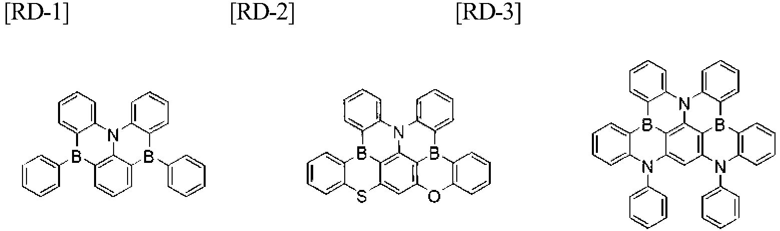

For the organic light-emitting devices manufactured according to Examples 1 to 7 and Comparative Examples 1 to 3, external quantum efficiency and lifespan were measured, and the results are shown in the following [Table 1].

**[Table 1]**

| Classification | Dopant | Efficiency (EQE, %) | Lifespan (T97, hr) |
|---|---|---|---|
| Example 1 | Compound 2 | 8.7 | 140 |
| Example 2 | Compound 7 | 9.5 | 168 |
| Example 3 | Compound 8 | 9.2 | 154 |
| Example 4 | Compound 9 | 10.3 | 167 |
| Example 5 | Compound 10 | 10.9 | 184 |
| Example 6 | Compound 13 | 8.9 | 160 |
| Example 7 | Compound 39 | 8.9 | 135 |
| Comparative Example 1 | RD-1 | 5.6 | 62 |
| Comparative Example 2 | RD-2 | 7.5 | 98 |
| Comparative Example 3 | RD-3 | 7.3 | 85 |

As shown in [Table 1], the device employing the compound according to the present invention as a dopant compound of the light-emitting layer in the organic light-emitting device may realize a high-efficiency and long-lifespan organic light-emitting device having excellent quantum efficiency and lifespan properties compared with the devices (Comparative Examples 1 to 3) employing the compounds having structures contrasting with the characteristic structures of the compound according to the present invention.

### [Industrial Applicability]

The present invention relates to a polycyclic compound having a characteristic fused ring structure, and since a highly efficient and long-lasting organic light-emitting device having excellent device properties such as luminous efficiency and lifespan may be achieved by employing the compound as a dopant material of a light-emitting layer in the organic light-emitting device, the device is industrially useful not only in lighting devices, but also in various display devices such as flat panel, flexible and wearable displays, and displays for virtual or augmented reality.

## Claims

1. A polycyclic compound represented by the following [Chemical Formula 1]: 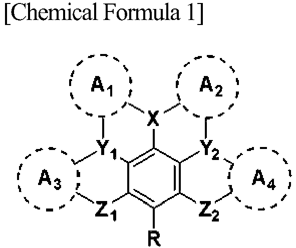
wherein, in [Chemical Formula 1],
X, Y₁ and Y₂ are each independently B or N;
Z₁ and Z₂ are the same as or different from each other, and each independently any one selected from O, S, NR₁, CR₂R₃, SiR₄R₅ and GeR₆R₇;
rings A₁ to A₄ are the same as or different from each other, and each independently any one selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring, and a substituted or unsubstituted ring in which a C₃-C₃₀ aliphatic ring and a C₃-C₃₀ aromatic ring are fused, provided that at least one thereof is a substituted or unsubstituted ring in which a C₃-C₃₀ aliphatic ring and a C₃-C₃₀ aromatic ring are fused;
R is any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₃-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
R₁ to R₇ are the same as or different from each other, and each independently any one selected from a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₃-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
the ring A₁ is linked to X and Y₁ to form a ring, the ring A₂ is linked to X and Y₂ to form a ring, the ring A₃ is linked to Y₁ and Z₁ to form a ring, and the ring A₄ is linked to Y₂ and Z₂ to form a ring;
R is optionally linked to adjacent substituents to further form an alicyclic or aromatic monocyclic or polycyclic ring;
R₂ and R₃, R₄ and R₅, and R₆ and R₇ are each optionally linked to each other to further form an alicyclic or aromatic monocyclic or polycyclic ring;
R₁ to R₇ are optionally linked to the adjacent ring A₃ or A₄ to further form an alicyclic or aromatic monocyclic or polycyclic ring;
the adjacent rings A₁ to A₄ are optionally linked to each other to further form an alicyclic or aromatic monocyclic or polycyclic ring; and
the 'substituted' in the 'substituted or unsubstituted' in [Chemical Formula 1] means being substituted with one, or two or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₃-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, one or more hydrogen atoms in the substituents are optionally substituted with deuterium atoms, and two or more adjacent substituents are optionally linked to each other to further form an alicyclic or aromatic monocyclic or polycyclic ring.

2. The polycyclic compound of claim 1, wherein the ring A₁ in [Chemical Formula 1] is a substituted or unsubstituted ring in which a C₃-C₂₄ aliphatic ring and a C₃-C₂₄ aromatic ring are fused.

3. The polycyclic compound of claim 1, wherein, in [Chemical Formula 1], Y₁ and Y₂ are N when X is B, or Y₁ and Y₂ are B when X is N.

4. The polycyclic compound of claim 1, wherein Z₁ and Z₂ in [Chemical Formula 1] are the same as or different from each other, and each independently any one selected from O, S and NR₁.

5. The polycyclic compound of claim 4, wherein at least one of Z₁ and Z₂ in [Chemical Formula 1] is O or S.

6. The polycyclic compound of claim 2, wherein [Chemical Formula 1] is represented by the following [Chemical Formula 1-1] to [Chemical Formula 1-3]: 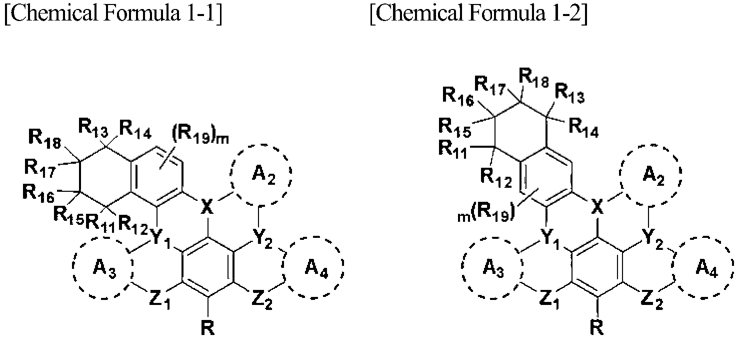 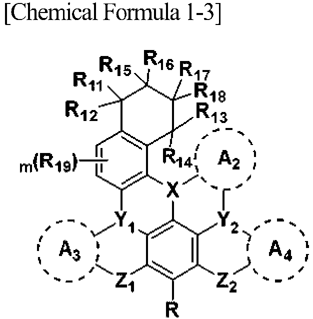
in [Chemical Formula 1-1] to [Chemical Formula 1-3],
X, Y₁ and Y₂ are each independently B or N;
Z₁ and Z₂ are the same as or different from each other, and each independently any one selected from O, S and NR₁;
rings A₂ to A₄ are the same as or different from each other, and each independently any one selected from a substituted or unsubstituted C₆-C₅₀ aromatic hydrocarbon ring, a substituted or unsubstituted C₃-C₅₀ aliphatic hydrocarbon ring, a substituted or unsubstituted C₂-C₅₀ aromatic heteroring, a substituted or unsubstituted C₂-C₅₀ aliphatic heteroring, and a substituted or unsubstituted ring in which a C₃-C₃₀ aliphatic ring and a C₃-C₃₀ aromatic ring are fused;
R and R₁₉ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, a substituted or unsubstituted cyclic group in which a C₃-C₃₀ aliphatic ring and a C₃-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₅-C₃₀ arylthioxy group, a substituted or unsubstituted amine group, a substituted or unsubstituted silyl group, a substituted or unsubstituted germanium group, a nitro group, a cyano group, and a halogen group;
R₁ and R₁₁ to R₁₄ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₅₀ aryl group, a substituted or unsubstituted C₃-C₅₀ cycloalkyl group, a substituted or unsubstituted C₂-C₅₀ heterocycloalkyl group, a substituted or unsubstituted C₂-C₅₀ heteroaryl group, and a substituted or unsubstituted cyclic group in which a C₃-C₃₀ aliphatic ring and a C₃-C₃₀ aromatic ring are fused;
R₁₅ to R₁₈ are the same as or different from each other, and each independently hydrogen or deuterium;
m is an integer of 2,
the ring A₂ is linked to X and Y₂ to form a ring, the ring A₃ is linked to Y₁ and Z₁ to form a ring, and the ring A₄ is linked to Y₂ and Z₂ to form a ring;
R is optionally linked to adjacent substituents to further form an alicyclic or aromatic monocyclic or polycyclic ring;
the adjacent R₁₁ to R₁₄ are optionally linked to each other to further form an alicyclic or aromatic monocyclic or polycyclic ring;
R₁ is optionally linked to the adjacent ring A₃ or A₄ to further form an alicyclic or aromatic monocyclic or polycyclic ring;
the adjacent rings A₂ and A₄ are optionally linked to each other to further form an alicyclic or aromatic monocyclic or polycyclic ring; and
the 'substituted' in the 'substituted or unsubstituted' in [Chemical Formula 1-1] to [Chemical Formula 1-3] means being substituted with one, or two or more substituents selected from the group consisting of deuterium, a C₁-C₂₄ alkyl group, a C₁-C₂₄ halogenated alkyl group, a C₂-C₂₄ alkenyl group, a C₂-C₂₄ alkynyl group, a C₃-C₃₀ cycloalkyl group, a C₁-C₂₄ heteroalkyl group, a C₆-C₃₀ aryl group, a C₇-C₃₀ arylalkyl group, a C₇-C₃₀ alkylaryl group, a C₂-C₃₀ heteroaryl group, a C₂-C₃₀ heteroarylalkyl group, a cyclic group in which a C₃-C₂₄ aliphatic ring and a C₃-C₂₄ aromatic ring are fused, a C₁-C₂₄ alkoxy group, a C₁-C₃₀ amine group, a C₁-C₃₀ silyl group, a C₁-C₃₀ germanium group, a C₆-C₂₄ aryloxy group, a C₆-C₂₄ arylthionyl group, a cyano group, a halogen group, a hydroxyl group and a nitro group, or being substituted with a substituent in which two or more of the above-mentioned substituents are linked, one or more hydrogen atoms in the substituents are optionally substituted with deuterium atoms, and two or more adjacent substituents are optionally linked to each other to further form an alicyclic or aromatic monocyclic or polycyclic ring.

7. The polycyclic compound of claim 6, wherein, in [Chemical Formula 1-1] to [Chemical Formula 1-3], Y₁ and Y₂ are N when X is B, or Y₁ and Y₂ are B when X is N.

8. The polycyclic compound of claim 1, wherein at least one hydrogen atom in [Chemical Formula 1] may be substituted with deuterium.

9. The polycyclic compound of claim 1, wherein [Chemical Formula 1] is any one selected from the following compounds:

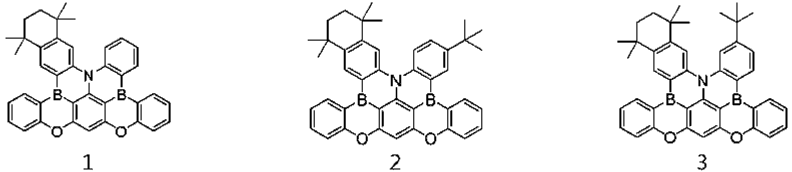

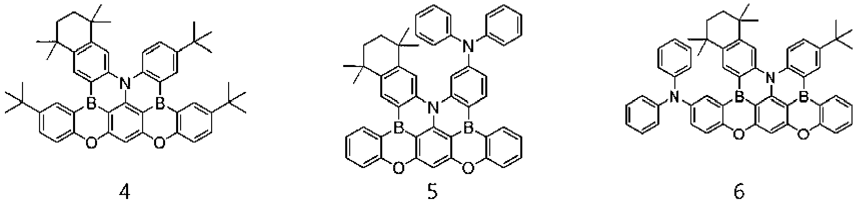

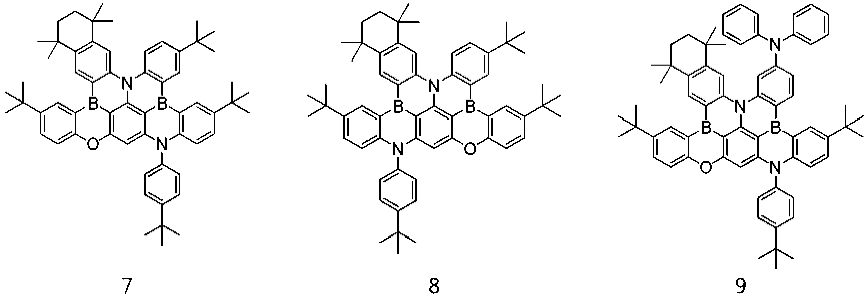

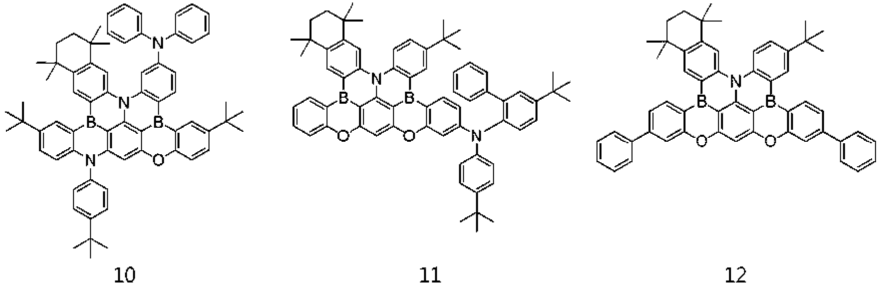

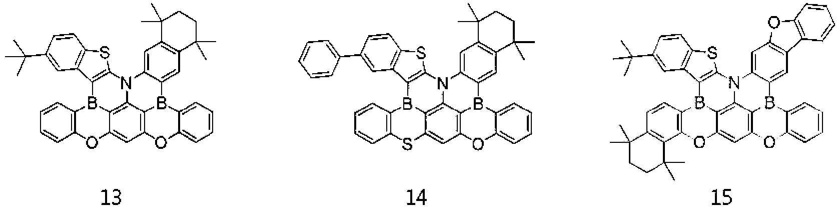

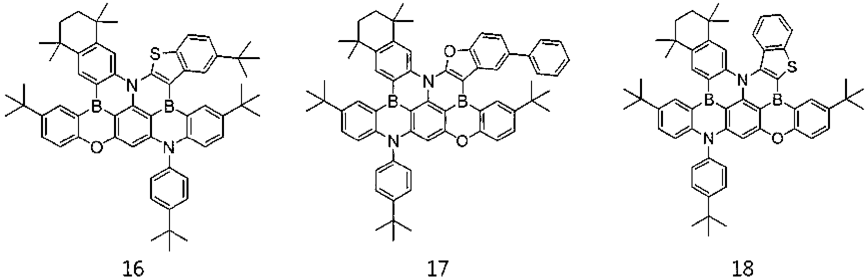

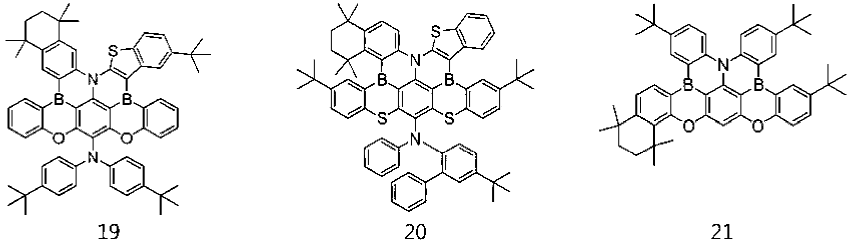

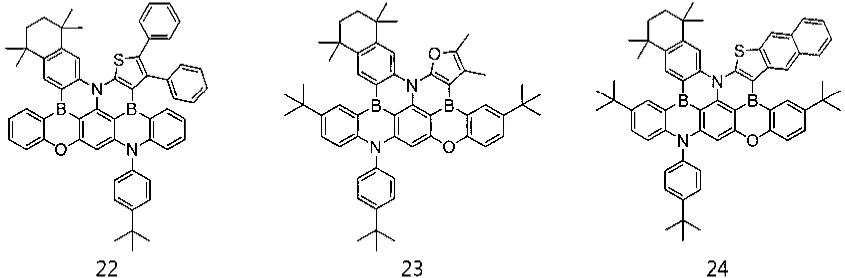

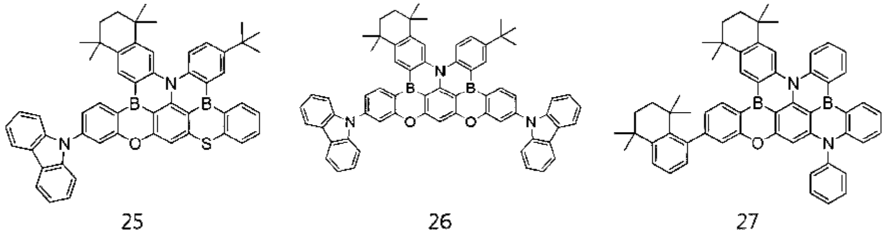

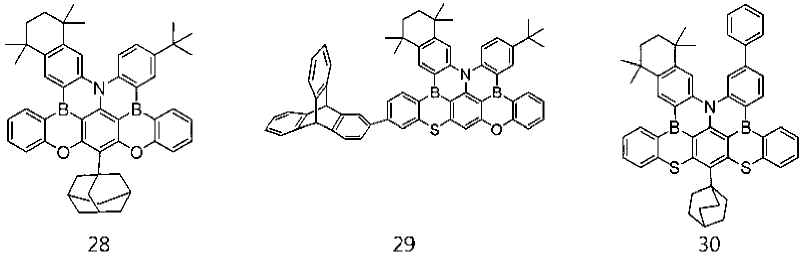

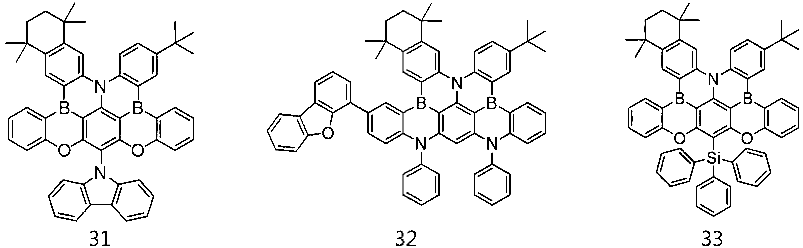

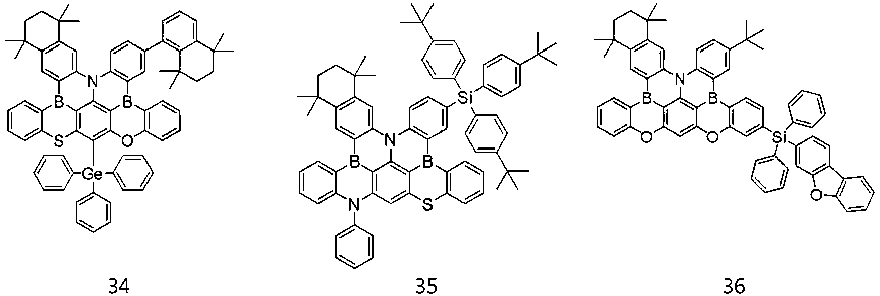

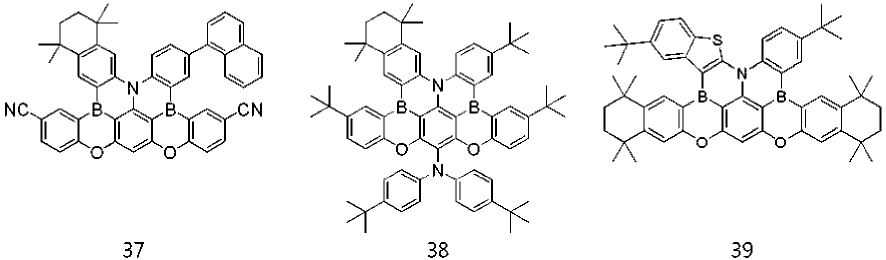

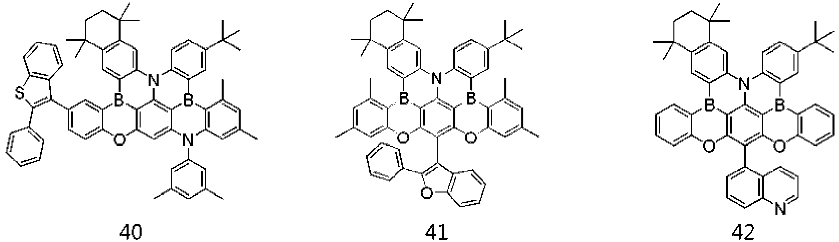

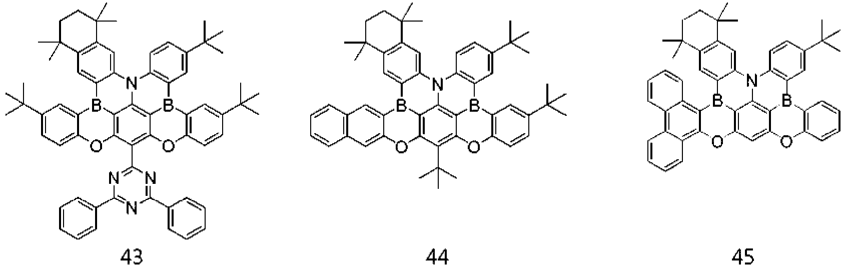

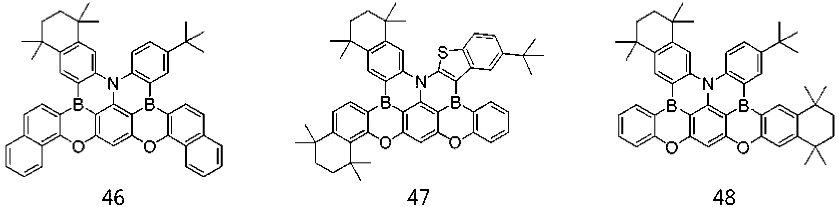

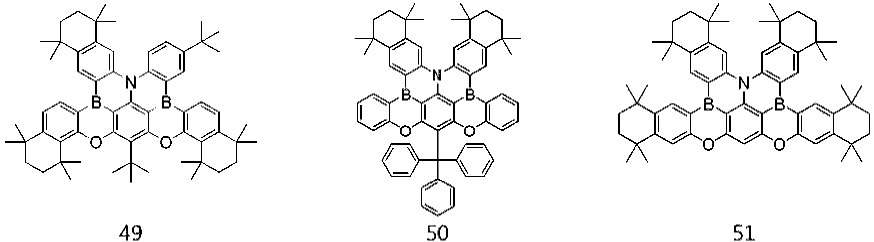

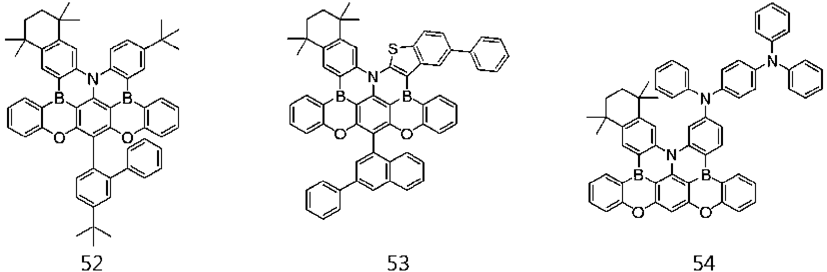

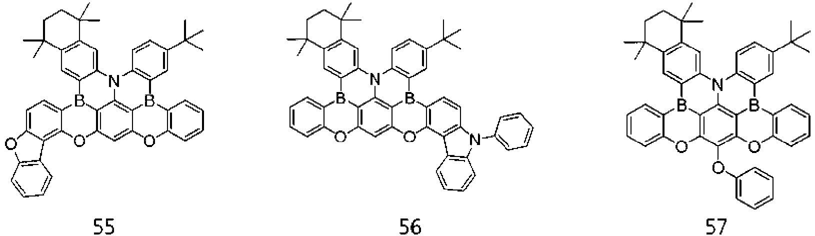

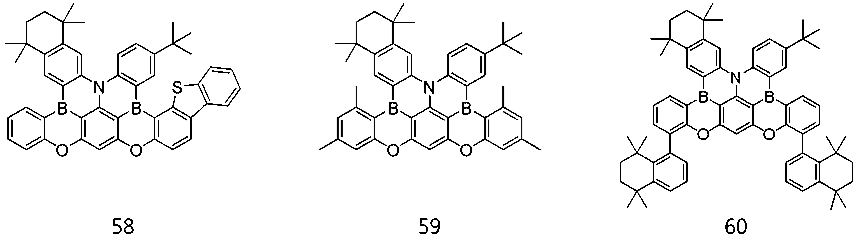

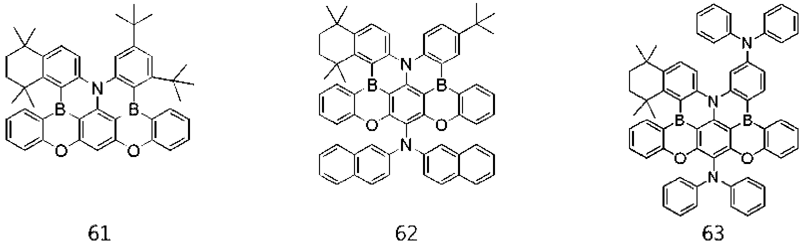

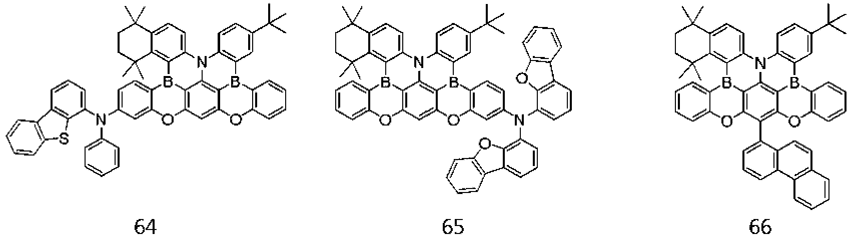

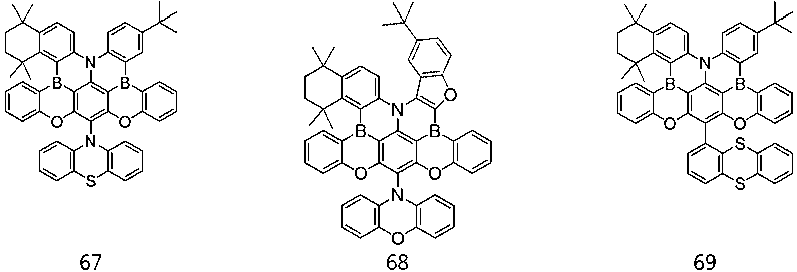

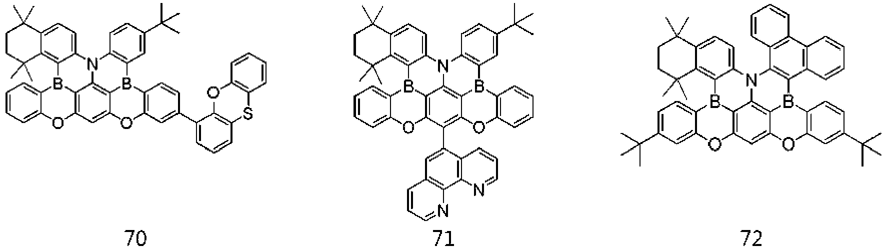

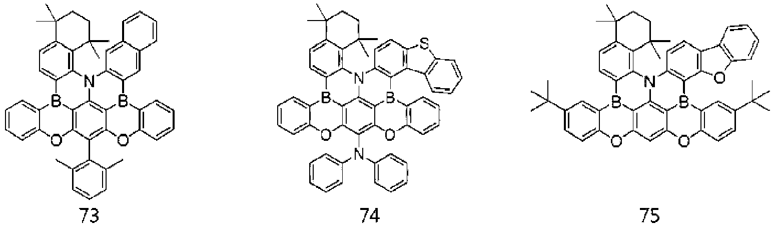

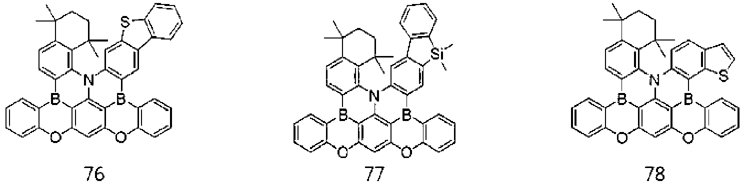

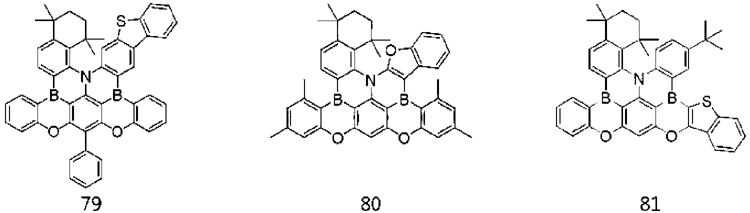

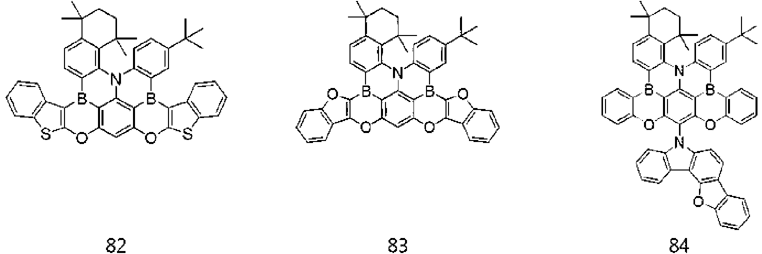

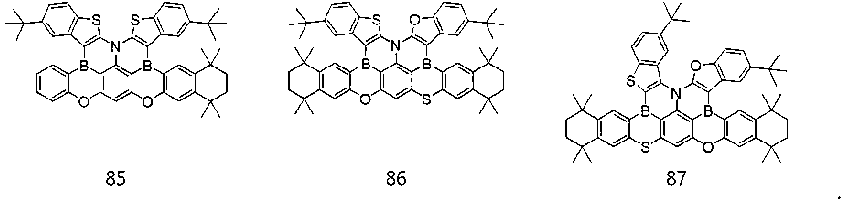

10. An organic light-emitting device comprising:
a first electrode;
a second electrode provided opposite to the first electrode; and
an organic layer interposed between the first electrode and the second electrode,
wherein the organic layer includes at least one of an electron injection layer, a hole injection layer, a hole transport layer, an electron blocking layer, a functional layer having both hole injection and hole transport functions, a light-emitting layer, an electron transport layer, a hole blocking layer, a functional layer having both electron injection and electron transport functions; and
the organic layer includes at least one polycyclic compound represented by [Chemical Formula 1] of claim 1.

11. The organic light-emitting device of claim 10, wherein the light-emitting layer includes a host and a dopant, and at least one of the polycyclic compounds represented by [Chemical Formula 1] is a dopant in the light-emitting layer.

12. The organic light-emitting device of claim 11, wherein, as the dopant, one or more other compounds are mixed or laminated and used in addition to the one polycyclic compound represented by [Chemical Formula 1].

13. The organic light-emitting device of claim 11, wherein at least one anthracene compound represented by the following [Chemical Formula 2] is mixed or laminated and used as a host in the light-emitting layer: 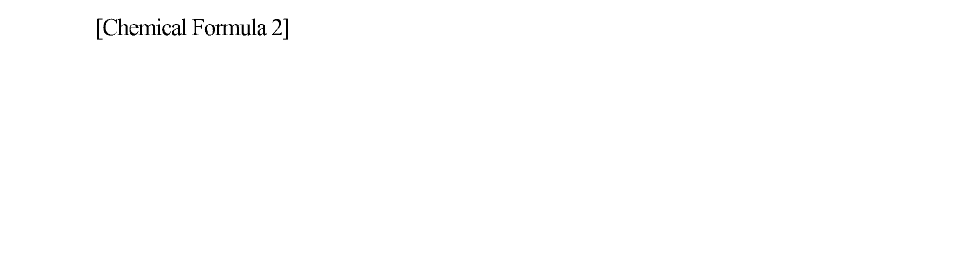 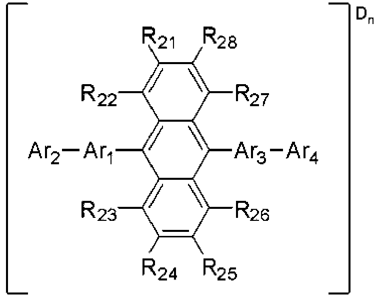 in [Chemical Formula 2],
R₂₁ to R₂₈ are the same as or different from each other, and each independently any one selected from hydrogen, deuterium, a substituted or unsubstituted C₁-C₃₀ alkyl group, a substituted or unsubstituted C₂-C₃₀ alkynyl group, a substituted or unsubstituted C₂-C₃₀ alkenyl group, a substituted or unsubstituted C₆-C₃₀ aryl group, a substituted or unsubstituted C₃-C₅₀ cycloalkyl group, a substituted or unsubstituted C₂-C₃₀ heterocycloalkyl group, a substituted or unsubstituted C₂-C₃₀ heteroaryl group, a substituted or unsubstituted cyclic group in which a C₃-C₃₀ aliphatic ring and a C₃-C₃₀ aromatic ring are fused, a substituted or unsubstituted C₁-C₃₀ alkoxy group, a substituted or unsubstituted C₆-C₃₀ aryloxy group, a substituted or unsubstituted C₁-C₃₀ alkylthioxy group, a substituted or unsubstituted C₃-C₃₀ arylthioxy group, a substituted or unsubstituted amine group, a substituted or unsubstituted silyl group, a substituted or unsubstituted germanium group, a nitro group, a cyano group, and a halogen group;
Ar₁ and Ar₃ are the same as or different from each other, and each independently a single bond, or a substituted or unsubstituted C₆-C₃₀ arylene group, a substituted or unsubstituted C₂-C₃₀ heteroarylene group, and a substituted or unsubstituted divalent cyclic group in which a C₃-C₃₀ aliphatic ring and a C₃-C₃₀ aromatic ring are fused;
Ar₂ and Ar₄ are the same as or different from each other, and each independently any one selected from a substituted or unsubstituted C₆-C₃₀ aryl group, a substituted or unsubstituted C₃-C₃₀ cycloalkyl group, a substituted or unsubstituted C₃-C₃₀ heterocycloalkyl group, a substituted or unsubstituted C₂-C₅₀ heteroaryl group, and a substituted or unsubstituted cyclic group in which a C₃-C₃₀ aliphatic ring and a C₃-C₃₀ aromatic ring are fused;
Dₙ refers to the number of hydrogen atoms replaced by deuterium atoms in [Chemical Formula 2]; and
n is an integer of 0 to 60.

14. The organic light-emitting device of claim 13, wherein the compound represented by [Chemical Formula 2] is any one selected from the following compounds:

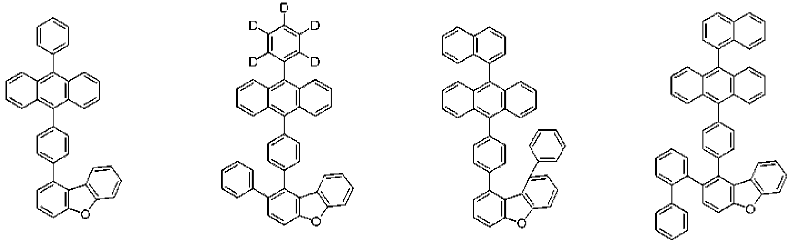

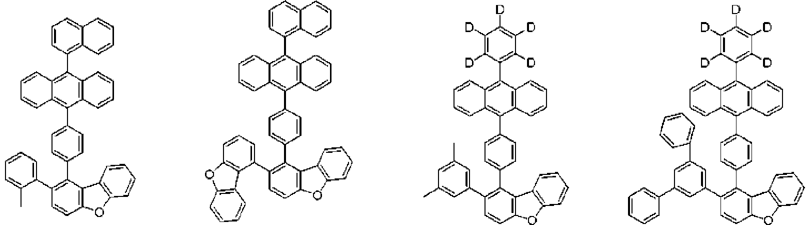

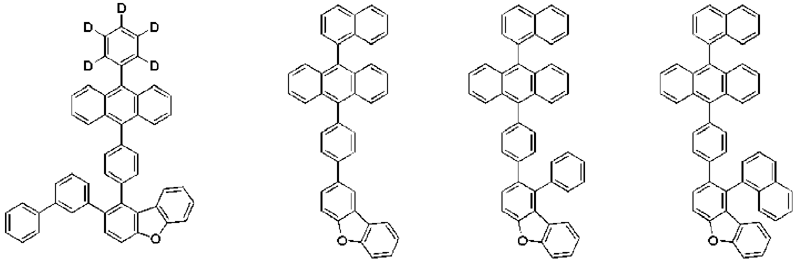

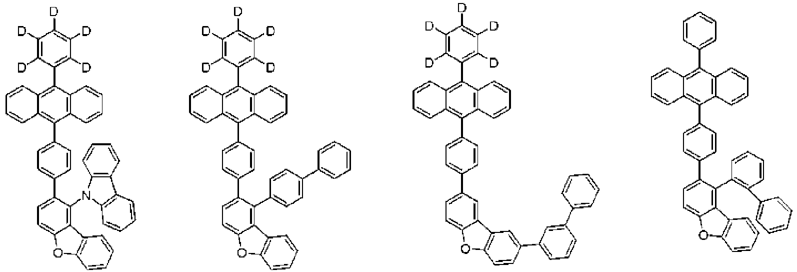

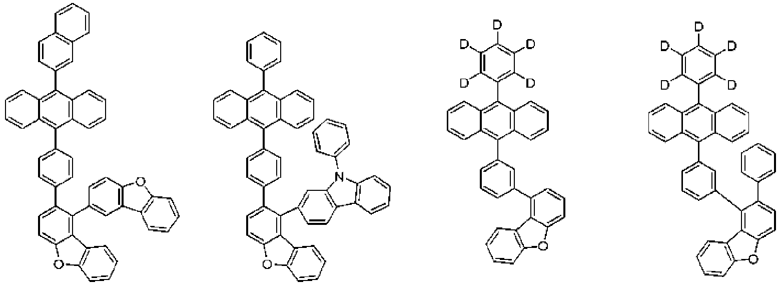

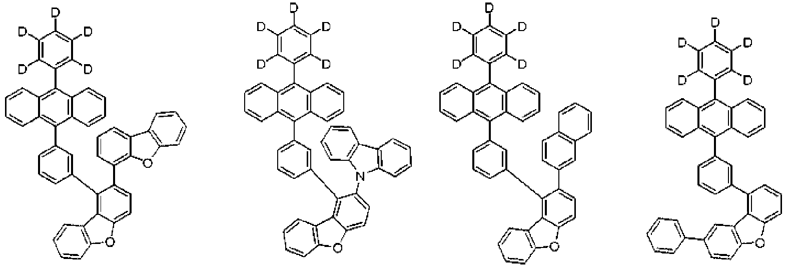

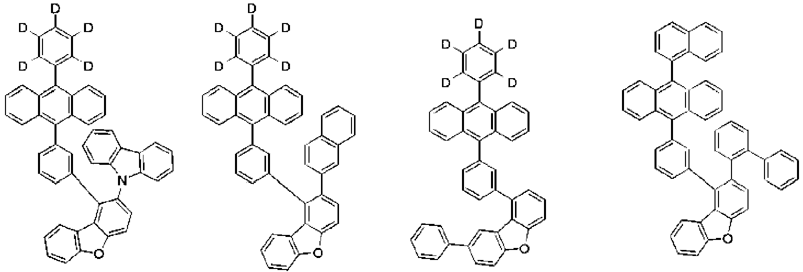

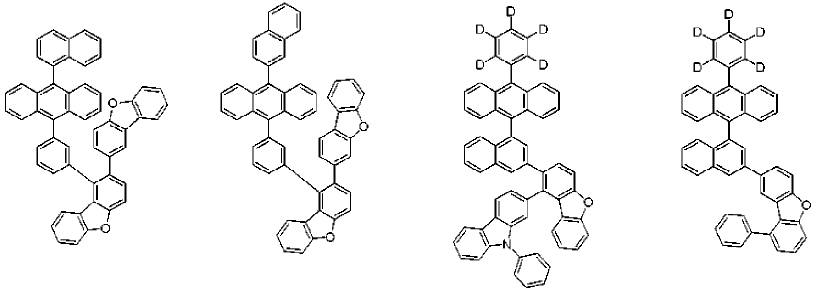

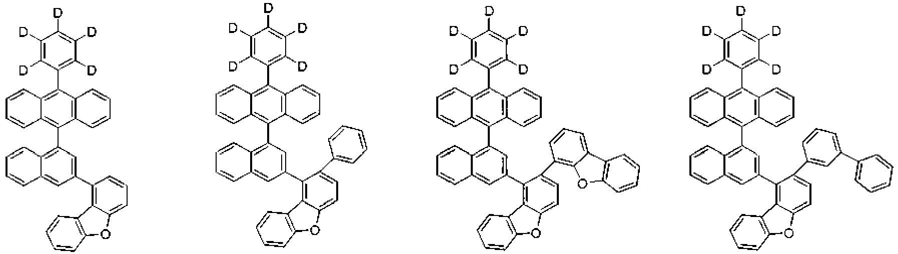

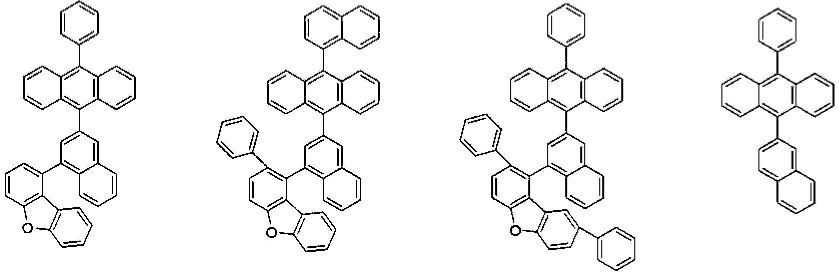

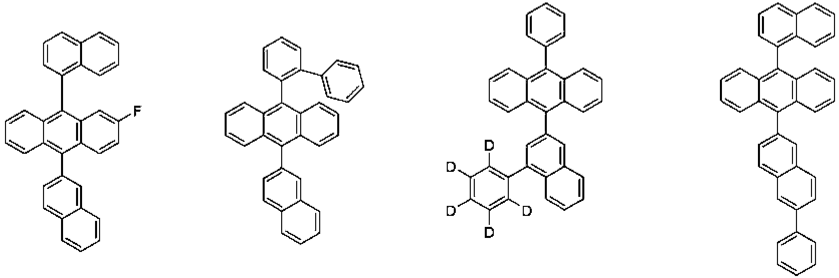

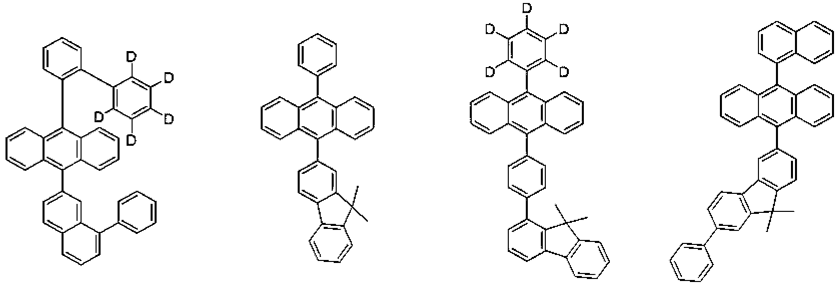

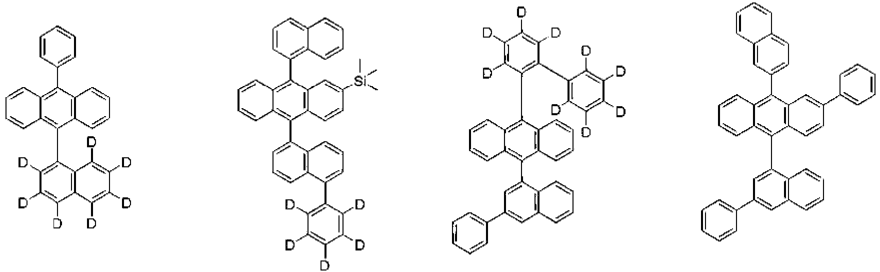

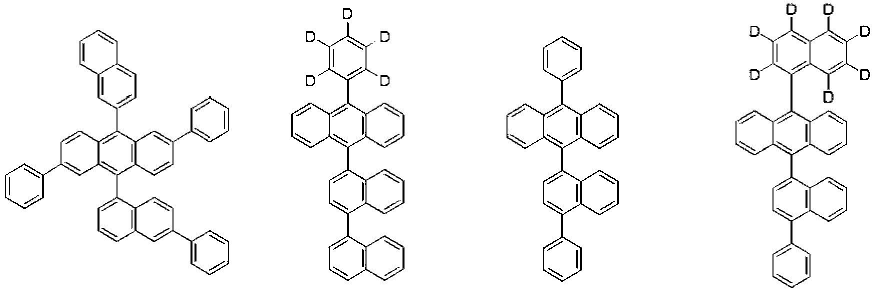

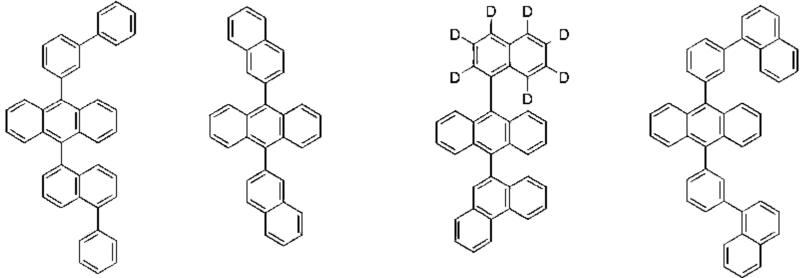

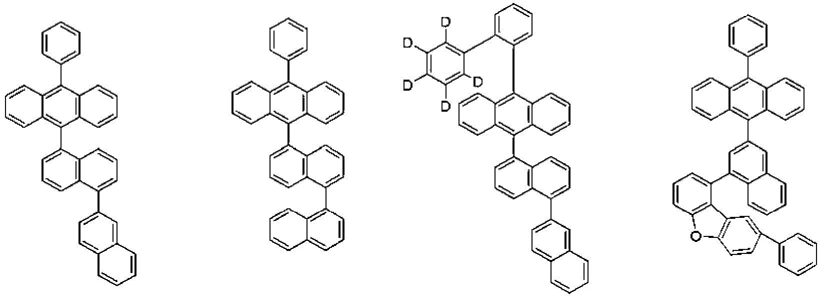

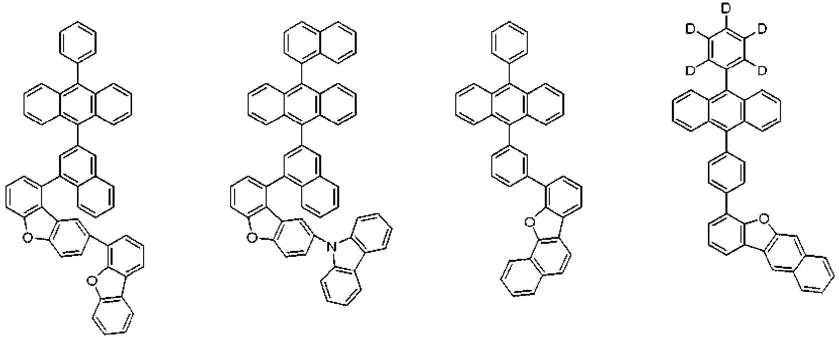

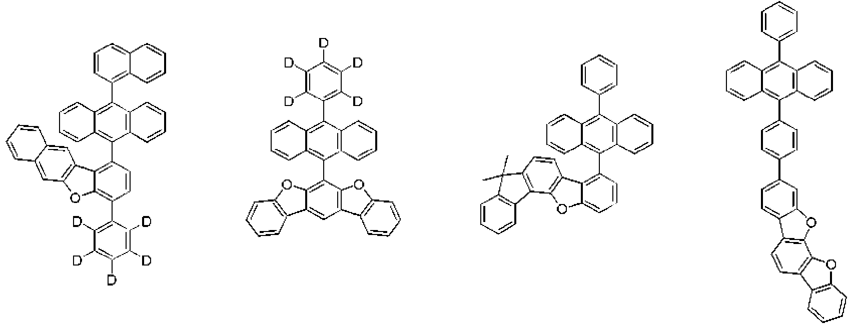

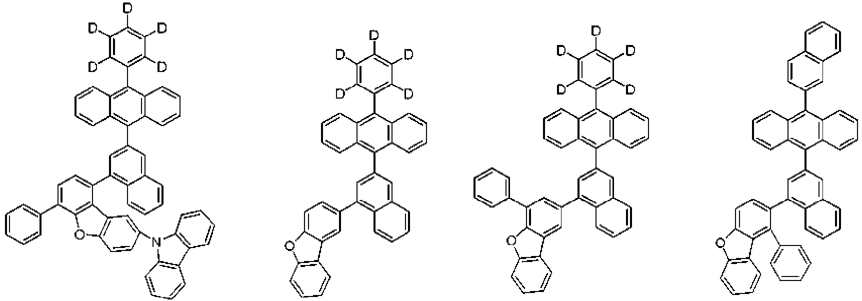

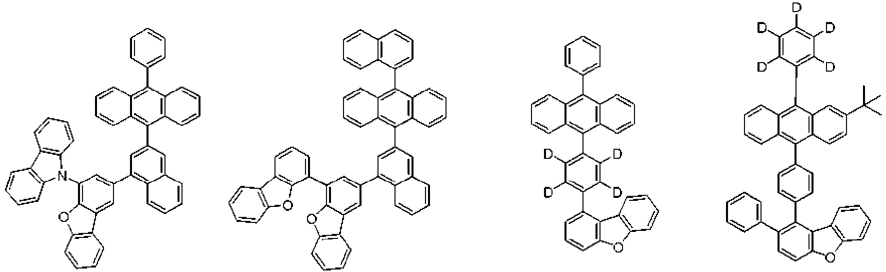

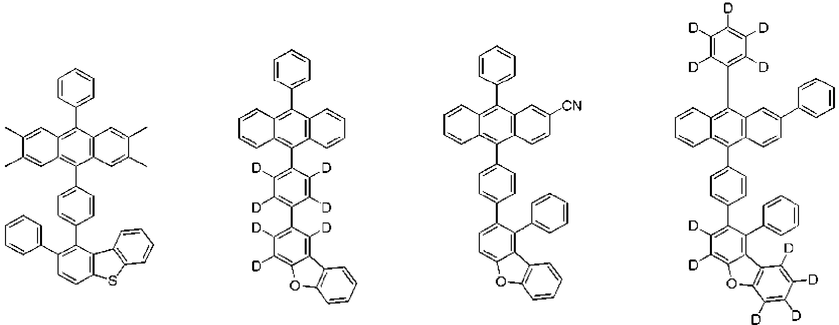

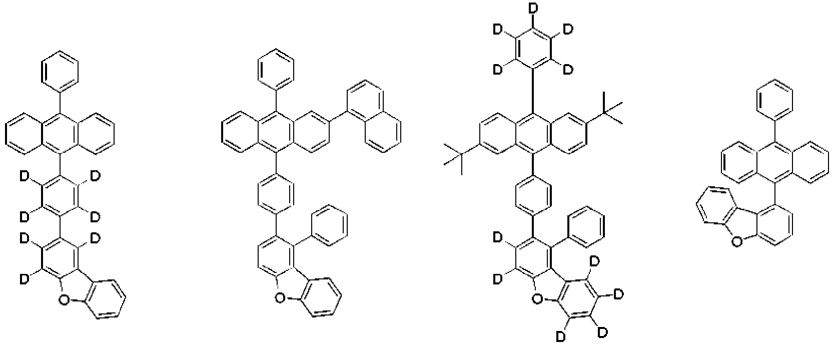

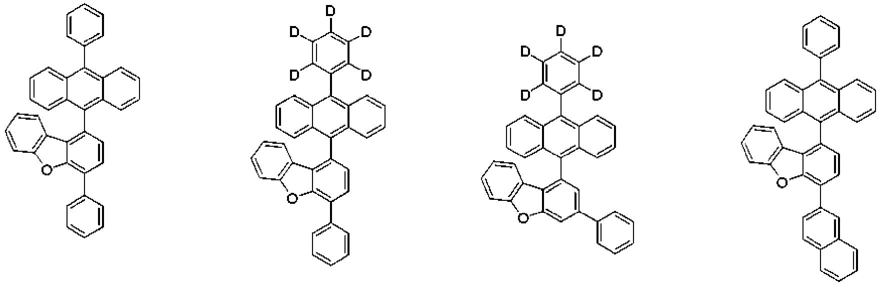

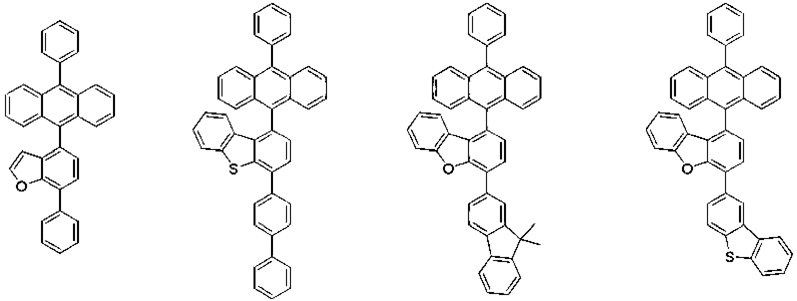

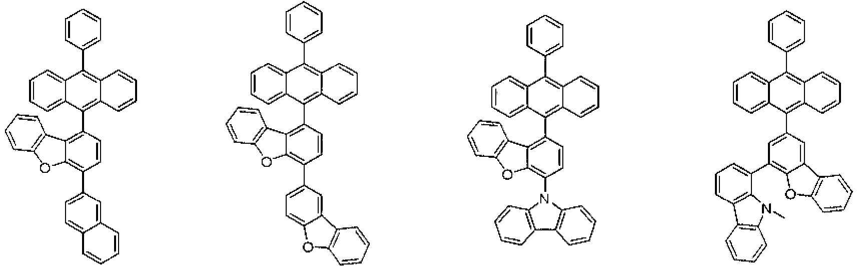

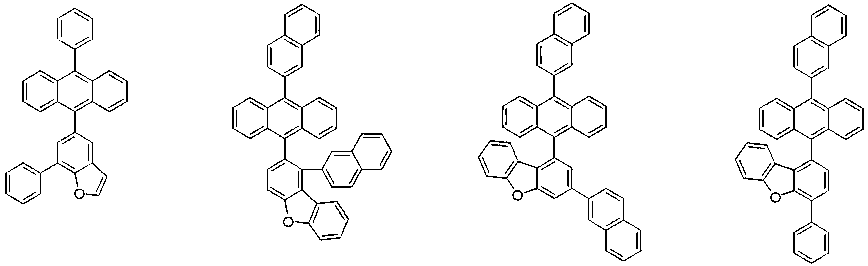

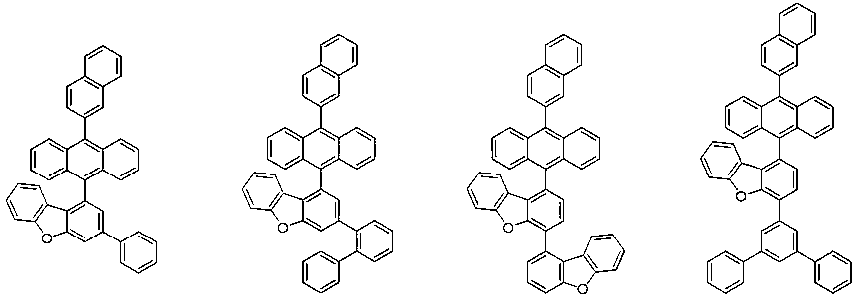

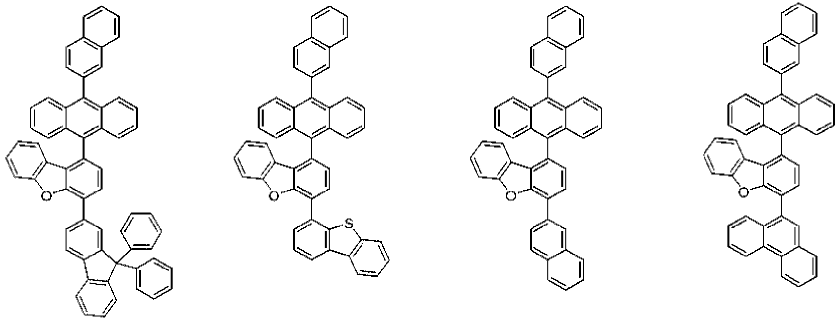

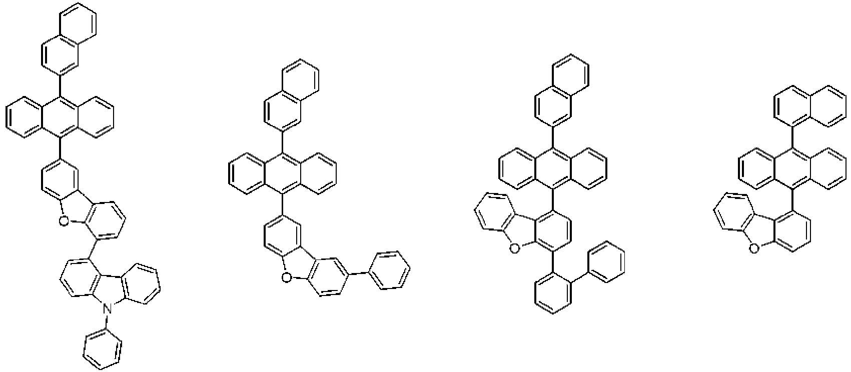

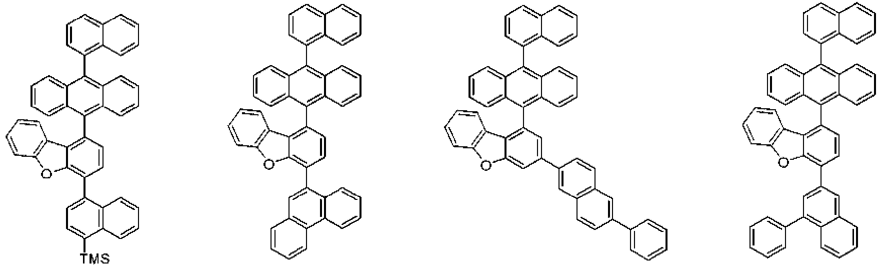

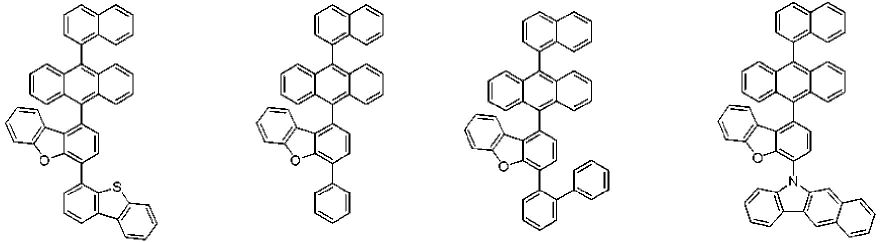

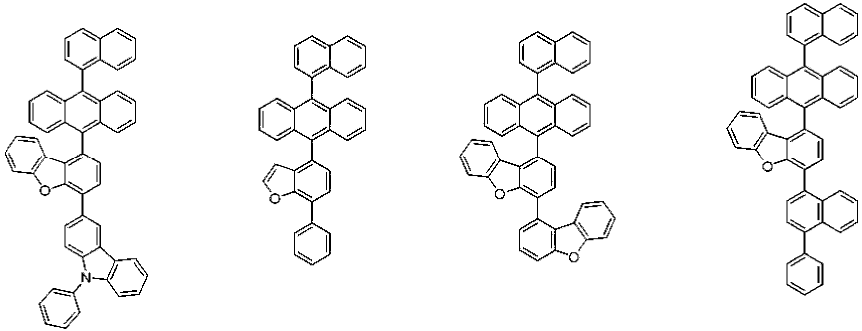

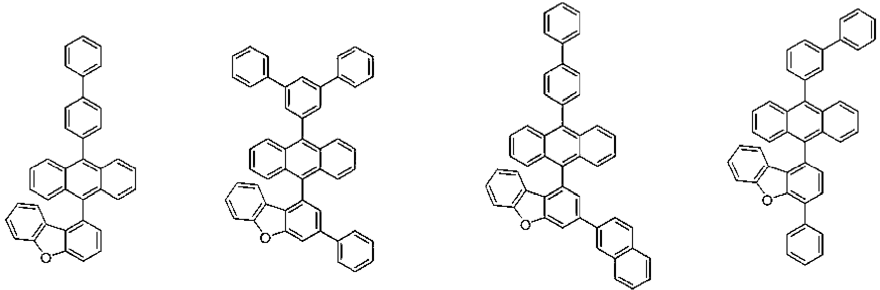

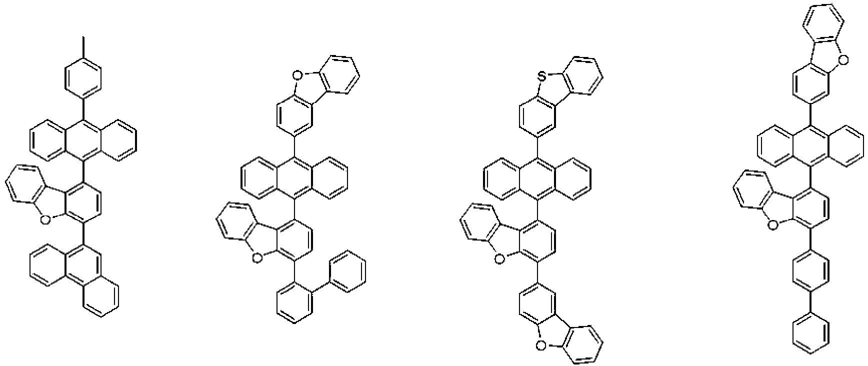

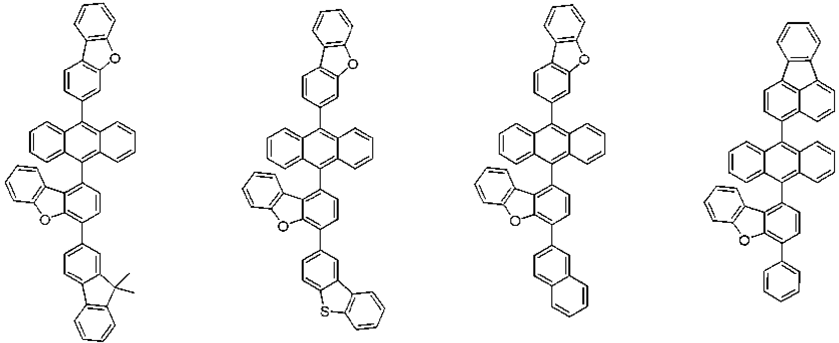

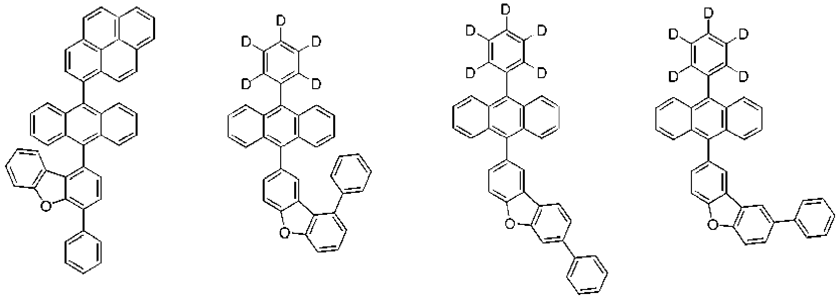

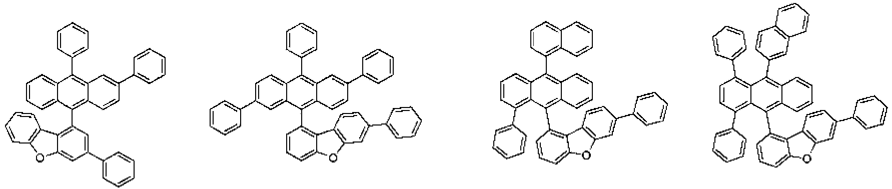

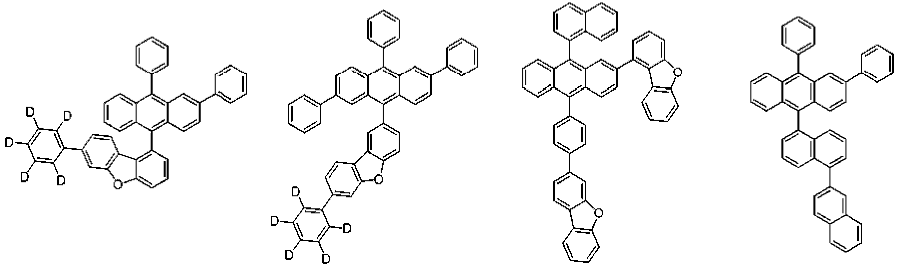

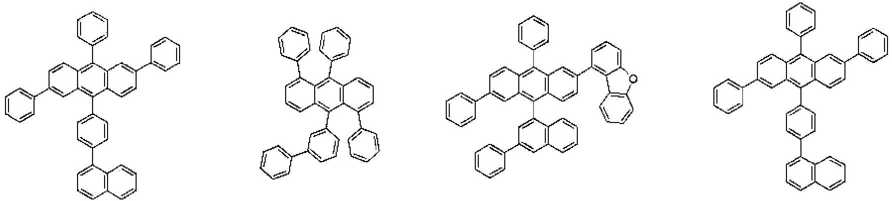

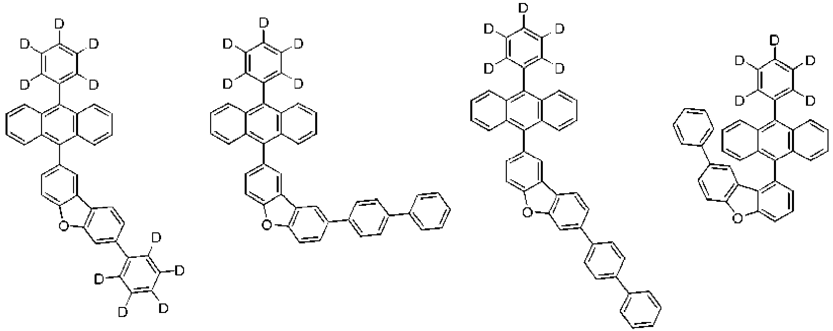

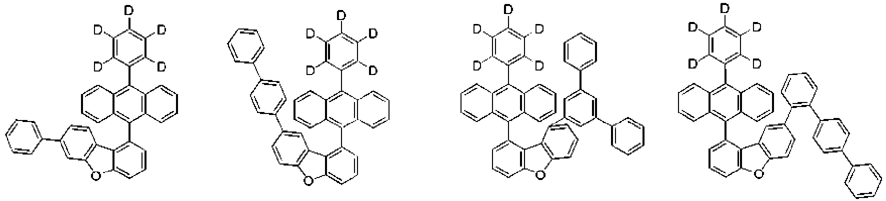

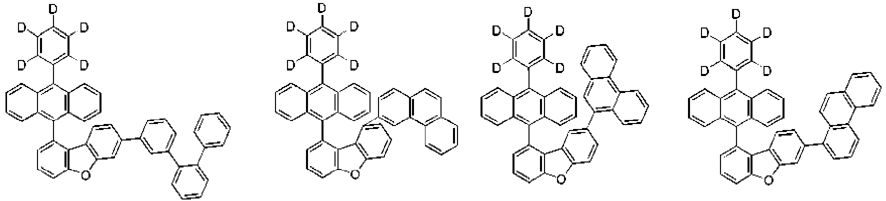

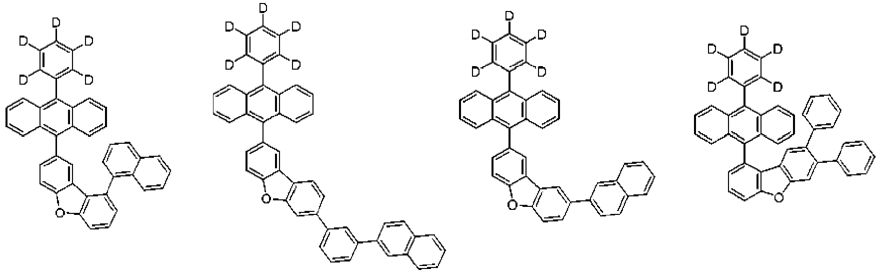

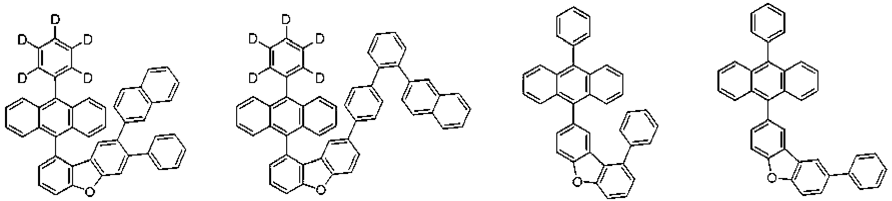

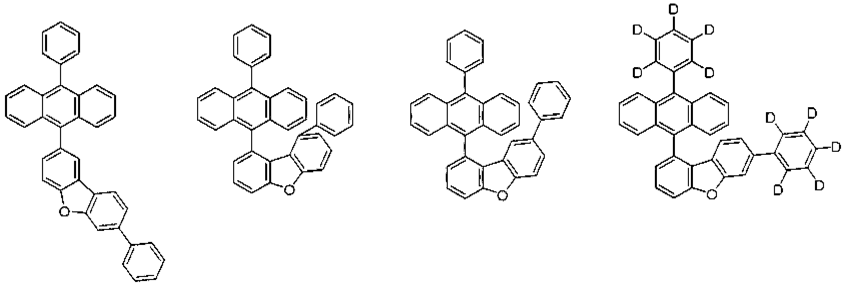

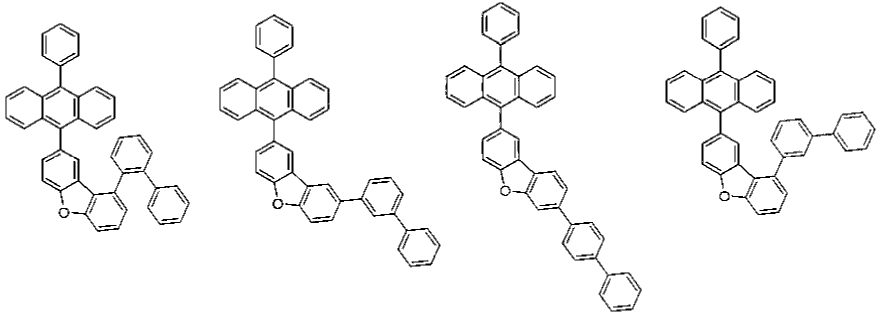

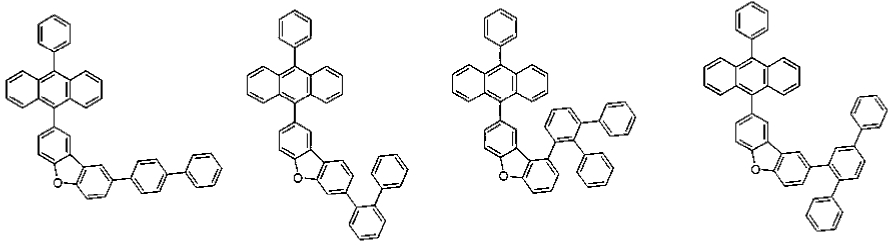

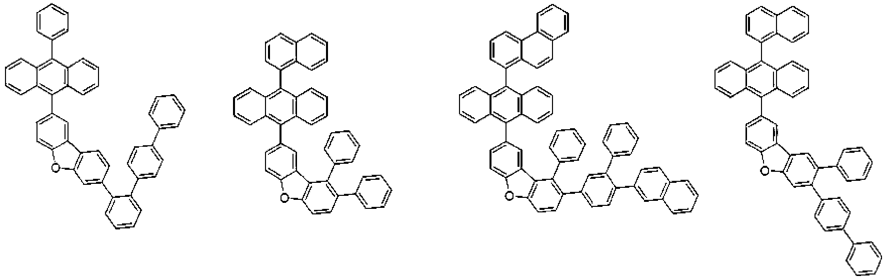

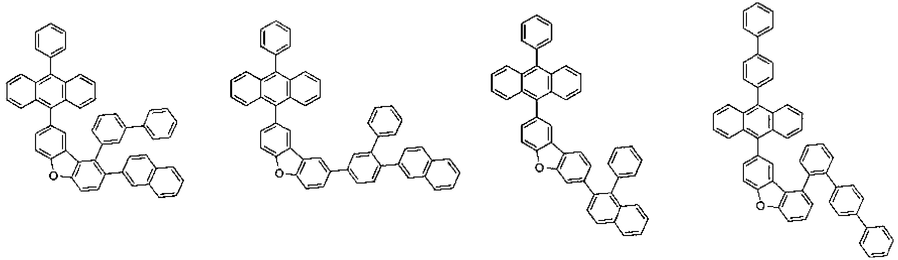

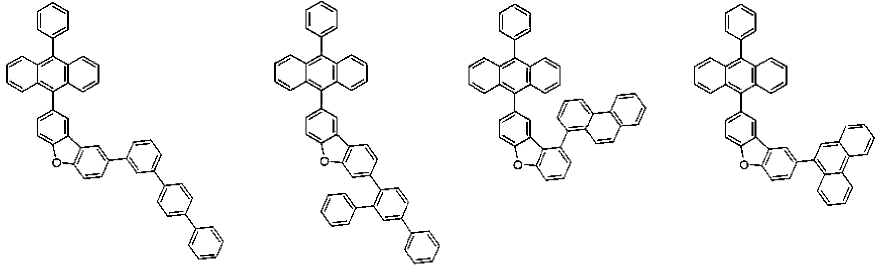

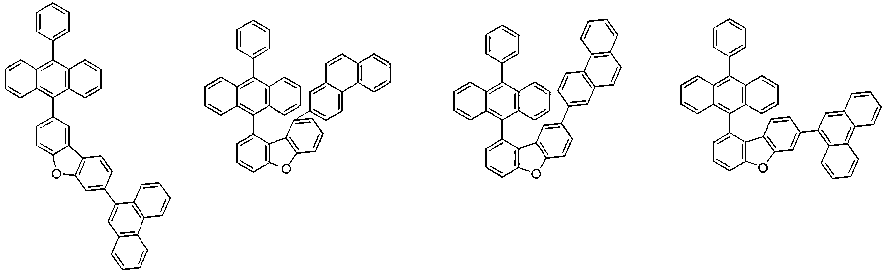

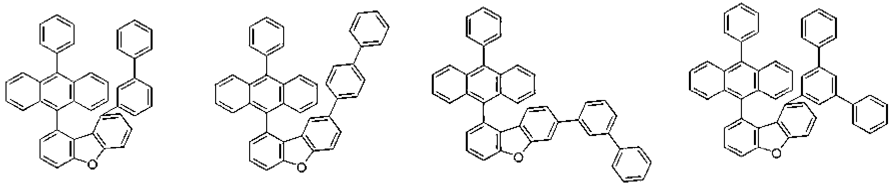

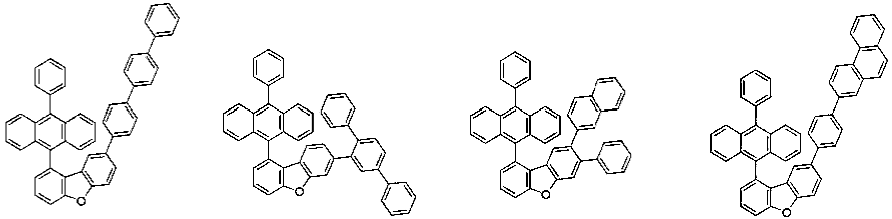

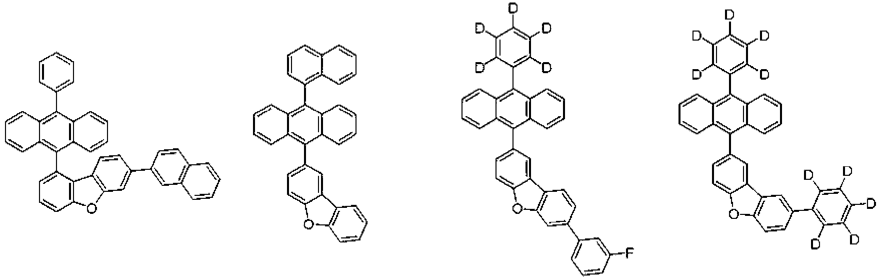

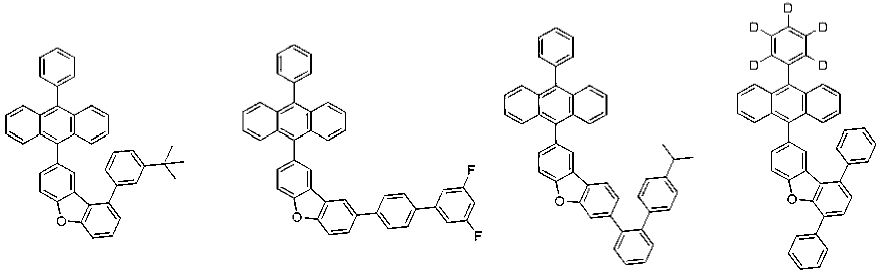

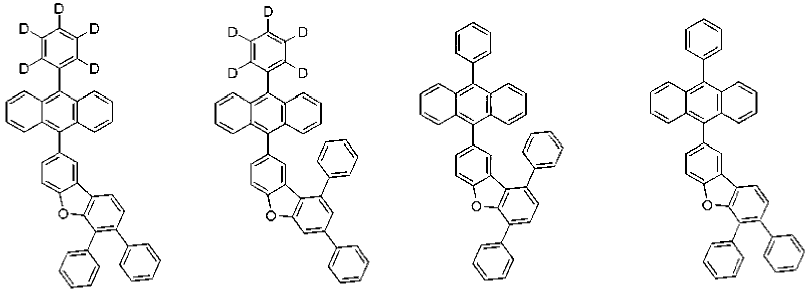

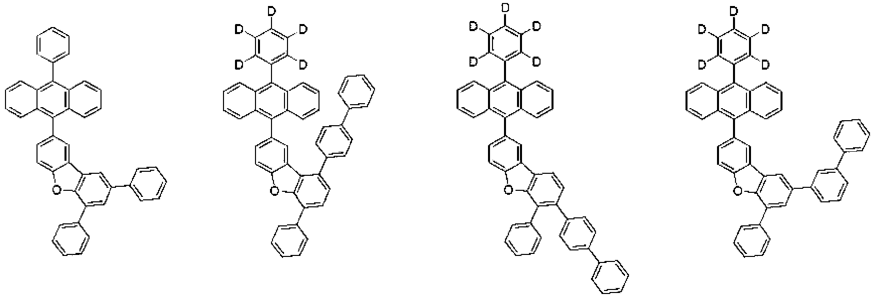

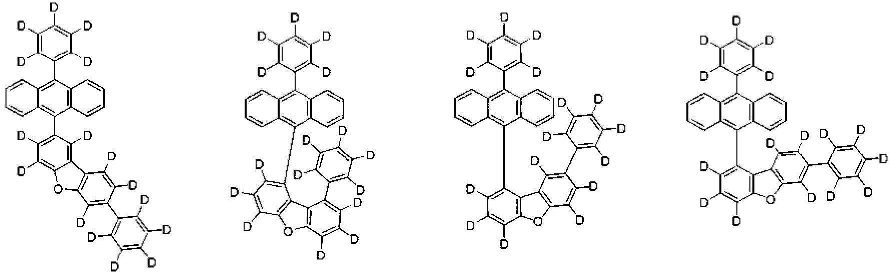

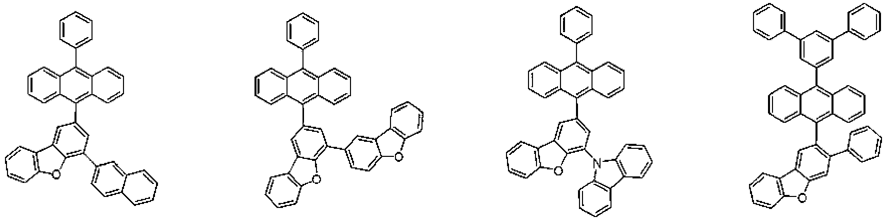

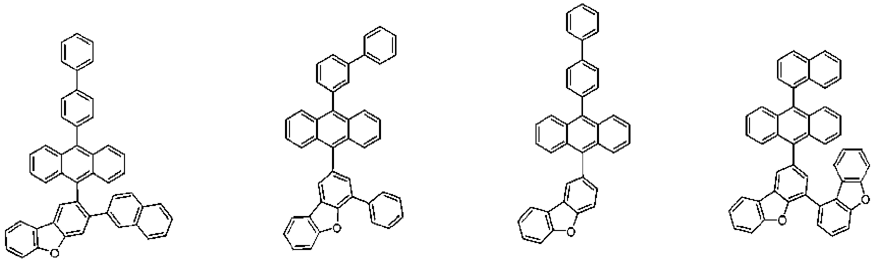

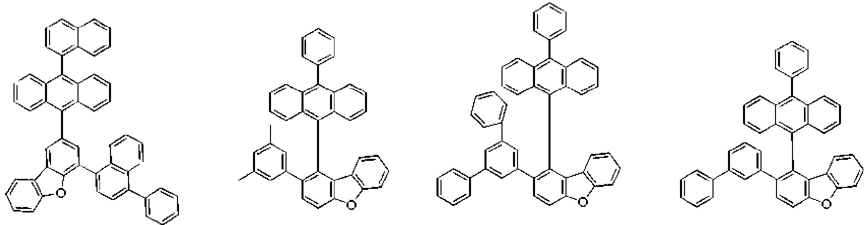

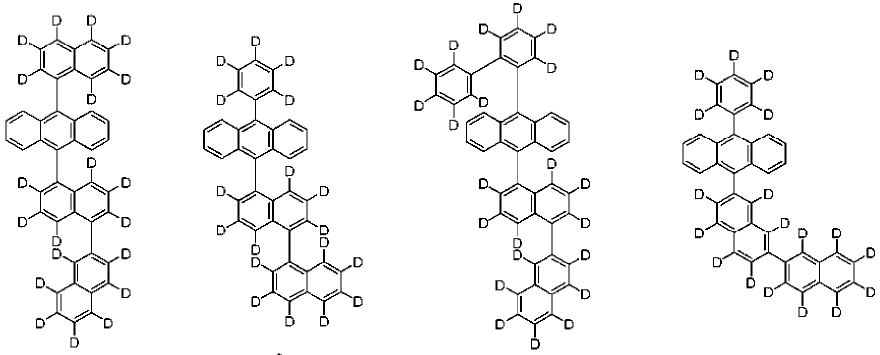

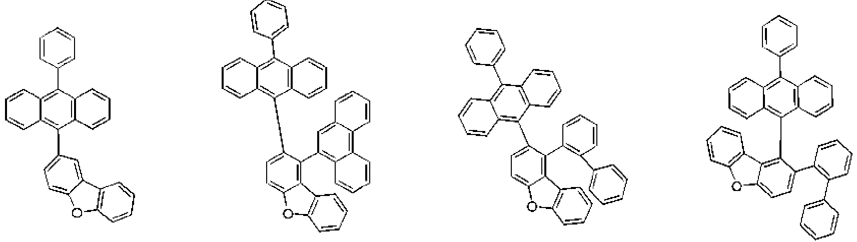

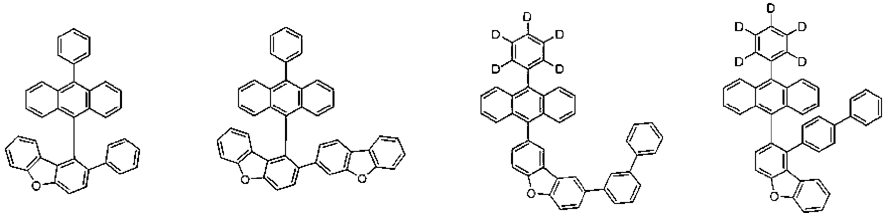

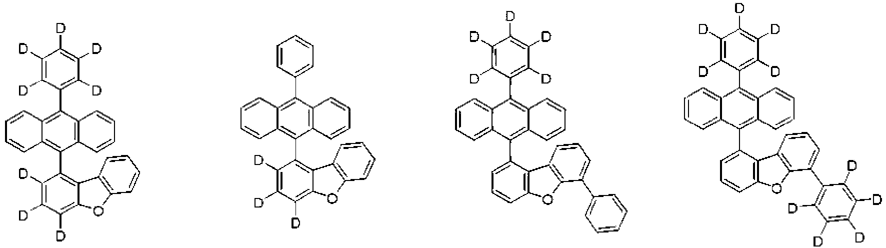

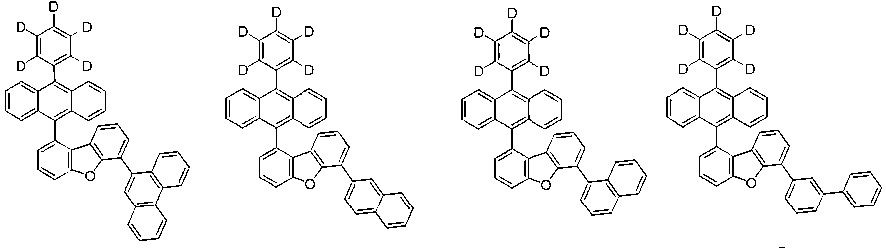

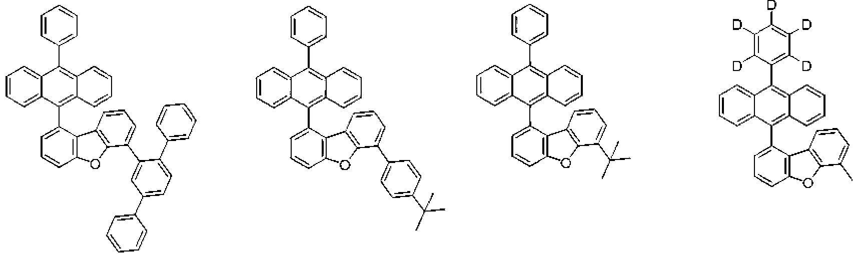

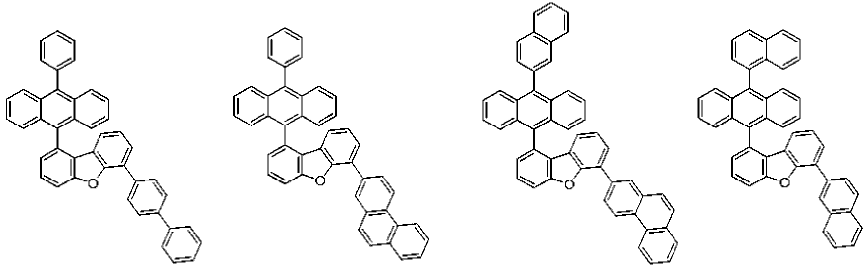

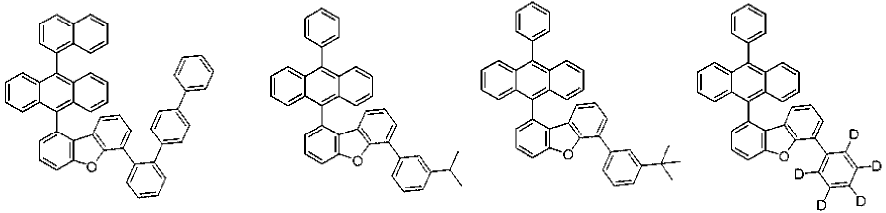

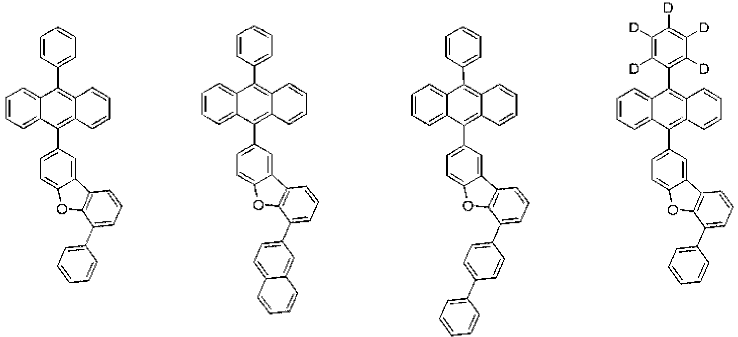

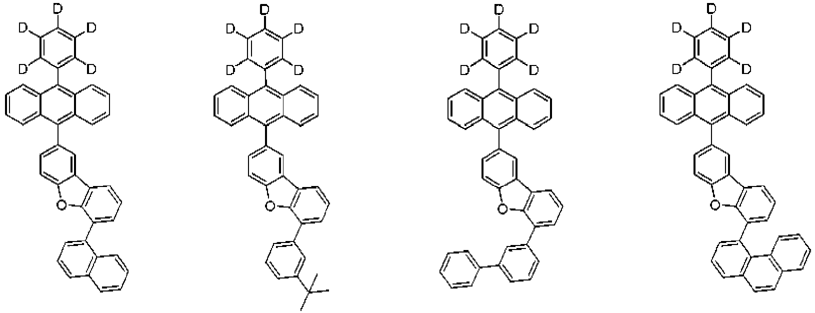

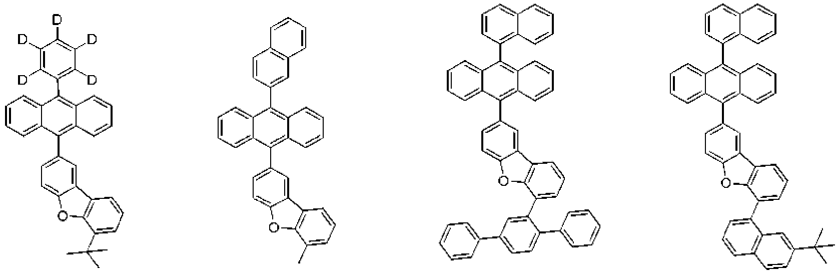

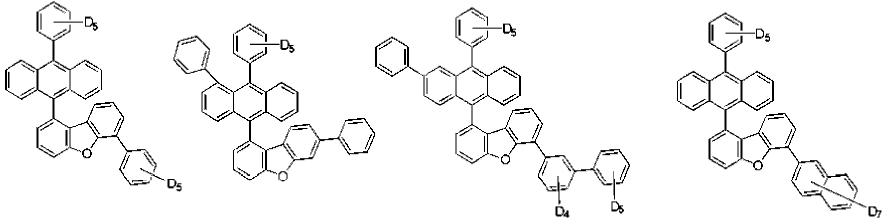

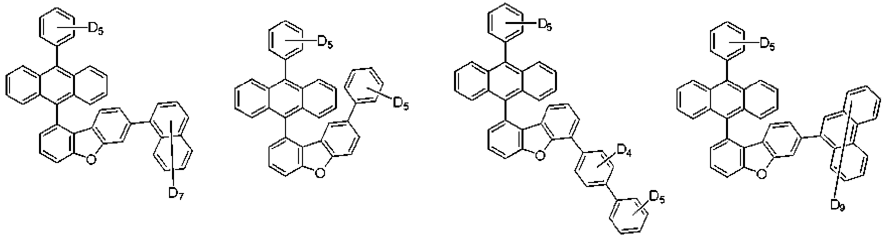

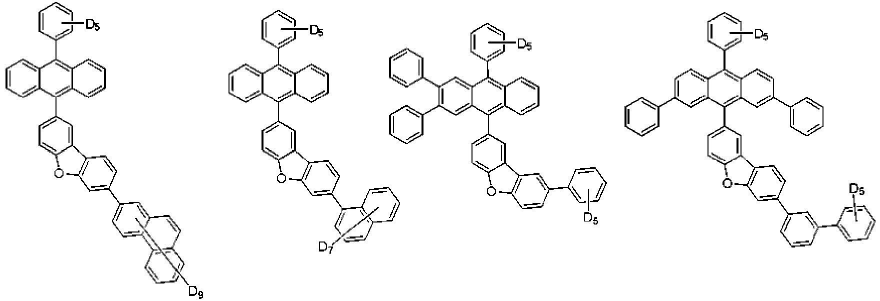

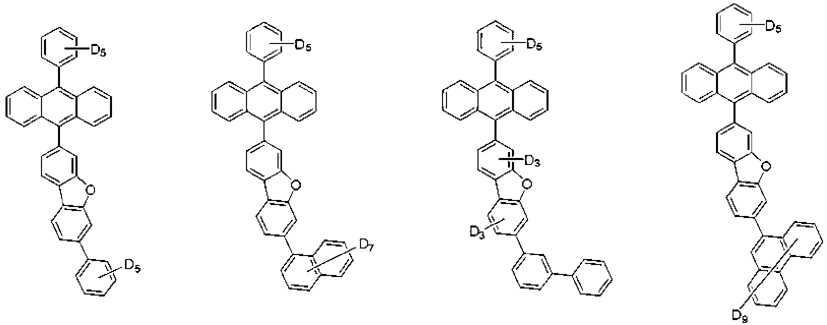

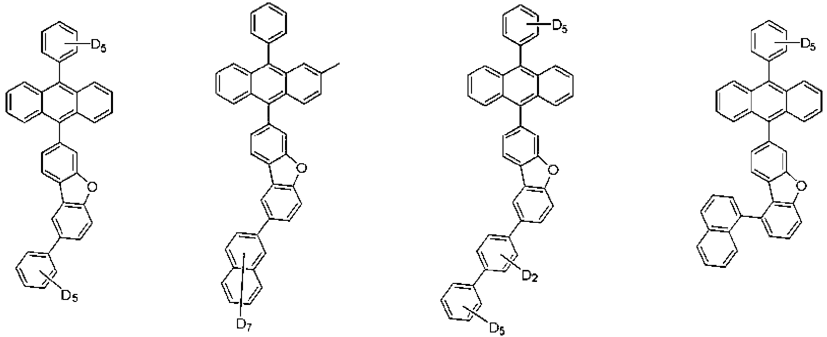

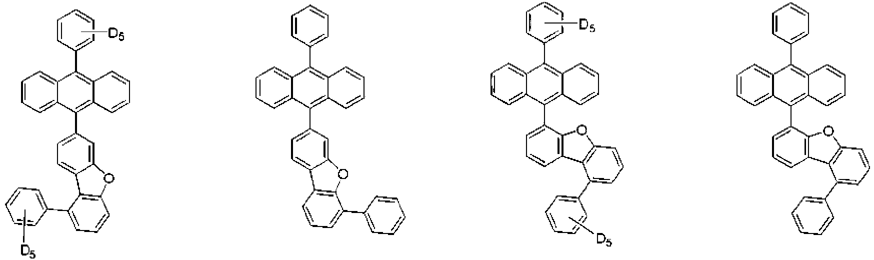

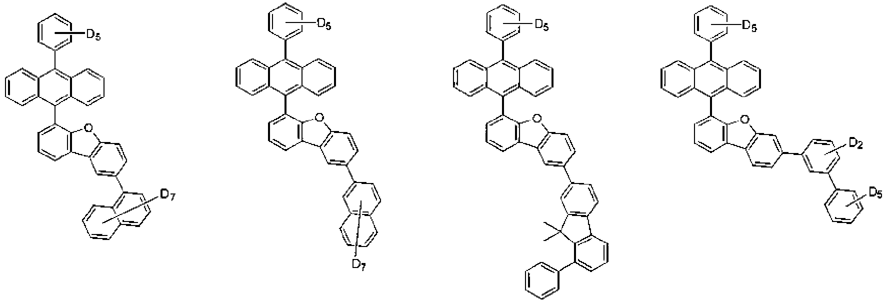

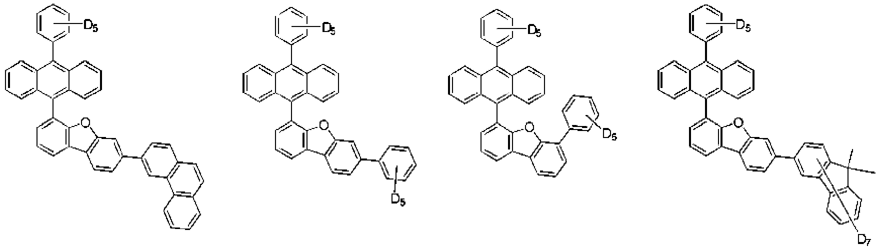

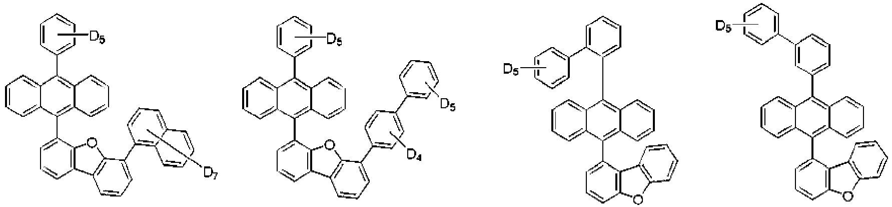

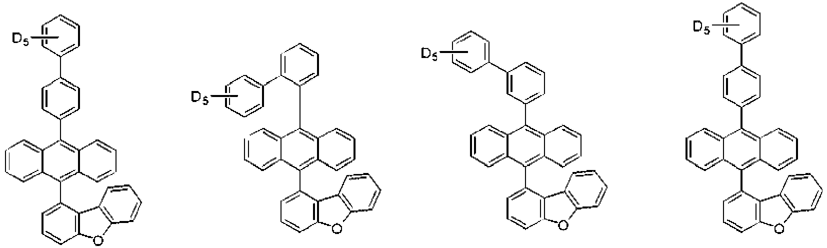

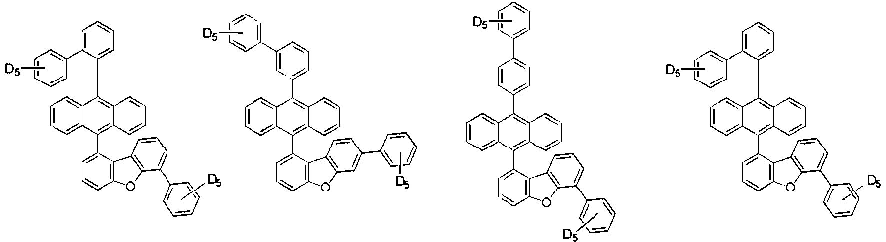

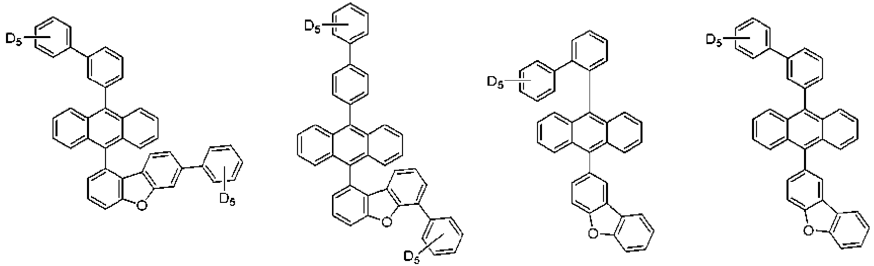

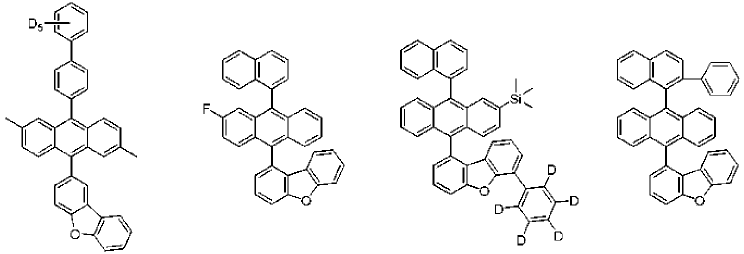

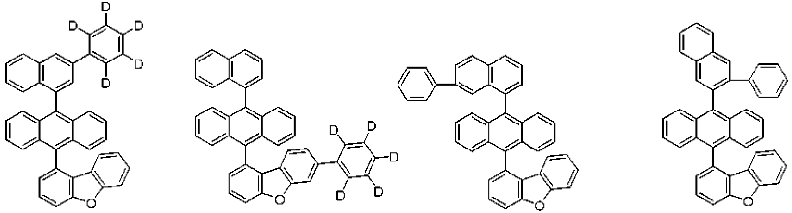

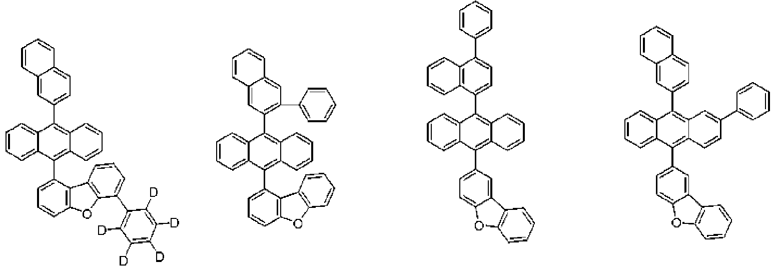

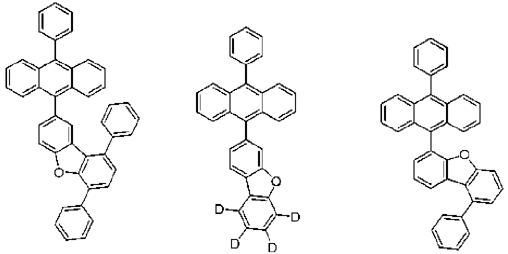

15. The organic light-emitting device of claim 10, which is used in any one device selected from flat-panel display devices; flexible display devices; monochromatic or white flat-panel lighting devices; monochromatic or white flexible lighting devices; display devices for vehicles; and display devices for virtual or augmented reality.
